# EUROPEAN PATENT APPLICATION

(11) **EP 4 525 415 A1**
(43) Date of publication of application: **19.03.2025**
(21) Application number: 23824045.1
(22) Date of filing: 16.03.2023
(51) Int. Cl.: H04M 1/02, F16C 11/04, G06F 1/16

(54) **FOLDABLE ELECTRONIC DEVICE**

(30) Priority: 14.06.2022 KR 20220071909; 30.06.2022 KR 20220080347
(71) Applicant: Samsung Electronics Co., Ltd., Suwon-si, Gyeonggi-do 16677 (KR)
(72) Inventor: KIM, Jongkeun, Suwon-si, Gyeonggi-do 16677 (KR); KIM, Jongyoon, Suwon-si, Gyeonggi-do 16677 (KR); KIM, Hyungsoo, Suwon-si, Gyeonggi-do 16677 (KR); PARK, Daehyeong, Suwon-si, Gyeonggi-do 16677 (KR)
(74) Representative: HGF
(86) International application number: PCT/KR2023/003511
(87) International publication number: WO 2023/243815

(57) **Abstract**

According to an example embodiment of the present disclosure, an electronic device comprises a first housing, a second housing, and a hinge module for connecting the first housing and the second housing, wherein: the hinge module comprises a first portion configured to be rotatable with respect to a first rotation shaft, a second portion configured to be rotatable with respect to a second rotation shaft that is parallel to the first rotation shaft and is separated from the first rotation shaft, and a first bracket that is connected to the first portion and the second portion and is fixed to the first housing; the first portion and the first bracket are connected to be slidable to each other in a first straight direction; the second portion and the first bracket are connected to be slidable to each other in a second straight direction different from the first straight direction; and when the angle between the first housing and the second housing is changed, the first portion and the first bracket may slide to each other, and the second portion and the first bracket may slide to each other.

## Description

### [Technical Field]

The disclosure relates to a foldable electronic device.

### [Background Art]

When a foldable electronic device is switched from an unfolded state to a folded state, an area of a flexible display module corresponding to the folding portion of the foldable electronic device may be transformed and disposed from an unfolded state to a bent state.

The above-described information may be provided as related art for the purpose of helping to understand the disclosure. No claim or determination is made as to whether any of the foregoing may be applied as prior art with respect to the disclosure.

### [Disclosure of Invention]

### [Technical Problem]

A foldable electronic device may require a structure that is capable of reducing bending stress in the area of a flexible display module corresponding to a folding portion of the foldable electronic device.

Embodiments of the disclosure may provide a foldable electronic device capable of reducing bending stress in an area of a flexible display module corresponding to a folding portion of the foldable electronic device.

The technical problems to be addressed by this disclosure are not limited to those described above, and other technical problems may be understood by a person ordinarily skilled in the related art to which the disclosure pertains.

### [Solution to Problem]

According to an exemplary embodiment of the disclosure, an electronic device may include a first housing, a second housing, and a hinge module connecting the first housing and the second housing. The hinge module may include a first unit, a second unit, and a first bracket. The first unit may be configured to be rotatable about a first rotation axis. The second unit may be configured to be rotatable about a second rotation axis that is parallel to the first rotation axis and spaced apart from the first rotation axis. The first bracket may be connected to the first unit and the second unit, and may be fixed to the first housing. The first unit and the first bracket may be connected to be slidable relative to each other in a first linear direction, and the second unit and the first bracket may be connected to be slidable relative to each other in a second linear direction different from the first linear direction. When the angle between the first housing and the second housing changes, the first unit and the first bracket may slide relative to each other, and the second unit and the first bracket may slide relative to each other.

According to an exemplary embodiment of the disclosure, an electronic device may include a first housing, a second housing, and a hinge module connecting the first housing and the second housing. The hinge module may include a first unit, a second unit, a first bracket, a third unit, a fourth unit, and a second bracket. The first unit may be configured to be rotatable about a first rotation axis. The second unit may be configured to be rotatable about a second rotation axis that is parallel to the first rotation axis and spaced apart from the first rotation axis. The first bracket may be connected to the first unit and the second unit, and may be fixed to the first housing. The third unit may be configured to be rotatable about a third rotation axis. The fourth unit may be configured to be rotatable about a fourth rotation axis. The second bracket may be connected to the third unit and the fourth unit, and may be fixed to the second housing. The third rotation axis may be positioned symmetrically to the first rotation axis with respect to the centerline of the electronic device. The third unit may be provided symmetrically to the first unit with respect to the centerline of the electronic device. The fourth rotation axis may be positioned symmetrically to the second rotation axis with respect to the centerline of the electronic device. The fourth unit may be provided symmetrically to the second unit with respect to the centerline of the electronic device. The first unit and the first bracket may be connected to be slidable relative to each other in a first linear direction. The second unit and the first bracket may be connected to be slidable relative to each other in a second linear direction different from the first linear direction. The third unit and the second bracket may be connected to be slidable relative to each other in a third linear direction symmetrical to the first linear direction with respect to the centerline of the electronic device. The fourth unit and the second bracket may be connected to be slidable relative to each other in a fourth linear direction symmetrical to the second linear direction with respect to the centerline of the electronic device. When the angle between the first housing and the second housing changes, the first unit and the second unit may slide relative to the first bracket, and the third unit and the fourth unit may slide relative to the second bracket.

### [Advantageous Effects of Invention]

A foldable electronic device according to various embodiments of the disclosure may reduce bending stress in an area corresponding to a hinge part of a flexible display module. When the foldable electronic device is switched from an unfolded state to a folded state, buckling in an area corresponding to the hinge part of the flexible display module may be reduced.

In addition, effects that may be obtained or predicted by various embodiments of the disclosure may be directly or implicitly disclosed in the detailed description of the embodiments of the disclosure.

### [Brief Description of Drawings]

The above and other aspects, features, and advantages of specific embodiments of the disclosure will become more apparent from the following detailed description taken in conjunction with the accompanying drawings.
FIG. 1 shows a block diagram of an electronic device according to an embodiment of the disclosure in a network environment.
FIG. 2 shows views illustrating an electronic device according to an embodiment of the disclosure in an unfolded state.
FIG. 3 shows views illustrating the electronic device according to an embodiment of the disclosure in a folded state.
FIG. 4 shows an exploded perspective view illustrating a portion of the electronic device according to an embodiment of the disclosure in the unfolded state.
FIG. 5 shows a view illustrating a foldable housing in the electronic device according to an embodiment of the disclosure in the unfolded state.
FIG. 6 shows cross-sectional views respectively illustrating the unfolded state and the folded state of the electronic device according to an embodiment of the disclosure.
FIG. 7 shows cross-sectional views illustrating a foldable housing when the electronic device according to various embodiments of the disclosure is unfolded.
FIG. 8 shows an exploded perspective view of a first hinge module according to an embodiment of the disclosure.
FIG. 9 shows a perspective view of the first hinge module according to an embodiment of the disclosure.
FIG. 10 shows views illustrating a first unit of the first hinge module according to an embodiment of the disclosure.
FIG. 11 shows views illustrating a third unit of the first hinge module according to an embodiment of the disclosure.
FIG. 12 shows views illustrating a second unit of the first hinge module according to an embodiment of the disclosure.
FIG. 13 shows views illustrating a fourth unit of the first hinge module according to an embodiment of the disclosure.
FIG. 14 shows views illustrating a fifth unit of a first bracket according to an embodiment of the disclosure.
FIG. 15 shows views illustrating a seventh unit of a second bracket according to an embodiment of the disclosure.
FIG. 16 shows a cross-sectional view illustrating a first circular gear, a second circular gear, a third circular gear, and a fourth circular gear according to an embodiment of the disclosure.
FIG. 17 shows a perspective view of a hinge part and a view illustrating the hinge part when the electronic device according to an embodiment of the disclosure is in the unfolded state.
FIG. 18 shows a view illustrating a first hinge module, a cross-sectional view of the first hinge module taken along line D-D', and a cross-sectional view of the first hinge module taken along line E-E' when the electronic device according to an embodiment of the disclosure is in the unfolded state.
FIG. 19 shows a perspective view of the hinge part and a view illustrating the hinge part when the electronic device according to an embodiment of the disclosure is in the closed state.
FIG. 20 shows a view illustrating the first hinge module, a cross-sectional view of the first hinge module taken along line F-F', and a cross-sectional view of the first hinge module taken along line E-E' when the electronic device according to an embodiment of the disclosure is in the closed state.
FIG. 21 shows a view illustrating the first hinge module, a cross-sectional view of the first hinge taken along line H-H', and a cross-sectional view of the first hinge module taken along line I-I' when the electronic device according to an embodiment of the disclosure is in the intermediate state.
FIG. 22 shows a view illustrating the electronic device in the unfolded state, a view illustrating the electronic device in the intermediate state, and a view illustrating the electronic device in the folded state, according to an embodiment of the disclosure.
FIG. 23 shows a view illustrating a first hinge module and a cross-sectional view of the first hinge module taken along line J-J' when the electronic device according to various embodiments of the disclosure is in the unfolded state.
FIG. 24 illustrates a view illustrating a hinge part and a cross-sectional view of the hinge part taken along line K-K' when the electronic device according to various embodiments of the disclosure is in the unfolded state.
FIG. 25 illustrates a view illustrating the first hinge module and a cross-sectional view of the first hinge module taken along line L-L' when the electronic device according to various embodiments of the disclosure is in the folded state.
FIG. 26 illustrates a view illustrating the unfolded state of the electronic device and a view illustrating the folded state of the electronic device according to various embodiments of the disclosure.

### [Mode for the Invention]

Hereinafter, various example embodiments of the disclosure disclosed herein will be described in greater detail with reference to the accompanying drawings.

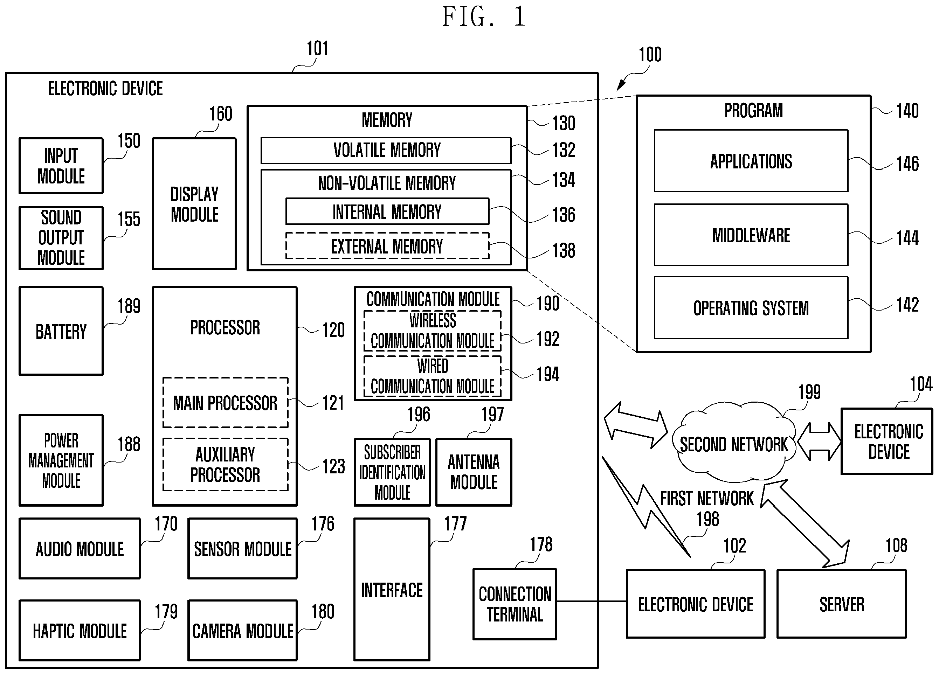

FIG. 1 is a block diagram of an electronic device 101 in a network environment 100 according to an embodiment of the disclosure.

Referring to FIG. 1, the electronic device 101 in the network environment 100 may communicate with an external electronic device 102 via a first network 198 (e.g., a short-range wireless communication network), or at least one of an external electronic device 104 or a server 108 via a second network 199 (e.g., a long-range wireless communication network). The electronic device 101 may communicate with the external electronic device 104 via the server 108. The electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, and/or an antenna module 197. In some embodiments of the disclosure, at least one (e.g., the connection terminal 178) of the components may be omitted from the electronic device 101, or one or more other components may be added in the electronic device 101. In some embodiments of the disclosure, some of the components may be implemented as single integrated circuitry. For example, the sensor module 176, the camera module 180, or the antenna module 197 may be implemented as embedded in single component (e.g., the display module 160).

The processor 120 may execute, for example, software (e.g., a program 140) to control at least one other component (e.g., a hardware or software component) of the electronic device 101 coupled with the processor 120, and may perform various data processing or computation. As at least part of the data processing or computation, the processor 120 may load a command or data received from another component (e.g., the sensor module 176 or the communication module 190) in a volatile memory 132, process the command or the data stored in the volatile memory 132, and store resulting data in a non-volatile memory 134. The processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. Additionally or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display module 160, the sensor module 176, or the communication module 190) among the components of the electronic device 101, instead of the main processor 121 while the main processor 121 is in an inactive (e.g., a sleep) state, or together with the main processor 121 while the main processor 121 is in an active state (e.g., executing an application). The auxiliary processor 123 (e.g., an ISP or a CP) may be implemented as part of another component (e.g., the camera module 180 or the communication module 190) functionally related to the auxiliary processor 123. According to an embodiment of the disclosure, the auxiliary processor 123 (e.g., a neural network processing device) may include a hardware structure specified for processing an artificial intelligence model. The artificial intelligence model may be created through machine learning. Such learning may be performed, for example, in the electronic device 101 itself on which the artificial intelligence model is performed, or may be performed through a separate server (e.g., the server 108). The learning algorithms may include, for example, supervised learning, unsupervised learning, semi-supervised learning, or reinforcement learning, but is not limited thereto. The artificial intelligence model may include a plurality of artificial neural network layers. The artificial neural network may be any of a deep neural network (DNN), a convolutional neural network (CNN), a recurrent neural network (RNN), a restricted Boltzmann machine (RBM), a deep belief network (DBN), a bidirectional recurrent DNN (BRDNN), a deep Q-network, or a combination of two or more of the above-mentioned networks, but is not limited the above-mentioned examples. In addition to the hardware structure, the artificial intelligence model may additionally or alternatively include a software structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 and/or the non-volatile memory 134.

The program 140 may be stored in the memory 130 as software, and may include, for example, an operating system (OS) 142, middleware 144, and/or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record, and the receiver may be used for incoming calls. The receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. The display module 160 may include touch circuitry (e.g., a touch sensor) adapted to detect a touch, or sensor circuitry (e.g., a pressure sensor) adapted to measure the intensity of force incurred by the touch.

The audio module 170 may convert a sound into an electrical signal and vice versa. The audio module 170 may obtain the sound via the input module 150, or output the sound via the sound output module 155 or a headphone of an external electronic device (e.g., the external electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. The sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the external electronic device 102) directly (e.g., wiredly) or wirelessly. The interface 177 may include, for example, a high-definition multimedia interface (HDMI), a universal serial bus (USB) interface, a secure digital (SD) card interface, and/or an audio interface.

The connecting terminal 178 may include a connector via which the electronic device 101 may be physically connected with the external electronic device (e.g., the external electronic device 102). The connecting terminal 178 may include, for example, an HDMI connector, a USB connector, an SD card connector, and/or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. The haptic module 179 may include, for example, a motor, a piezoelectric element, or an electric stimulator.

The camera module 180 may capture a still image or moving images. The camera module 180 may include one or more lenses, image sensors, ISPs, or flashes.

The power management module 188 may manage power supplied to or consumed by the electronic device 101. The power management module 188 may be implemented as at least part of, for example, a power management integrated circuit (PMIC).

The battery 189 may supply power to at least one component of the electronic device 101. The battery 189 may include, for example, a primary cell which is not rechargeable, a secondary cell which is rechargeable, and/or a fuel cell.

The communication module 190 may support establishing a direct (e.g., wired) communication channel or a wireless communication channel between the electronic device 101 and the external electronic device (e.g., the external electronic device 102, the external electronic device 104, or the server 108) and performing communication via the established communication channel. The communication module 190 may include one or more CPs that are operable independently from the processor 120 (e.g., the AP) and supports a direct (e.g., wired) communication or a wireless communication. The communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BLUETOOTH, wireless-fidelity (Wi-Fi) direct, or IR data association (IrDA)) or the second network 199 (e.g., a long-range communication network, such as a legacy cellular network, a 5^{th} generation (5G) network, a next generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network, after a 4^{th} generation (4G) network, and next-generation communication technology, e.g., new radio (NR) access technology. The NR access technology may support highspeed transmission of high-capacity data (i.e., enhanced mobile broadband (eMBB)), minimization of terminal power and connection of multiple terminals (massive machine type communications (mMTC)), or high reliability and low latency (ultra-reliable and low-latency communications (URLLC)). The wireless communication module 192 may support a high-frequency band (e.g., a mmWave band) to achieve, for example, a high data transmission rate. The wireless communication module 192 may support various technologies for securing performance in a high-frequency band, such as beamforming, massive multiple-input and multiple-output (MIMO), full-dimensional MIMO (FD-MIMO), array antenna, analog beam-forming, or large-scale antenna. The wireless communication module 192 may support various requirements specified in the electronic device 101, an external electronic device (e.g., external the electronic device 104), or a network system (e.g., the second network 199). According to an embodiment of the disclosure, the wireless communication module 192 may support a peak data rate for implementing eMBB (e.g., 20Gbps or more), loss coverage for implementing mMTC (e.g., 164dB or less), or U-plane latency for realizing URLLC (e.g., 0.5ms or less for each of downlink (DL) and uplink (UL) or 1ms or less for round trip).

The antenna module 197 may transmit or receive a signal or power to or from the outside (e.g., the external electronic device) of the electronic device 101. The antenna module 197 may include an antenna including a radiating element including a conductive material or a conductive pattern formed in or on a substrate (e.g., a printed circuit board (PCB)). The antenna module 197 may include a plurality of antennas (e.g., an antenna array). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. Another component (e.g., a radio frequency integrated circuit (RFIC)) other than the radiating element may be additionally formed as part of the antenna module 197.

According to various embodiments of the disclosure, the antenna module 197 may form a mmWave antenna module. According to an embodiment of the disclosure, the mmWave antenna module may include a PCB, an RFIC that is disposed on or adjacent to a first surface (e.g., the bottom surface) of the PCB and is capable of supporting a predetermined high-frequency band (e.g., a mmWave band), and a plurality of antennas (e.g., array antennas) that is disposed on or adjacent to a second surface (e.g., the top surface or the side surface) of the PCB and is capable of transmitting or receiving a signal of the predetermined high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

Commands or data may be transmitted or received between the electronic device 101 and the external electronic device 104 via the server 108 coupled with the second network 199. Each of the external electronic devices 102 or 104 may be a device of a same type as, or a different type, from the electronic device 101. All or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide an ultra-low delay service using, for example, distributed computing or MEC. In another embodiment of the disclosure, the external electronic device 104 may include an internet of things (IoT) device. The server 108 may be an intelligent server using machine learning and/or neural networks. According to an embodiment of the disclosure, the external electronic device 104 or the server 108 may be included in the second network 199. The electronic device 101 may be applied to an intelligent service (e.g., smart home, smart city, smart car, or healthcare) based on 5G communication technology or IoT-related technology.

An electronic device according to an embodiment of the disclosure may be one of various types of electronic devices. The electronic devices may include a portable communication device (e.g., a smartphone), a computer device, a portable multimedia device, a portable medical device, a camera, a wearable device, or a home appliance. However, the electronic device is not limited to any of those described above.

Various embodiments of the disclosure and the terms used herein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). If an element (e.g., a first element) is referred to, with or without the term "operatively" or "communicatively," as "coupled with," "coupled to," "connected with," or "connected to" another element (e.g., a second element), the element may be coupled with the other element directly (e.g., wiredly), wirelessly, or via a third element.

The term "module" may include a unit implemented in hardware, software, or firmware, or any combination thereof, and may interchangeably be used with other terms, for example, "logic," "logic block," "part," or "circuitry". A module may be a single integral component, or a minimum unit or part thereof, adapted to perform one or more functions. For example, according to an embodiment of the disclosure, the module may be implemented in a form of an application-specific integrated circuit (ASIC).

Various embodiments as set forth herein may be implemented as software (e.g., the program 140) including one or more instructions that are stored in a storage medium (e.g., an internal memory 136 or an external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

A method according to an embodiment of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PLAYSTORE^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

Each component (e.g., a module or a program) of the above-described components may include a single entity or multiple entities. One or more of the above-described components may be omitted, or one or more other components may be added. Alternatively or additionally, a plurality of components (e.g., modules or programs) may be integrated into a single component. In such a case, the integrated component may perform one or more functions of each of the plurality of components in the same or similar manner as they are performed by a corresponding one of the plurality of components before the integration. Operations performed by the module, the program, or another component may be carried out sequentially, in parallel, repeatedly, or heuristically, or one or more of the operations may be executed in a different order or omitted, or one or more other operations may be added.

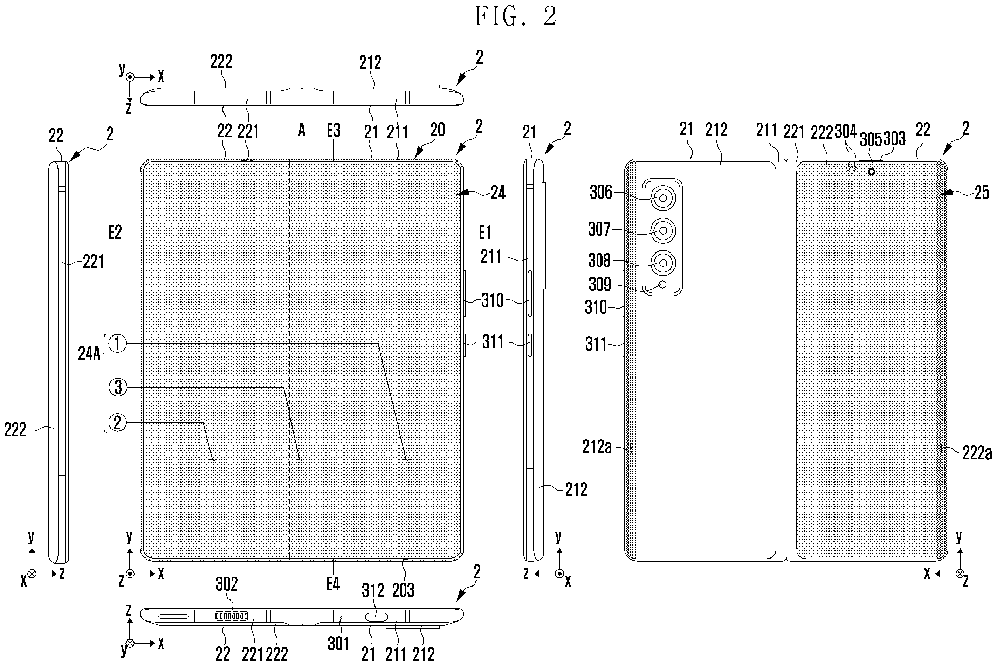

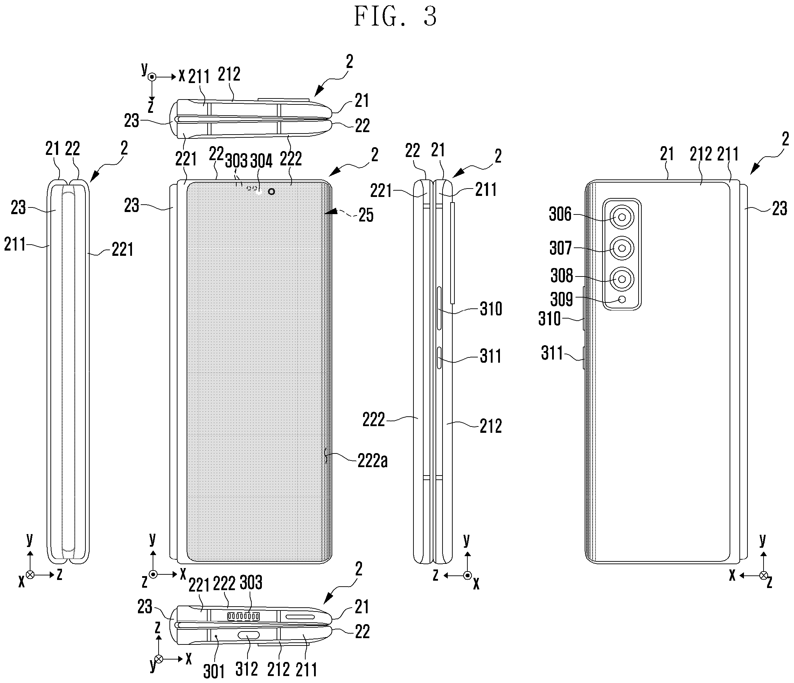

FIG. 2 shows views illustrating an electronic device 2 in a flat or unfolded state (or an unfolding state), according to an embodiment of the disclosure. FIG. 3 shows views illustrating an electronic device 2 in a folded state (or a folding state), according to an embodiment of the disclosure.

Referring to FIGS. 2 and 3, the electronic device 2 may include a foldable housing 20, and a flexible display module 24 disposed on the foldable housing 20.

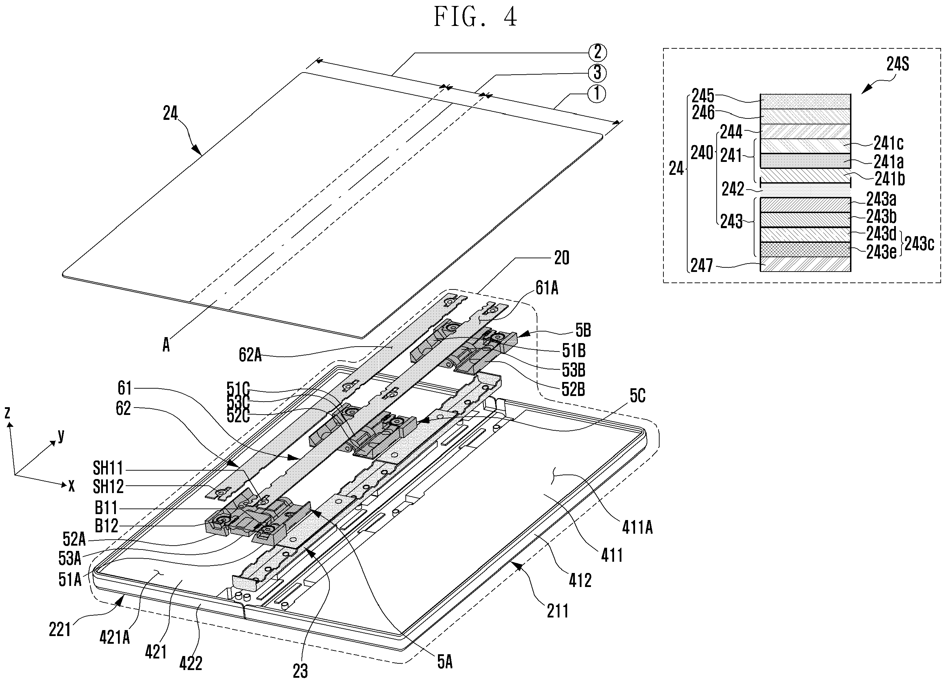

According to an embodiment, the foldable housing 20 may include a first housing (or a first housing part or a first housing structure) 21, a second housing (or a second housing part or a second housing structure) 22, a hinge housing 23, and/or a hinge part. The first housing 21 and the second housing 22 may be connected via a hinge part and may be rotatable relative to each other with respect to the hinge part. The hinge part may include one or more hinge modules (or hinge assemblies) (e.g., the first hinge module 5A, the second hinge module 5B, or the third hinge module 5C in FIG. 4).

According to an embodiment, the display area 24A of the flexible display module 24 may include an active area of the flexible display module 24 capable of displaying an image, a first display area (or a first active area or a first screen area) ①, a second display area (or a second active area or a second screen area) ②, and a third display area (or a third active area or a third screen area) ③ connecting the first display area ① and the second display area ②. The first display area ① may be positioned corresponding to the first housing 21. The second display area ② may be positioned corresponding to the second housing 22. The third display area ③ may be positioned corresponding to the hinge part. The first display area ① may be disposed on the first housing 21, and the shape of the first display area ① may be maintained by the support of the first housing 21. The second display area ② may be disposed on the second housing 22, and the shape of the second display area ② may be maintained by the support of the second housing 22. The first display area ① and the second display area ② may be provided, for example, to be substantially flat. The unfolded state of the electronic device 2 (see FIG. 2) may be the state in which the third display area ③ is disposed to be substantially flat. In the unfolded state of the electronic device 2, the first display area ① and the second display area ② may form an angle of about 180 degrees, and the display area 24A including the first display area ①, the second display area ②, and the third display area ③ may be provided in a substantially flat form. Due to the relative positions between the first display area ① disposed on the first housing 21 and the second display area ② disposed on the second housing 22 in the unfolded state of the electronic device 2, the third display area ③ connecting the first display area ① and the second display area ② may be disposed flat. In the unfolded state of the electronic device 2, the third display area ③ may be pulled at opposite sides by the first display area ① and the second display area ②, and the pulling force may be provided to reduce damage to the third display area ③ while allowing the third display area ③ to be disposed flat. The third display area ③ may be provided with an extended width that may be disposed flat while reducing stress by being pulled by the first display area ① and the second display area ② in the unfolded state of the foldable device 2. In the unfolded state of the electronic device 2, the hinge part may support the third display area ③. In the unfolded state of the electronic device 2, even if an external force (e.g., an external pressure such as a touch input using a user's finger or a touch input using an electronic pen) is applied to the third display area ③, the third display area ③ may be maintained flat without sagging due to the support of the hinge part. The illustrated coordinate axes are illustrated based on the first housing 21, and for example, the +z axis direction may be interpreted as the direction in which the plane provided by the flat first display area ① is oriented.

According to an embodiment, the electronic device 2 may be provided in an infolding type in which the display area 24A of the flexible display module 24 is folded inward. FIG. 3 illustrates the fully folded state of the electronic device 2 in which the first housing 21 and the second housing 22 are disposed such that they cannot come closer to each other anymore. In the fully folded state of the electronic device 2, the first display area ① and the second display area ② may be positioned facing each other, and the third area ③ may be disposed in a bent form. In the fully folded state of the electronic device 2, the angle between the first housing 21 and the second housing 22 (or the angle between the first display area ① and the second display area ②) may be about 0 degrees to about 10 degrees, and the display area 24A may be substantially invisible. Although not illustrated, the intermediate state of the electronic device 2 may be a state between the unfolded state and the fully folded state, or may be a less folded state compared to the fully folded state. In the intermediate state in which the angle between the first housing 21 and the second housing 22 is equal to or greater than a certain angle, a use environment in which a user does not have substantial difficulty in using the display area 24A may be provided. Hereinafter, the "folded state of the electronic device 2" described herein may refer to the fully folded state as opposed to the intermediate state of the less folded state.

According to an embodiment, when viewing the unfolded state of the electronic device 2 (see FIG. 2), the display area 24A of the flexible display module 24 may be provided in a symmetrical shape with respect to the centerline A of the electronic device 2. The centerline A may correspond to the middle of the width of the third display area ③ extended from a first boundary between the first display area ① and the third display area ③ to a second boundary between the second display area ② and the third display area ③ when viewing the unfolded state of the electronic device 2. The third display area ③ disposed in the bent shape in the folded state of the electronic device 2 (see FIG. 3) may be a substantially symmetrical shape with respect to the centerline A of the electronic device 2. When viewing the unfolded state of the electronic device 2, the display area 24A may be substantially rectangular. The display area 24A may include a first edge E1, a second edge E2, a third edge E3, and a fourth edge E4. The first edge E1 and the second edge E2 may be substantially parallel to the centerline A. The third edge E3 may connect one end of the first edge E1 and one end of the second edge E2, and the fourth edge E4 may connect the other end of the first edge E1 and the other end of the second edge E2. The first display area ① may include the first edge E1, a portion of the third edge E3, and a portion of the fourth edge E4. The second display area ② may include the second edge E2, a portion of the third edge E3, and a portion of the fourth edge E4. The third display area ③ may include a portion of the third edge E3 and a portion of the fourth edge E4. In the folded state of the electronic device 2, the first edge E1 and the second edge E2 may be aligned to overlap each other. In the folded state of the electronic device 2, a portion of the third edge E3 included in the first display area ① and a portion of the third edge E3 included in the second display area ② may be aligned to overlap each other. In the folded state of the electronic device 2, a portion of the fourth edge E4 included in the first display area ① and a portion of the fourth edge E4 included in the second display area ② may be aligned to overlap each other.

According to an embodiment, the first housing 21 may include a first frame (or a first frame structure or a first framework) 211, and/or a first cover 212 disposed on the first frame 211. The first frame 211 may include a first side (or a first side surface member, a first side surface structure, or a first side surface bezel structure) (e.g., the first side 412 in FIG. 4). The first side may be arranged along an edge of the first display area ① of the flexible display module 24. The first side may provide a first side surface of the electronic device 2 corresponding to the first display area ① of the electronic device 2. The first frame 211 may include a first support portion (e.g., the first support portion 411 in FIG. 4) extending from the first side or connected to the first side. The first display area ① may be disposed on the first support portion, and the first support portion may support the first display area ①. The first display area ① and the first cover 212 may be positioned on opposite sides of the first support portion of the first frame 211. The first side of the first frame 211 may be arranged to at least partially surround the space between the first display area ① and the first cover 212. The first display area ① may provide one outer surface of the electronic device 2, and the first cover 212 may provide the other outer surface of the electronic device 2 substantially facing away from the first display area ①. Various electrical components (or electronic components) such as a printed circuit board or a battery may be disposed on the first support between the first support of the first frame 211 and the first cover 212.

According to an embodiment, the second housing 22 may include a second frame (or a second frame structure or a second framework) 221, and/or a second cover 222 disposed on the second frame 221. The second frame 221 may include a second side (or a second side surface member, a second side surface structure, or a second side surface bezel structure) (e.g., the second side 422 in FIG. 4). The second side may be arranged along an edge of the second display area ② of the flexible display module 24. The second side may provide a second side surface of the electronic device 2 corresponding to the second display area ② of the electronic device 2. In the folded state of the electronic device 2 (see FIG. 3), the first side of the first frame 211 and the second side of the second frame 221 may be aligned to overlap each other. The second frame 221 may include a second support portion (e.g., the second support portion 421 in FIG. 4) extending from the second side or connected to the second side. The second display area ② may be disposed on the second support portion, and the second support portion may support the second display area ②. The second display area ② and the second cover 222 may be positioned on opposite sides of the first support portion of the second frame 221. The second side of the second frame 221 may be arranged to at least partially surround the space between the second display area ② and the first cover 222. The second display area ② may provide one outer surface of the electronic device 2, and the second cover 222 may provide the other outer surface of the electronic device 2 substantially facing away from the second display area ②. Various electrical components (or electronic components) such as a printed circuit board or a battery may be disposed on the second support between the second support of the second frame 221 and the second cover 212.

According to an embodiment, the hinge housing (or hinge cover) 23 may be coupled with a hinge part connecting the first frame 211 and the second frame 221. When the electronic device 2 is switched from the unfolded state (see FIG. 2) to the folded state (see FIG. 3), due to a change in the relative position between the first housing 21 and the second housing 22 connected to each other via the hinge part, and a change in the state of the hinge part coupled with the hinge housing 23, a gap between the first housing 21 and the second housing 22 opens on the side opposite to the third display area ③, and the hinge housing 23 may be exposed outside through the opened gap. In the folded state of the electronic device 2, the hinge housing 23 may be a portion of the exterior that covers the interior of the electronic device 2 through the open gap between the first housing 21 and the second housing 22. The hinge housing 23 may be more exposed in the folded state of FIG. 3 than in the intermediate state. When the electronic device 2 is switched from the folded state to the unfolded state, due to a change in the relative position between the first housing 21 and the second housing 22 connected to each other via the hinge part, and a change in the state of the hinge part coupled with the hinge housing 23, the gap between the first housing 21 and the second housing 22 on the side opposite to the third display area ③ may be closed, and the hinge housing 23 may be positioned in the inner space resulting from the combination of the first housing 21 and the second housing 22 and not be exposed outside.

According to an embodiment, the electronic device 2 may include a display 25 positioned between the second frame 221 and the second cover 222. The flexible display included in the flexible display module 24 may be interpreted as a "first display", and the display 25 may be interpreted as a "second display". The second cover 222 may be substantially transparent, and the display 25 may be visible through the second cover 222. **In** the folded state, the electronic device 2 may be configured to display an image through the display 25 instead of the flexible display module 24.

According to an embodiment, the first cover 212 may include a first curved area 212a that is curved and seamlessly extended toward the first display area ① corresponding to the first edge E1 of the display area 24A. The second cover 222 may include a second curved area 222a that is curved and seamlessly extended toward the second display area ② corresponding to the second edge E2 of the display area 24A. The first curved area 212a and the second curved area 222a may be provided symmetrically on opposite sides in either the unfolded state (see FIG. 2) or the folded state (see FIG. 3) of the electronic device 2, thereby contributing to a beautiful exterior. In an embodiment, the display 25 may be a flexible display that may be bent and disposed corresponding to the second curved area 222a of the second cover 222. In various embodiments, the first cover 212 may be provided substantially flat without the first curved area 212a. In various embodiments, the second cover 222 may be provided substantially flat without the second curved area 222a. In this case, the display 25 may be a substantially rigid display.

According to an embodiment, the electronic device 2 may include at least one of one or more audio modules (e.g., the audio module 170 in FIG. 1), one or more sensor modules (e.g., the sensor module 176 in FIG. 1), one or more camera modules (e.g., the camera module 180 in FIG. 1), one or more light-emitting modules, one or more input modules (e.g., the input module 150 in FIG. 1), and/or one or more connection terminal modules (e.g., the interface 177 or the connection terminal 178 in FIG. 1). According to various embodiments, at least one of the above-mentioned components may be omitted from the electronic device 2 or other components may be additionally included in the electronic device 2. The positions or the number of components included in the electronic device 2 may vary without being limited to the illustrated example.

Any one of the one or more audio modules may include a microphone positioned inside the electronic device 2, for example, corresponding to a microphone hole 301 provided on the exterior of the electronic device 2. In the illustrated example, the microphone hole 301 may be provided on the first side of the first frame 211, and the microphone may be positioned in the inner space of the first housing 21. The positions or numbers of microphones and microphone holes are not limited to the illustrated example and may vary. In various embodiments, the electronic device 2 may include a plurality of microphones used to detect the direction of sound.

Any one of the one or more audio modules may include a first speaker for multimedia playback (or recording playback) positioned inside the electronic device 2, for example, corresponding to a first speaker hole 302 provided on the exterior of the electronic device 2. In the illustrated example, the first speaker hole 302 may be provided on the second side of the second frame 221, and the first speaker may be positioned in the inner space of the second housing 22. Any one of the one or more audio modules may include a second speaker (e.g., a call receiver) positioned inside the electronic device 2, for example, corresponding to a second speaker hole (e.g., a receiver hole) 303 provided on the external surface of the electronic device 2. In the illustrated example, the second speaker hole 303 may be provided in the second frame 221 adjacent to the second cover 222, and the second speaker may be positioned in the inner space of the second housing 22. The positions or numbers of speakers and speaker holes are not limited to the illustrated example and may vary. In various embodiments, the microphone hole and the speaker hole may be implemented as a single hole. In various embodiments, a piezo speaker with an omitted speaker hole may be provided.

The one or more sensor modules may generate, for example, electrical signals or data values corresponding to an internal operating state of the electronic device 2 or an external environmental state. In an embodiment, one of the one or more sensor modules may include an optical sensor 304 positioned in the inner space of the second housing 22 corresponding to the second cover 212. The optical sensor 304 may be positioned in alignment with or at least partially inserted into an opening provided in the display 25. External light may reach the optical sensor through the second cover 222 and the opening provided in the display 25. The optical sensor 304 may include, for example, a proximity sensor or an illuminance sensor. The number or positions of optical sensors are not limited to the illustrated examples and may vary.

According to various embodiments, the optical sensor 304 may be positioned in the inner space of the second housing 22 to overlap at least a portion of the display area of the display 25 when viewed from above the second cover 222. In this case, the optical sensor 304 or the position of the optical sensor 304 may not be visually distinct (or exposed), while still allowing the sensing function of the optical sensor 304 to be performed. In an embodiment, the optical sensor 304 may be positioned on the rear surface of the display 25 or below or beneath the display 25, and the optical sensor 304 or the position of the optical sensor 304 may not be visually distinct (or exposed). In various embodiments, the optical sensor 304 may be positioned to be aligned with or at least partially inserted into a recess provided on the rear surface of the display 25. Some areas of the display 25 that at least partially overlap the optical sensor 304 may include different pixel structures and/or wiring structures from other areas. For example, some areas of the display 25 that at least partially overlap the optical sensor 304 may have different pixel densities compared to other areas. The pixel structure and/or wiring structure formed in some areas of the display 25 that at least partially overlap the optical sensor 304 may reduce light loss between the exterior and the optical sensor 304. For another example, multiple pixels may not be arranged in some areas of the display 25 that at least partially overlap the optical sensor 304.

According to various embodiments, various other sensors, not limited to the optical sensor 304, such as a proximity sensor or a light sensor, may be positioned corresponding to an opening provided in the display 25, or may be positioned on the rear surface of the display 25 or below or beneath the display 25. For example, an optical, electrostatic, or ultrasonic biometric sensor (e.g., a fingerprint sensor) may be positioned corresponding to the opening provided in the display 25, or may be positioned on the rear surface of the display 25 or below or beneath the display 25.

According to various embodiments, various sensors may be positioned corresponding to the openings provided in the flexible display module 24, or may be positioned on the rear surface of the flexible display module 24, or may be positioned below or beneath the flexible display module 24.

According to various embodiments, the electronic device 2 may include various other sensors (e.g., a gesture sensor, a gyro sensor, a barometric pressure sensor, a magnetic sensor, an acceleration sensor, a grip sensor, a color sensor, an infrared (IR) sensor, a temperature sensor, or humidity sensor), and the positions thereof may vary.

According to an embodiment, the one or more camera modules may include one or more lenses, an image sensor, and/or an image signal processor. The one or more camera modules may include, for example, a first camera module 305, a second camera module 306, a third camera module 307, and/or a fourth camera module 308.

According to an embodiment, the first camera module 305 may be positioned in the inner space of the second housing 22 to correspond to the second cover 222. The first camera module 305 may be positioned in alignment with or at least partially inserted into the opening provided in the display 25. External light may reach the first camera module 305 through the second cover 222 and the opening in the display 25. The opening of the display 25 aligned with or overlapping the first camera module 305 may be provided in the form of a through hole, as in the illustrated example. In various embodiments, the opening of the display 25 aligned with or overlapping the first camera module 305 may be provided in the form of a notch.

According to various embodiments, the first camera module 305 may be positioned in the inner space of the second housing 22 to overlap at least a portion of the display area of the display 25 when viewed from above the second cover 222. In this case, the position of the first camera module 305 or the first camera module 305 itself may allow the image capturing function to be executed while the first camera module 305 remains visually indistinct (or unexposed) or invisible. In an embodiment, the first camera module 305 may be positioned on the rear surface of the display 25 or below or beneath the display 25, and the first camera module 305 or the position of the first camera module 305 may be visually indistinct (or unexposed) or invisible. In various embodiments, the first camera module 305 may be positioned in alignment with or at least partially inserted into a recess provided on the rear surface of the display 25. The first camera module 305 may include, for example, a hidden display rear camera (e.g., an under-display camera (UDC)). A portion of the display 25 that at least partially overlaps the first camera module 305 may include a different pixel structure and/or wiring structure compared to other areas. For example, the portion of the display 25 that at least partially overlaps the first camera module 305 may have a different pixel density compared to other areas. The pixel structure and/or wiring structure provided in the portion of the display 25 that at least partially overlap the first camera module 305 may reduce the loss of light between the exterior and the optical sensor. As another example, multiple pixels may not be disposed in the portion of the display 25 that at least partially overlaps the first camera module 305.

According to an embodiment, the second camera module 306, the third camera module 307, or the fourth camera module 308 may be positioned within the inner space of the first housing 21, corresponding to the first cover 212. The first cover 212 may include a camera cover portion (e.g., a camera decoration portion) disposed in correspondence with the second camera module 306, the third camera module 307, and the fourth camera module 308. The camera cover portion may include a camera hole (or light-transmitting area) provided in correspondence with the second camera module 306, a camera hole (or light-transmitting area) provided in correspondence with the third camera module 307, and a camera hole (or light-transmitting area) provided in correspondence with the fourth camera module 308. The number or positions of camera modules provided in correspondence with the first cover 213 may not be limited to the illustrated example and may vary. The second camera module 306, the third camera module 307, and the fourth camera module 308 may have different attributes (e.g., fields of view) or functions from one another. The second camera module 306, the third camera module 307, and the third camera module 308 may provide different angles of view (or lenses with different angles of view), and the electronic device 2 may selectively use the corresponding camera module based on a user's selection regarding the angle of view. Any one of the second camera module 306, the third camera module 307, and the third camera module 308 may include a wide-angle camera module, a telephoto camera module, a color camera module, a monochrome camera module, or an infrared (IR) camera (e.g., a time of flight (TOF) camera or a structured light camera) module. In various embodiments, the IR camera module may also operate as at least a portion of the sensor module.

According to an embodiment, one of the one or more light-emitting modules may include a flash 309 positioned in the inner space of the first housing 21, corresponding to a flash hole (or light-transmitting area) provided in the camera cover portion of the first cover 212. The flash 309 may include a light source for the second camera module 306, the third camera module 307, and/or the fourth camera module 308. The flash 309 may include, for example, a light-emitting diode (LED) or a xenon lamp.

According to various embodiments, one of the one or more light-emitting modules (e.g., an LED, an IR LED, or a xenon lamp) may be configured to provide state information of the electronic device 2 in the form of light. In various embodiments, the light-emitting modules may provide a light source that operates in conjunction with the operation of the first camera module 305.

According to an embodiment, the one or more input modules may include a first key input device 310 or a second key input device 311. In the illustrated example, the first key input device 310 or the second key input device 311 may be positioned in an opening provided on the first side of the first frame 211. The positions or number of input modules may vary without being limited to the illustrated example. In various embodiments, the electronic device 2 may not include some or all of the key input devices, and the key input devices that are not included may be implemented as soft keys via the flexible display module 24 or the display 25. In various embodiments, the input module or the key input device may include at least one sensor module.

One of the one or more connection terminal modules (or a connector module or an interface terminal module) may include a connector (or an interface terminal) positioned inside the electronic device 2, for example, corresponding to the connector hole 312 provided on the exterior of the electronic device 2. In the illustrated example, the connector hole 312 may be provided on the first side of the first frame 211. The positions or number of connection terminal modules may vary without being limited to the illustrated example. The electronic device 2 may transmit and/or receive power and/or data to an external electronic device electrically connected to the connector. In an embodiment, the connector may include a USB connector or an HDMI connector. In various embodiments, one of the one or more connection terminal modules may include an audio connector (e.g., a headphone connector or an earphone connector), and a connector hole provided on the exterior of the electronic device 2 corresponding to the audio connector. In various embodiments, one of the one or more connection terminal modules may include a connector for a memory card positioned inside the electronic device 2, and a connector hole provided on the exterior of the electronic device 2 corresponding to the connector for the memory card.

According to various embodiments, the electronic device 2 may include a detachable pen input device (e.g., an electronic pen, a digital pen, or a stylus pen) (not illustrated). The pen input device may be implemented to be inserted into, for example, the inner space of the first housing 21 or the second housing 22. As another example, the pen input device may be attached to or detached from the hinge housing 23. The hinge housing 23 may include a recess, and the pen input device may fit into the recess.

The electronic device 2 may further include various components depending on its provied form. Although all of these components cannot be listed since the components are modified diversely depending on the convergence trend of electronic devices 2, components equivalent to the above-mentioned components may be further included in the electronic device 2. In various embodiments, specific components may be excluded from the above components or replaced with other components depending on the provided form of the electronic device.

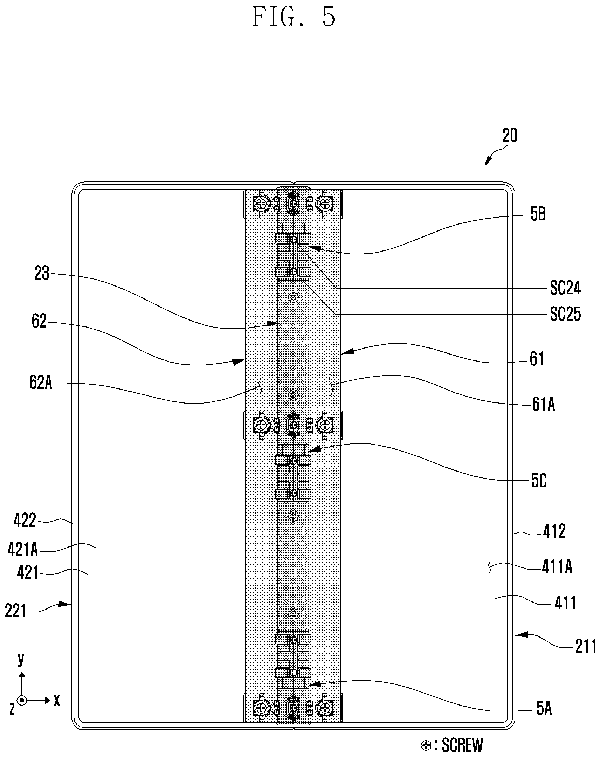

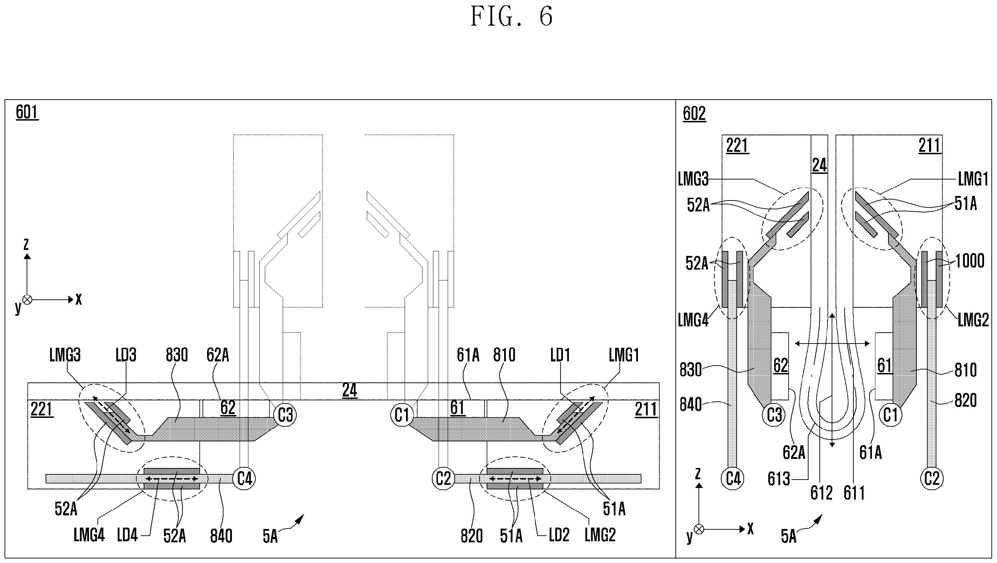

FIG**.** 4 shows a partially exploded perspective view of an electronic device 2 in the unfolded state, according to an embodiment of the disclosure. FIG. 5 shows a view illustrating the foldable housing 20 in the unfolded state of the electronic device 2 according to an embodiment of the disclosure. FIG. 6 shows a cross-sectional view illustrating the unfolded state of the electronic device 2 (601) and a cross-sectional view illustrating the folded state of the electronic device 2 (602), according to an embodiment of the disclosure.

Referring to FIGS. 4 and 5, the electronic device 2 may include a flexible display module 24 and a foldable housing 20.

According to an embodiment, the foldable housing 20 may include a first frame 211, a second frame 221, a first hinge module (or a first hinge assembly) 5A, a second hinge module (or a second hinge assembly) 5B, a third hinge module (or a third hinge assembly) 5C, a hinge housing 23, a first plate 61, and/or a second plate 62.

According to an embodiment, the first frame 211 may include a first support portion 411 and a first side 412. The first frame 211 may be provided in an integral form including the first support portion 411 and the first side 412. The first support 411 is an internal structure positioned inside the electronic device 2 to correspond to the first housing 21, and in various embodiments, may be referred to as various other terms, such as a "first bracket", a "first supporter", a "first support member", or a "first support structure". The second frame 221 may include a second support portion 421 and a second side 422. The second frame 221 may be provided in an integral form including the second support portion 421 and the second side 422. The second support portion 421 is an internal structure located inside the electronic device 2 to correspond to the second housing 22, and in various embodiments, may be referred to as various other terms, such as a "second bracket", a "second supporter", a "second support member", or a "second support structure". At least a portion of the first frame 211 and/or at least a portion of the second frame 221 may be made of a metal material and/or a non-metal material (e.g., polymer). Electrical components (or electronic components) or various members related to the electrical components may be disposed on or supported by the first frame 211 or the first support portion 411. The first support portion 411 may include, for example, a first support area 411A facing a first display area ①, and a third support area (not illustrated) facing substantially away from the first support area 411A. The first display area ① of the flexible display module 24 may be disposed in the first support area 411A of the first support portion 411. The second support portion 421 may include, for example, a second support area 421A facing a second display area ②, and a fourth support area (not illustrated) facing substantially away from the second support area 421A. The second display area ② of the flexible display module 24 may be disposed in the second support area 421A of the second support portion 421. The first display area ① may be disposed in the first support portion 411 and the second display area ② may be disposed in the second support portion 421 via various adhesive materials (or bonding materials) such as a heat-reactive adhesive material (or a heat-reactive bonding material), a light-reactive adhesive material (or a light-reactive bonding material), an ordinary adhesive material (or an ordinary bonding material), and/or a double-sided tape.

According to an embodiment, the "hinge part" mentioned in the description referring to FIGS. 2 and 3 may include a first plate 61, a second plate 62, a first hinge module 5A, a second hinge module 5B, and/or a third hinge module 5C. The hinge part may support a third display area ③ of the flexible display module 24 in the unfolded state of the electronic device 2.

According to various embodiments, the electronic device 2 may include a first inner support positioned in the inner space of the first housing 21 (see FIG. 2) corresponding to (or facing) the first cover 212 (see FIG. 2). The first inner support may cover and protect a component, such as a printed circuit board, disposed, for example, between the first support portion 411 and the first cover 212. In various embodiments, the first inner support may include a non-metallic material, and a conductive pattern used as an antenna radiator may be disposed on the first inner support. The first frame 211 may be referred to as a "first front case", and the first inner support may be referred to as a "first rear case".

According to various embodiments, the electronic device 2 may include a second inner support positioned in the inner space of the second housing 22 (see FIG. 2) corresponding to (or facing) the second cover 222 (see FIG. 2). The second inner support may cover and protect a component, such as a printed circuit board, disposed, for example, between the second support portion 421 and the first cover 222. The second frame 221 may be referred to as a "second front case", and the second inner support may be referred to as a "second rear case".

According to an embodiment, referring to a cross-sectional view 24S of the flexible display module 24, the flexible display module 24 may include a flexible display 240, a transparent cover 245, an optically transparent adhesive member (or an optically transparent adhesive member) 246, and/or a support sheet 247. For example, the flexible display 240 may be bonded with the transparent cover 245 via the optically transparent adhesive member 246 (e.g., an optical clear adhesive OCA, an optical clear resin OCR, or a super view resin SVR). The transparent cover 245 (e.g., a window) may cover the flexible display 240 to protect the flexible display 240 from the outside. The transparent cover 245 may be provided in the form of a thin flexible film (e.g., a thin film layer). The transparent cover 245 may include, for example, a plastic film (e.g., a polyimide film) or thin-film glass (e.g., ultra-thin glass (UTG)). In some embodiments, the transparent cover 245 may include multiple layers. For example, the transparent cover 245 may be in the form in which various coating layers are disposed on a plastic film or thin film glass. The transparent cover 245 may be, for example, in the form in which at least one protective layer or coating layer including a polymer material (e.g., polyester (PET), polyimide (PI), or thermoplastic polyurethane (TPU)) is disposed on a plastic film or a thin film glass. In some embodiments, the transparent cover 245 and the optically transparent adhesive member 246 may be defined or interpreted as a portion of the flexible display 240. In some embodiments, the transparent cover 246 may be interpreted as a portion of the foldable housing 20 (see FIG. 2) rather than the flexible display module 24. The flexible display 240 may include, for example, a display panel 241, a base film 242, a lower panel 243, and/or an optical layer 244. The display panel 241 may be positioned between the optical layer 244 and the base film 242. The base film 242 may be positioned between the display panel 241 and the lower panel 243. The optical layer 244 may be positioned between the optically transparent adhesive member 246 and the display panel 241. Between the display panel 241 and the base film 242, between the base film 242 and the lower panel 243, and/or between the display panel 241 and the optical layer 244, various polymer adhesive materials (or adhesive members) or bonding materials (or adhesive members) may be disposed. The display panel 241 may include, for example, a light-emitting layer 241a, a thin film transistor (TFT) film (or TFT substrate) 241b, and/or an encapsulation (e.g., a thin-film encapsulation (TFE)) 241c. The light-emitting layer 241a may include, for example, multiple pixels implemented by light-emitting elements such as organic light-emitting diodes (OLEDs) or micro-LEDs. The light-emitting layer 241a may be disposed on the TFT film 241b through organic evaporation. The TFT film 241b may be positioned between the light-emitting layer 241a and the base film 242. The TFT film 241b may refer to a film structure in which at least one TFT is disposed on a flexible substrate (e.g., a PI film) through a series of processes such as deposition, patterning, and/or etching. At least one TFT may control current to the light-emitting elements of the light-emitting layer 241a to turn on or off the pixels or to adjust brightness of the pixels. The at least one TFT may be implemented as, for example, an amorphous silicon (a-Si) TFT, a liquid crystalline polymer (LCP) TFT, a low-temperature polycrystalline oxide (LTPO) TFT, or a low-temperature polycrystalline silicon (LTPS) TFT. In an embodiment, the display panel 241 may include a storage capacitor, which may maintain a voltage signal to the pixels, maintain the voltage applied to the pixels within one frame, or reduce a change in the gate voltage of the TFT due to leakage current during the light emission time. By a routine for controlling the at least one TFT (e.g., initialization or data write), the storage capacitor may maintain the voltage applied to the pixels at regular time intervals. In an embodiment, the display panel 241 may be implemented based on OLEDs, and the encapsulation 241c may cover the light-emitting layer 241a. The organic materials and electrodes that emit light in the OLEDs may react very sensitively to oxygen and/or moisture and may lose light-emitting properties thereof. Thus, in order to reduce or prevent this phenomenon, the encapsulation 241c may seal the light-emitting layer 241a to prevent oxygen and/or moisture from penetrating into the OLEDs. The base film 242 may include a flexible film made of a polymer or plastic such as polyimide or polyester (PET). The base film 242 may support and protect the display panel 241. In some embodiments, the base film 242 may be referred to as a "protective film", a "back film", or a "back plate". The lower panel 243 may include multiple layers for various functions. Various polymeric bonding materials (or bonding materials) (not illustrated) may be disposed between adjacent ones of the multiple layers included in the lower panel 243. The lower panel 243 may include, for example, a light-blocking layer 243a, a buffer layer 243b, and/or a lower layer 243c. The light-blocking layer 243a may be positioned between the base film 242 and the buffer layer 243b. The buffer layer 243b may be positioned between the light-blocking layer 243a and the lower layer 243c. The light-blocking layer 243a may block at least some of light incident from the outside. For example, the light-blocking layer 243a may include an embossed layer. The embossed layer may be a black layer including an uneven pattern. The buffer layer 243b may alleviate an external impact applied to the flexible display 240. For example, the buffer layer 243b may include a sponge layer or a cushion layer. The lower layer 243c may diffuse, disperse, or dissipate heat generated from the electronic device 2 or the flexible display 240. The lower layer 243c may absorb or block electromagnetic waves. The lower layer 243c may alleviate an external impact applied to the electronic device 2 or the flexible display 240. For example, the lower layer 243c may include a composite sheet 243d or a copper sheet 243e. In an embodiment, the composite sheet 243d may be a sheet obtained by combining layers or sheets with different properties. For example, the composite sheet 243d may include at least one of polyimide or graphite. The composite sheet 243d may also be replaced with a single sheet including a single material (e.g., polyimide or graphite). The composite sheet 243d may be positioned between the buffer layer 243b and the copper sheet 243e. The copper sheet 243e may be replaced with various other metal sheets. In some embodiments, at least a portion of the lower layer 243c is a conductive member (e.g., a metal plate), which may help reinforce the rigidity of the electronic device 2 and may be used to block ambient noise and to dissipate heat emitted from surrounding heat-emitting components (e.g., a display drive circuit) (e.g., a display drive integrated circuit (DDI)). For example, the conductive layer may include at least one of copper (Cu), aluminum (Al), stainless steel (SUS), or a CLAD (e.g., a lamination member in which SUS and Al are alternately disposed). The lower layer 243c may include various layers for various other functions. According to an embodiment (not illustrated), at least one additional polymer layer (e.g., a layer including PI**,** PET, or TPU) may be further disposed on the rear surface of the display panel 241 in addition to the base film 242. In some embodiments, at least one of the multiple layers included in the lower panel 243 (e.g., the light-blocking layer 243a, the buffer layer 243b, the composite sheet 243d, and the copper sheet 243e) may be omitted. In some embodiments, the arrangement order of the multiple layers included in the lower panel 243 is not limited to the illustrated embodiment and may be variously changed. The optical layer 244 may include, for example, a polarizing layer (or a polarizer) or a phase retardation layer (or a phase retarder). The polarizing layer and the phase retardation layer may improve outdoor visibility of the screen. For example, the optical layer 244 may selectively allow light that is emitted from a light source of the display panel 241 and oscillates in a predetermined direction to pass therethrough. In some embodiments, a single layer in which the polarizing layer and the phase retardation layer are combined may be provided, and such a layer may be interpreted as a "circular polarizing layer". The optically transparent adhesive member 246 may be positioned between the transparent cover 245 and the optical layer 244. In some embodiments, the polarizing layer (or the circular polarizing layer) may be omitted, in which case, a black pixel define layer (PDL) and/or a color filter may be provided in place of the polarizing layer. The electronic device 2 may include a touch detection circuit (e.g., a touch sensor) (not illustrated). The touch-sensitive circuit may be implemented as a transparent conductive layer (or a film) based on various conductive materials such as indium tin oxide (ITO). In an embodiment, the touch-sensitive circuit may be disposed between the transparent cover 245 and the optical layer 244 (e.g., an add-on type). In another embodiment, the touch-sensitive circuit may be disposed between the optical layer 244 and the display panel 241 (e.g., an on-cell type). In another embodiment, the display panel 241 may include a touch-sensitive circuit or a touch-sensitive function (e.g., an in-cell type). In some embodiments, the display panel 241 may be based on an OLED, and may include an encapsulation 241c disposed between the light-emitting layer 241a and the optical layer 244. The encapsulation 241c may serve as a pixel protection layer for protecting multiple pixels of the light-emitting layer 241a. In an embodiment (not illustrated), the flexible display 240 may include a conductive pattern such as a metal mesh (e.g., an aluminum metal mesh) as a touch-sensitive circuit disposed on the encapsulation 241c between the encapsulation 241c and the optical layer 244. For example, to correspond to the bending of the flexible display 240, the metal mesh may have greater durability than the transparent conductive layer made of ITO. In some embodiments, the flexible display 240 may further include a pressure sensor (not illustrated) capable of measuring the intensity (pressure) of a touch. Multiple layers included in the display panel 241 or the lower panel 243, or a laminating structure or laminating order thereof may vary. The flexible display 240 may be implemented by omitting some of the components or adding other components depending on its provided form or convergence trend.

According to an embodiment, the support sheet (or support plate or a support layer) 247 may be disposed on the rear surface of the flexible display 240. The rear surface of the flexible display 240 may be a surface located on a side opposite to the surface from which light from the display panel 241 including multiple pixels is emitted. The support sheet 247 may be disposed (e.g., attached) on the rear surface of the lower panel 243 to cover at least a portion of the lower panel 243 of the flexible display 240. The support sheet 247 may be bonded to the lower panel 243 via an adhesive material or a bonding material. The adhesive material (or the bonding material) between the flexible display 240 and the support sheet 247 may include, for example, a heat-reactive adhesive material (or a heat-reactive bonding material), a light-reactive adhesive material (or a light-reactive bonding material), an ordinary adhesive material (or an ordinary bonding material), and/or double-sided tape. As another example, the adhesive materials (or bonding materials) may include various polymers such as triazine thiol, dithio pyrimidine, or a silane-based compound, or an organic bonding material (or organic bonding material) such as a sealant. The support sheet 247 may contribute to durability (e.g., rigidity reinforcement) of the flexible display module 24. The support sheet 247 may reduce the impact of load or stress that may occur when the foldable housing 20 (see FIG. 2) is folded on the flexible display module 24. The support sheet 247 may reduce or prevent the flexible display module 24 from being damaged by the force transmitted when the foldable housing 20 is folded. In an embodiment, the support sheet 247 may include a metallic material. The support sheet 247 may include, for example, stainless steel. The support sheet 247 may include various other metal materials. In various embodiments, the support sheet 247 may include engineering plastic.

According to an embodiment, the support sheet 247 may include a lattice structure (not illustrated) that at least partially overlaps the third display area ③ of the flexible display module 24. The lattice structure may include, for example, multiple openings (or slits) provided in the support sheet 247. The lattice structure may refer to a pattern structure in which multiple openings are regularly arranged. The multiple openings may be provided periodically, may have substantially the same shape, and may be repeatedly arranged at regular intervals. The lattice structure may reduce the decrease in flexibility of the third display area (①). In various embodiments, the lattice structure including multiple openings may be referred to by another term, such as an "opening pattern", a "hole pattern", or a "lattice pattern". In various embodiments, the support sheet 247 may include a recess pattern (not illustrated) including multiple recesses in place of the lattice structure. The recess pattern may refer to a pattern structure in which multiple cut recesses provided in a first surface of the support sheet 247 facing the lower panel 243 of the flexible display 240 or on a second surface of the support sheet 247 located opposite to the first surface are regularly arranged. In various embodiments, the lattice structure or recessed pattern may extend to a portion of the support sheet 247 corresponding to the first area ① and/or the second area ② of the flexible display module 24. In various embodiments, the support sheet 247 including a lattice structure or a recessed pattern, or a conductive member corresponding thereto, may be provided in multiple layers.

According to various embodiments, the support sheet 247 may suppress electromagnetic interference (EMI) with respect to the flexible display 240. In some embodiments, the support sheet 247 may diffuse or dissipate heat emitted from a heat-emitting component (e.g., a display drive circuit such as a display drive integrated circuit (DDI) or a DDI chip).

According to various embodiments, the support sheet 247 may be omitted.

According to various embodiments, the support sheet 247 may be interpreted as an element separate from the flexible display module 24.

According to an embodiment, the first hinge module 5A, the second hinge module 5B, and the third hinge module 5C may interconnect the first frame 211 and the second frame 221. The first frame 211 and the second frame 221 be connected to be rotatable relative to each other through the first hinge module 5A, the second hinge module 5B, and the third hinge module 5C. According to an embodiment, the first hinge module 5A, the second hinge module 5B, and the third hinge module 5C may be arranged along the centerline A of the electronic device 2, and the third hinge module 5C may be positioned between the first hinge module 5A and the second hinge module 5B. In an embodiment, the third hinge module 5C may be positioned corresponding to the center between the first hinge module 5A and the second hinge module 5B (e.g., a point on the centerline A that is substantially equidistant from the first hinge module 5A and the second hinge module 5B). In various embodiments, the number or positions of hinge modules positioned corresponding to the centerline A of the electronic device 2 may vary without being limited to the illustrated example.

According to an embodiment, the first hinge module 5A may include, for example, a first bracket 51A, a second bracket 52A, and/or a bracket connector 53A. The first bracket 51A may be disposed on or coupled to the first support area 411A of the first frame 211 through screw fastening. For screw fastening, the first bracket 51A may include one or more screw holes, and the first support area 411A may include screw fastening portions aligned in a one-to-one correspondence with the one or more screw holes of the first bracket 51A. The screw fastening portions may be bosses including female threads corresponding to male threads of screws. The first bracket 51A of the first hinge module 5A and the first support area 411A of the first frame 211 may be provided in a fitting form to be stably coupled to each other. The second bracket 52A may be disposed on or coupled to the second support area 421A of the second frame 221 through screw fastening. For screw fastening, the second bracket 52A may include one or more screw holes, and the second support area 421A may include one or more screw fastening portions aligned in a one-to-one correspondence with the one or more screw holes of the second bracket 52A. The second bracket 52A of the first hinge module 5A and the second support area 421A of the second frame 221 may be provided to be fitted so as to be stably coupled to each other. The bracket connector 53A may connect the first bracket 51A and the second bracket 52A. The first bracket 51A and the second bracket 52A may be rotatable relative to the bracket connector 53A.

According to an embodiment, the bracket connector 53A may be configured such that a first frame 211, to which the first bracket 51A is fixed, and a second frame 221, to which the second bracket 52A is fixed, are rotatable in opposite directions at the same angle. The bracket connector 53A may be configured such that the first frame 211 to which the first bracket 51A is fixed and the second frame 221 to which the second bracket 52A is fixed may be maintained after rotating by at least one predetermined angle. The bracket connector 53A may have, for example, a free-stop function. The bracket connector 53A may be configured to provide a force to allow the first frame 211 to which the first bracket 51A is fixed and the second frame 221 to which the second bracket 52A is fixed to rotate relative to each other.

The second hinge module 5B may be provided substantially identically to the first hinge module 5A, and may include, for example, a first bracket 51B, a second bracket 52B, and/or a bracket connector 53B. In an embodiment, the second hinge module 5B may be provided to the electronic device 2 in an arrangement direction opposite to that of the first hinge module 5A. The first bracket 51B of the second hinge module 5B may be disposed on or coupled to the second support area 421A of the second frame 221, and the second bracket 52B of the second hinge module 5B may be disposed on or coupled to the first support area 411A of the first frame 221.

The third hinge module 5C may be provided substantially identically to the first hinge module 5A, and may include, for example, a first bracket 51C, a second bracket 52C, and/or a bracket connector 53C. In an embodiment, the third hinge module 5C may be provided to the electronic device 2 in the same arrangement direction as the second hinge module 5B. The first bracket 51C of the third hinge module 5C may be disposed on or coupled to the second support area 421A of the second frame 221, and the second bracket 52C of the third hinge module 5C may be disposed on or coupled to the first support area 411A of the first frame 211. In some embodiments, the third hinge module 5C may be provided to the electronic device 2 in the same arrangement direction as the first hinge module 5A.

According to an embodiment, the first hinge module 5A, the second hinge module 5B, and the third hinge module 5C may be coupled to the hinge housing 23 via screws. The hinge housing 23 may be connected to the first frame 211 and the second frame 221 via the first hinge module 5A, the second hinge module 5B, and the third hinge module 5C. For screw fastening, the bracket connector 53A of the first hinge module 5A may include one or more screw holes, and the hinge housing 23 may include one or more screw fastening portions aligned in a one-to-one correspondence with the one or more screw holes of the bracket connector 53A. For screw fastening, the bracket connector 53B of the second hinge module 5B may include one or more screw holes, and the hinge housing 23 may include one or more screw fastening portions aligned in a one-to-one correspondence with the one or more screw holes of the bracket connector 53B. For screw fastening, the bracket connector 53C of the third hinge module 5C may include one or more screw holes, and the hinge housing 23 may include one or more screw fastening portions aligned in a one-to-one correspondence with the one or more screw holes of the bracket connector 53C.

According to an embodiment, the first plate 61 may be positioned corresponding to the first frame 211, and the second plate 62 may be positioned corresponding to the second frame 221. The first plate 61 and the second plate 62 may have a first width in the direction of the centerline A (e.g., the y-axis direction) that is relatively larger than a second width in the direction perpendicular to the above-mentioned direction, and may overlap the first hinge module 5A, the second hinge module 5B, and the third hinge module 5C. The first plate 61 and the second plate 62 may be coupled to the first hinge module 5A, the second hinge module 5B, and the third hinge module 5C through screw fastening.

According to an embodiment, the first plate 61 may be coupled to the bracket connector 53A of the first hinge module 5A via screws in correspondence with the first bracket 51A of the first hinge module 5A. For screw fastening, the first plate 61 may include a first screw hole SH11, and the bracket connector 53A may include a first screw fastening portion B11 aligned corresponding to the first screw hole SH11. A portion of the first plate 61 corresponding to the bracket connector 53A of the first hinge module 5A, and the bracket connector 53A may be provided to be fitted so as to be stably coupled to each other. The second plate 62 may be coupled to the bracket connector 53A of the first hinge module 5A via screws in correspondence with the second bracket 52A of the first hinge module 5A. For screw fastening, the second plate 62 may include a second screw hole SH12, and the bracket connector 53A may include a second screw fastening portion B12 aligned corresponding to the second screw hole SH12. A portion of the second plate 62 corresponding to the bracket connector 53A of the first hinge module 5A, and the bracket connector 53A may be provided to be fitted so as to be stably coupled to each other.

According to an embodiment, the first plate 61 may be coupled with the second hinge module 5B substantially in the same manner as the coupling between the first plate 61 and the first hinge module 5A. The second plate 62 may be coupled with the second hinge module 5B substantially in the same manner as the coupling between the second plate 62 and the first hinge module 5A. The first plate 61 may be coupled with the bracket connector 53B of the second hinge module 5B in correspondence with the second bracket 52B of the second hinge module 5B. The second plate 62 may be coupled with the bracket connector 53B of the second hinge module 5B in correspondence with the first bracket 51B of the second hinge module 5B.

According to an embodiment, the first plate 61 may be coupled with the third hinge module 5C substantially in the same manner as the coupling between the first plate 61 and the first hinge module 5A. The second plate 62 may be coupled with the third hinge module 5C substantially in the same manner as the coupling between the second plate 62 and the first hinge module 5A. The first plate 61 may be coupled with the bracket connector 53C of the third hinge module 5C in correspondence with the second bracket 52C of the third hinge module 5C. The second plate 62 may be coupled with the bracket connector 53C of the third hinge module 5C in correspondence with the first bracket 51C of the third hinge module 5C. In some embodiments, when the third hinge module 5C is provided to the electronic device 2 in the same arrangement direction as the first hinge module 5B, the first plate 61 may be coupled with the bracket connector 53C of the first hinge module 5A in correspondence with the first bracket 51C of the third hinge module 5C, and the second plate 62 may be coupled with the bracket connector 53C of the third hinge module 5C in correspondence with the second bracket 52C of the third hinge module 5C.

According to an embodiment, the first plate 61 may include a first surface 61A and a third surface (not illustrated) facing away from the first surface 61A. The second plate 62 may include a second surface 62A and a fourth surface (not illustrated) facing away from the second surface 62A. The first surface 61A and the second surface 62A may be positioned corresponding to the third display area ③ of the flexible display module 24. In the unfolded state of the electronic device 2 (see FIG. 2), the first surface 61A of the first plate 61 and the second surface 62B of the second plate 62 may support the third display area ③. The first surface 61A of the first plate 61 may include a flat surface capable of supporting one side area of the third display area ③ with respect to the centerline A of the electronic device 2 in the unfolded state of the electronic device 2. The second surface 62A of the second plate 62 may include a flat surface capable of supporting the other side area of the third display area ③ with respect to the centerline A of the electronic device 2 in the unfolded state of the electronic device 2. In the unfolded state of the electronic device 2, the first surface 61A of the first plate 61 and the second surface 62A of the second plate 62 may substantially form an angle of about 180 degrees and may be disposed without a substantial difference in height. In the unfolded state of the electronic device 2, even if an external force (e.g., an external pressure such as a touch input using a user's finger or a touch input using an electronic pen) is applied to the third display area ③, the third display area ③ may be maintained flat without sagging due to the support of the first plate 61 and the second plate 62.

According to an embodiment, the hinge part may be configured to provide a space in which the third display area ③ of the flexible display module 24 may be disposed in a bent shape capable of reducing bending stress when the electronic device 2 is switched from the unfolded state (see FIG. 2) to the folded state (see FIG. 3). The hinge part may be configured to provide a space in which the third display area ③ may be disposed in a bent shape capable of reducing buckling when the electronic device 2 is switched from the unfolded state to the folded state. In an embodiment, when the electronic device 2 is switched from the unfolded state to the folded state, the third display area ③ may be disposed in a droplet shape or a dumbbell shape capable of reducing breakage or permanent deformation. In the folded state of the electronic device 2, the third display area ③ may be disposed in a bent shape capable of reducing a conflict (e.g., bending stress) between a compressive stress occurring in one side area of the third display area ③ and a tensile stress occurring in one side area of the third display area ③ with respect to a neutral plane 613 (see FIG. 6).

Referring to FIGS. 4 and 6, the electronic device 2 may include a flexible display module 24, a first frame 211, a second frame 221, a first hinge module 5A, a first plate 61, and/or a second plate 62. In an embodiment, the first hinge module 5A may include a first bracket 51A, a second bracket 52A, a first unit 810, a second unit 820, a third unit 830, and a fourth unit 840. The bracket connector 53A (see FIG. 4) may include the first unit 810, the second unit 820, the third unit 830, and/or the fourth unit 840.

According to an embodiment, the first hinge module 5A may include a first rotation axis C1 and a second rotation axis C2 for mutual rotational motion between the first bracket 51A and the bracket connector 53A. The first rotation axis C1 and the second rotation axis C2 may be substantially parallel to the centerline A of the electronic device 2 and may be spaced apart from each other. The first unit 810 of the bracket connector 53A may be connected to the first bracket 51A to be rotatable about the first rotation axis C1. The first unit 810 of the bracket connector 53A may be slidably connected to the first bracket 51A to be linearly movable in a first linear direction LD1 with respect to the first bracket 51A. The second unit 820 of the bracket connector 53A may be connected to the first bracket 51A to be rotatable about the second rotation axis C2. The second unit 820 of the bracket connector 53A may be slidably connected to the first bracket 51A to be linearly movable in a second linear direction LD2, which differs from the first linear direction LD1, with respect to the first bracket 51A. The first linear direction LD1 may be perpendicular to the first rotation axis C1 or the centerline A of the electronic device 2, and the second linear direction LD2 may be perpendicular to the second rotation axis C2 or the centerline A of the electronic device 2. In an embodiment, when viewed in the direction of the centerline A of the electronic device 2 (e.g., when viewed in the y-axis direction), the second linear direction LD2 may be substantially parallel to the direction in which the first display area ① of the flexible display module 24 is flatly extended, and may form an acute angle with the first linear direction LD1.

According to an embodiment, the first hinge module 5A may include a third rotation axis C3 and a fourth rotation axis C4 for mutual rotational motion between the second bracket 52A and the bracket connector 53A. The third rotation axis C3 and the fourth rotation axis C4 may be substantially parallel to the centerline A of the electronic device 2 (see FIG. 4) and may be spaced apart from each other. The third unit 830 of the bracket connector 53A may be connected to the second bracket 52A to be rotatable about the third rotation axis C3. The third unit 830 of the bracket connector 53A may be slidably connected to the second bracket 52A to be linearly movable in a third linear direction LD3 with respect to the second bracket 52A. The fourth unit 840 of the bracket connector 53A may be connected to the second bracket 52A to be rotatable about the fourth rotation axis C4. The fourth unit 840 of the bracket connector 53A may be slidably connected to the first bracket 52A to be linearly movable in a fourth linear direction LD4, which differs from the third linear direction LD3, with respect to the first bracket 52A. The third linear direction LD3 may be perpendicular to the third rotation axis C3 or the centerline A of the electronic device 2, and the fourth linear direction LD4 may be perpendicular to the fourth rotation axis C4 or the centerline A of the electronic device 2. In an embodiment, when viewed in the direction of the centerline A of the electronic device 2 (e.g., when viewed in the y-axis direction), the fourth linear direction LD4 may be substantially parallel to the direction in which the second display area ② of the flexible display module 24 is flatly extended, and may form an acute angle with the third linear direction LD3.

According to an embodiment, the first hinge module 5A may include a first linear motion guide LMG1 so that the first unit 810 and the first bracket 51A are mutually slidable (e.g., mutually linearly movable) in the first linear direction LD1. The first linear motion guide LMG1 may include, for example, a first linear motion guide rail provided on the first bracket 51A, and a portion of the first unit 810 (e.g., a first linear motion slider) slidably positioned on the first linear motion guide rail. The first unit 810 and the first bracket 51A may be stably slidably connected to each other in the first linear direction LD1 due to the first linear motion guide LMG1. The first hinge module 5A may include a second linear motion guide LMG2 so that the second unit 820 and the first bracket 51A are mutually slidable (e.g., mutually linearly movable) in the second linear direction LD2. The second linear motion guide LMG2 may include, for example, a second linear motion guide rail provided on the first bracket 51A, and a portion of the second unit 820 (e.g., a second linear motion slider) slidably positioned on the second linear motion guide rail. The second unit 820 and the first bracket 51A may be stably slidably connected to each other in the second linear direction LD2 due to the second linear motion guide LMG2.

According to an embodiment, the first hinge module 5A may include a third linear motion guide LMG3 so that the third unit 830 and the second bracket 52A are mutually slidable (e.g., mutually linearly movable) in the third linear direction LD3. The third unit 830 and the second bracket 52A may be stably slidably connected to each other in the third linear direction LD3 due to the third linear motion guide LMG3. The first unit 810 and the third unit 830, and the first linear motion guide LMG1 and the third linear motion guide LMG3 may be provided substantially symmetrically with respect to the centerline A of the electronic device 2. The first hinge module 5A may include a fourth linear motion guide LMG4 so that the fourth unit 840 and the second bracket 52A are mutually slidable (e.g., mutually linearly movable) in the fourth linear direction LD4. The fourth unit 840 and the second bracket 52A may be stably slidably connected to each other in the fourth linear direction LD4 due to the fourth linear motion guide LMG4. The second unit 820 and the fourth unit 840, and the second linear motion guide LMG2 and the fourth linear motion guide LMG4 may be provided substantially symmetrically with respect to the centerline A of the electronic device 2.

According to an embodiment, the first plate 61 may be disposed on or coupled to the first unit 810 of the bracket connector 53A, and the second plate 62 may be disposed on or coupled to the third unit 830 of the bracket connector 53A.

According to an embodiment, when the electronic device 2 is switched between the unfolded state (see reference numeral "601") and the folded state (see reference numeral "602"), there may be a rotational motion of the first unit 810 about the first rotation axis C1, a first mutual linear motion (or first mutual sliding) between the first unit 810 and the first bracket 51A via the first linear motion guide LMG1, a rotational motion of the second unit 820 about the second rotation axis C2, and a second mutual linear motion (or second mutual sliding) between the second unit 820 and the first bracket 51A via the second linear motion guide LMG2. When the electronic device 2 is switched between the unfolded state and the folded state, there may be a rotational motion of the third unit 830 about the third rotation axis C3, a third mutual linear motion (or third mutual sliding) between the third unit 830 and the second bracket 52A via the third linear motion guide LMG3, a rotational motion of the fourth unit 840 about the fourth rotation axis C4, and a fourth mutual linear motion (or fourth mutual sliding) between the fourth unit 840 and the second bracket 52A via the fourth linear motion guide LMG4.

According to an embodiment, when the electronic device 2 is switched from the unfolded state (see reference numeral "601") to the folded state (see reference numeral "602"), the first rotation axis C1 and the second rotation axis C2 may be positioned further apart from the first frame 211 to which the first bracket 51A is fixed, compared to the unfolded state of the electronic device 2. When the electronic device 2 is switched from the unfolded state to the folded state, the first unit 810 to which the first plate 61 is fixed may be positioned to be retracted relative to the first bracket 51A in a direction opposite to the direction in which the third display area ③ of the flexible display module 24 is oriented. When the electronic device 2 is switched from the unfolded state to the folded state, the third rotation axis C3 and the fourth rotation axis C4 may be positioned further away from the second frame 221 to which the second bracket 52A is fixed compared to the unfolded state of the electronic device 2. When the electronic device 2 is switched from the unfolded state to the folded state, the third unit 830 to which the second plate 62 is fixed may be positioned to be retracted relative to the second bracket 52A in a direction opposite to the direction in which the third display area ③ of the flexible display module 24 is oriented. When the electronic device 2 is switched from the unfolded state to the folded state, the first surface 61A of the first plate 61 and the second surface 62A of the second plate 62 may be positioned facing each other and spaced apart from each other. When the electronic device 2 is switched from the unfolded state to the folded state, due to the retraction of the first unit 810 relative to the first bracket 51A and the retraction of the third unit 830 relative to the second bracket 52A, the first plate 61 coupled with the first unit 810 and the second plate 62 coupled with the third unit 830 may be positioned not to interfere with the third display area ③ of the flexible display module 24. When the electronic device 2 is switched from the unfolded state to the folded state, due to the retraction of the first unit 810 relative to the first bracket **51A and** the retraction of the third unit 830 relative to the second bracket 52A, the space width in a first direction 611 between the first surface 61A of the first plate 61 and the second surface 62A of the second plate 62 may be provided to allow the third display area ③ to be disposed in a bent shape capable of reducing bending stress and/or buckling. When the electronic device 2 is switched from the unfolded state to the folded state, the first rotation axis C1 and the second rotation axis C2 may move away from the first frame 211 on which the first display area ① is disposed, and the third rotation axis C3 and the fourth rotation axis C4 may move away from the second frame 221 on which the second display area ② is disposed to allow the bracket connector 53A to move away from the structure in which the first frame 211 and the second frame 221 face each other in a second direction 612 that is perpendicular to the first direction 611. When the electronic device 2 is switched from the unfolded state to the folded state, the bracket connector 53A may be positioned away from the structure in which the first frame 211 and the second frame 221 may face each other in the second direction 612 to provide a space width in the second direction 612 so as to allow the third display area ③ to be disposed in a bent shape capable of reducing bending stress and/or buckling.

According to an embodiment, when the electronic device 2 is switched from the unfolded state to the folded state, the bracket connector 53A may be positioned away from the structure in which the first frame 211 and the second frame 221 may face each other in the second direction 612 to allow the hinge housing 23 coupled to the bracket connector 53A to be exposed outside through the open gap between the first housing 21 and the second housing 22, as illustrated in FIG. 3, while reducing the gap with the first housing 21 and the gap with the second housing 22.

According to an embodiment, when the electronic device 2 is switched from the folded state (see reference numeral "602") to the unfolded state (see reference numeral "601"), due to the change in relative position between the first frame 211 and the second frame 221, and the first hinge module 5A, the second hinge module 5B, and the third hinge module 5C, which operate corresponding thereto, the first surface 61A of the first plate 61 and the second surface 62A of the second plate 62 may be positioned to support the third display area ③ of the flexible display module 24.

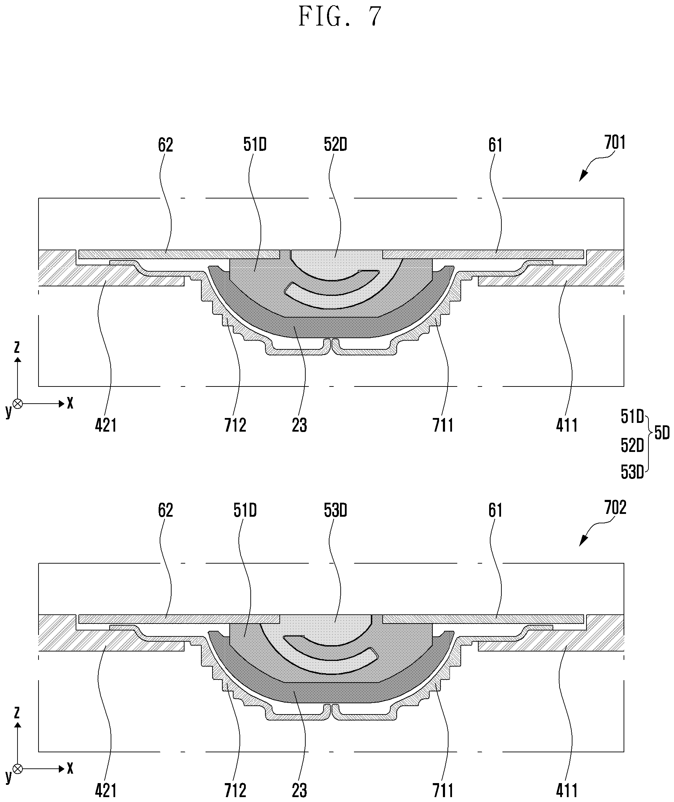

According to an embodiment, the structure in which the third hinge module 5C between the first hinge module 5A and the second hinge module 5B is coupled with the first plate 61 and the second plate 62 may reduce or prevent lifting of the first plate 61 and the second plate 62. In various embodiments, a guide rail assembly 6D (see FIG. 7) may be provided in place of the third hinge module 5C.

FIG. 7 shows cross-sectional views 701 and 702 of a foldable housing 20 in an unfolded electronic device 2 according to various embodiments of the disclosure.

Referring to FIG. 7, the foldable housing 20 may include a first support portion 411, a second support portion 421, a first plate 61, a second plate 62, a guide rail assembly 5D, a first hinge housing cover 711, and/or a second hinge housing cover 712. The first hinge housing cover 711 may be a portion of the first housing 21 (see FIG. 2), and the second hinge housing cover 712 may be a portion of the second housing 22 (see FIG. 2).

According to an embodiment, the guide rail assembly 5D may be disposed in or coupled to the hinge housing 23. The hinge housing 23 may include one surface that is exposed outside in the folded state of the electronic device 2 (see FIG. 3) and a recess provided on the other surface on the opposite side, and the guide rail assembly 5D may be disposed in or coupled to the recess of the hinge housing 23. In an embodiment, the guide rail assembly 5D may include a guide rail 51D, a first slider 52D, and/or a second slider 53D. The first slider 52D and the second slider 53D may be slidably disposed on the guide rail 51D. The guide rail 51D may be coupled with the hinge housing 23 through screw fastening. The first slider 52D may be coupled with the first plate 61 through screw fastening. The second slider 53D may be coupled with the second plate 62 through screw fastening. The guide rail 51D may include a first guide rail and a second guide rail. The first guide rail may be a space provided along a path corresponding to the rotational motion of the first plate 61 to which the first slider 52D is coupled. The second guide rail may be a space provided along a path corresponding to the rotational motion of the second plate 62 to which the second slider 53D is coupled. The first slider 52D may include a first slider that is inserted into the first guide rail of the guide rail 51D and is movable while being guided by the first guide rail. The second slider 53D may include a second slider that is inserted into the second guide rail of the guide rail structure 51D and is movable while being guided by the second guide rail. The guide rail assembly 5D may reduce the lifting of the first plate 61 and the second plate 62.

According to an embodiment, the first hinge housing cover 711 may be connected to the first support portion 411. In various embodiments, the first support portion 411 may be provided in a form that further includes a portion corresponding to the first hinge housing cover 711. In this case, the first hinge housing cover 711 may be omitted. The second hinge housing cover 712 may be connected to the second support portion 421. In various embodiments, the second support portion 421 may be provided in a form that further includes a portion corresponding to the second hinge housing cover 712. In this case, the second hinge housing cover 712 may be omitted. One surface of the hinge housing 23, which is exposed outside in the folded state of the electronic device 2 (see FIG. 3), may include a curved surface, and the first hinge housing cover 711 and the second hinge housing cover 712 may be provided in a curved shape that includes a curved portion corresponding to the curved surface. In various embodiments, the first hinge housing cover 711 may be referred to by various other terms, such as a "first curved cover", and the second hinge housing cover 712 may be referred to by various other terms, such as a "second curved cover". In the unfolded state of the electronic device 2 (see FIG. 2), the first hinge housing cover 711 and the second hinge housing cover 712 may respectively cover opposite sides of the hinge housing 23, and the hinge housing 23 may not be substantially exposed outside. In the folded state of the electronic device 2, the hinge housing 23 may be exposed outside between the first hinge housing cover 711 and the second hinge housing cover 712.

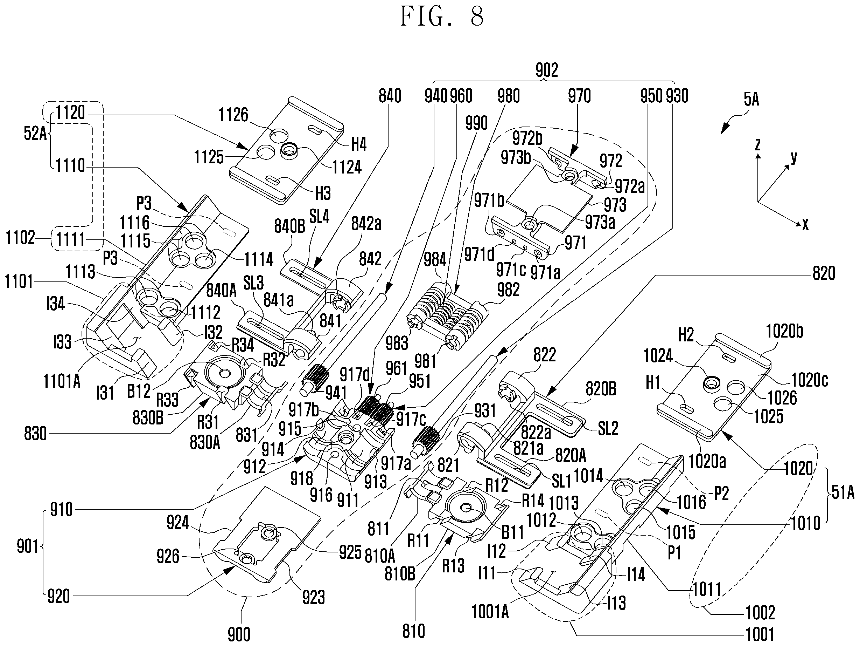

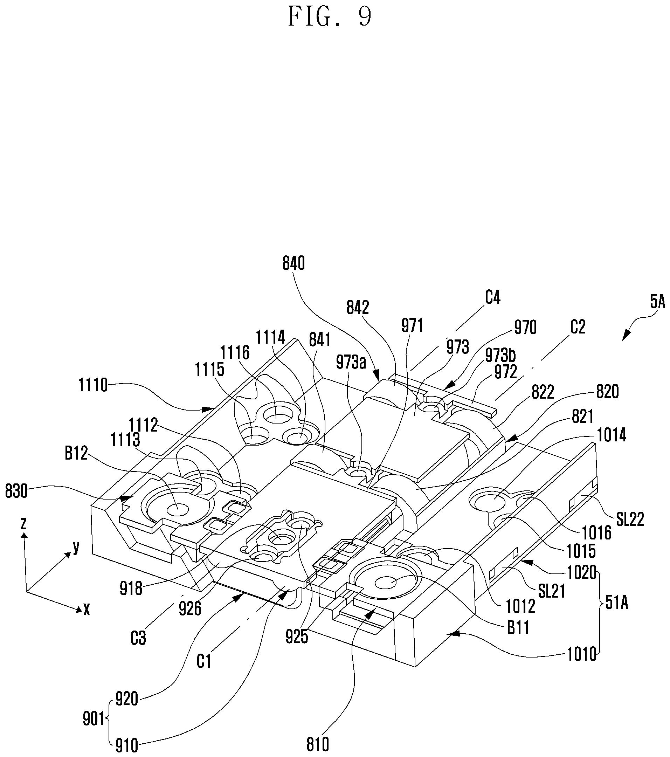

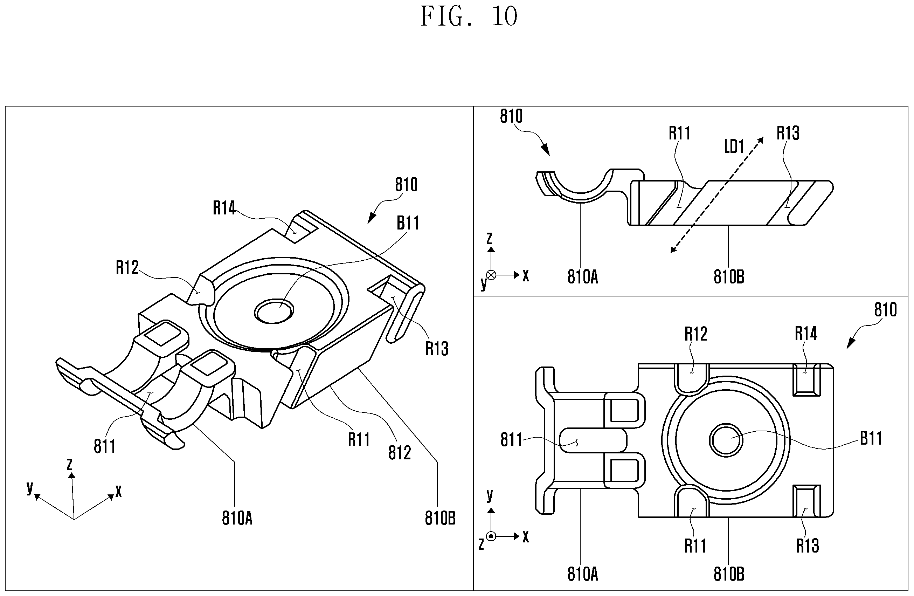

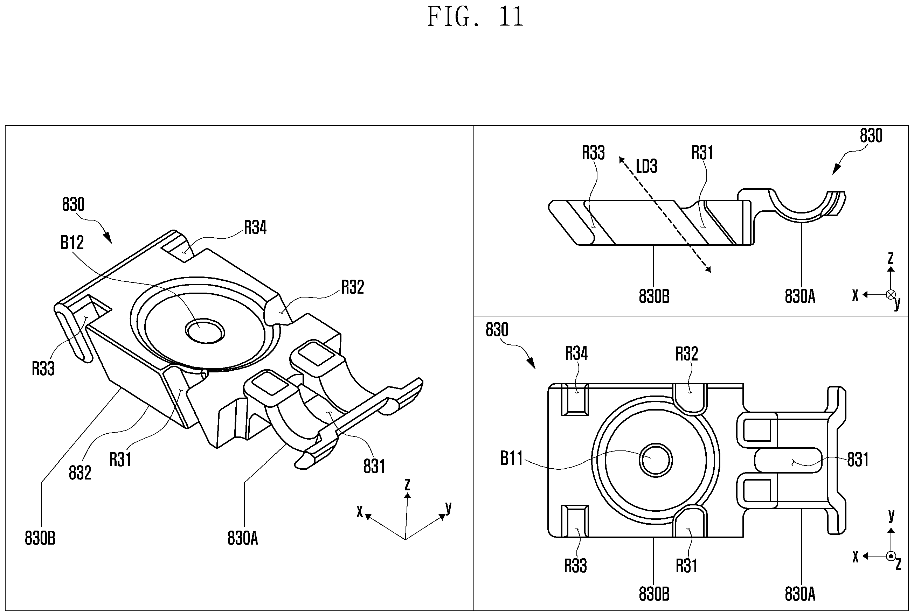

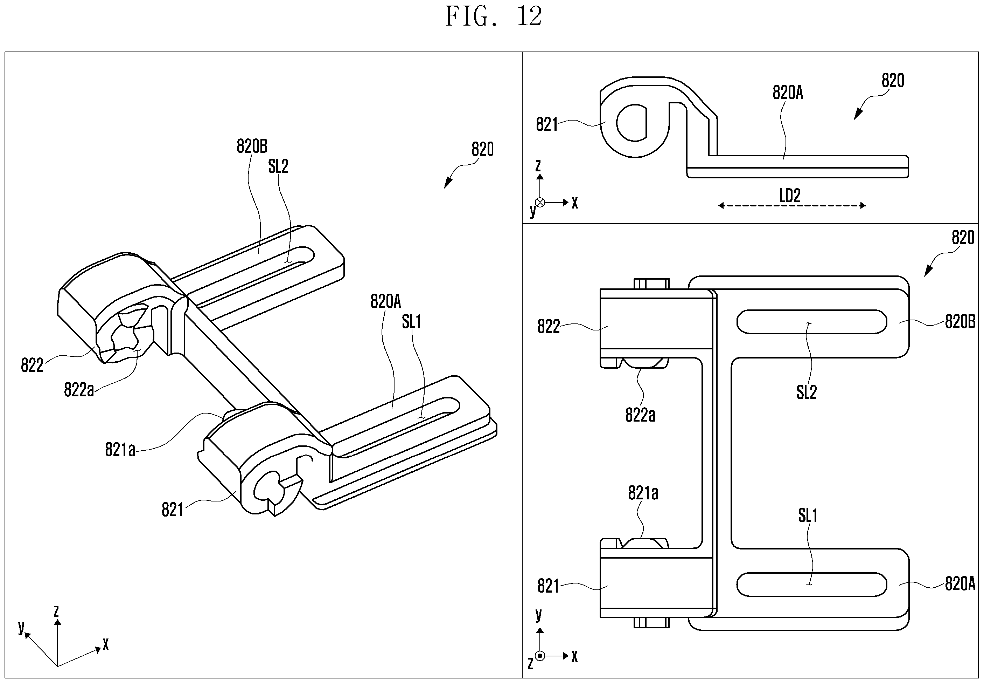

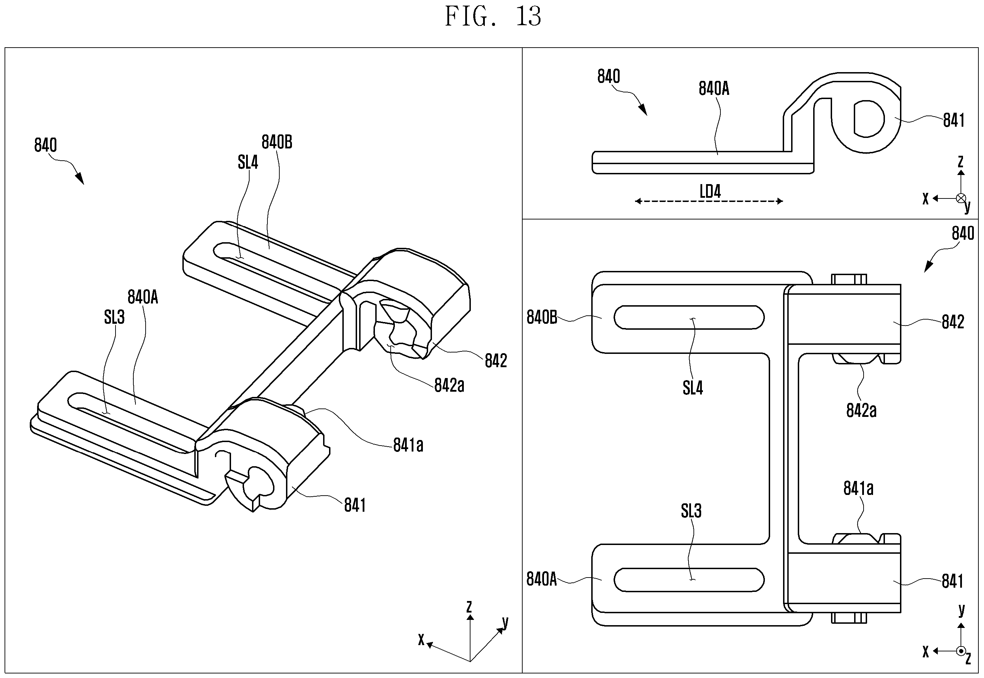

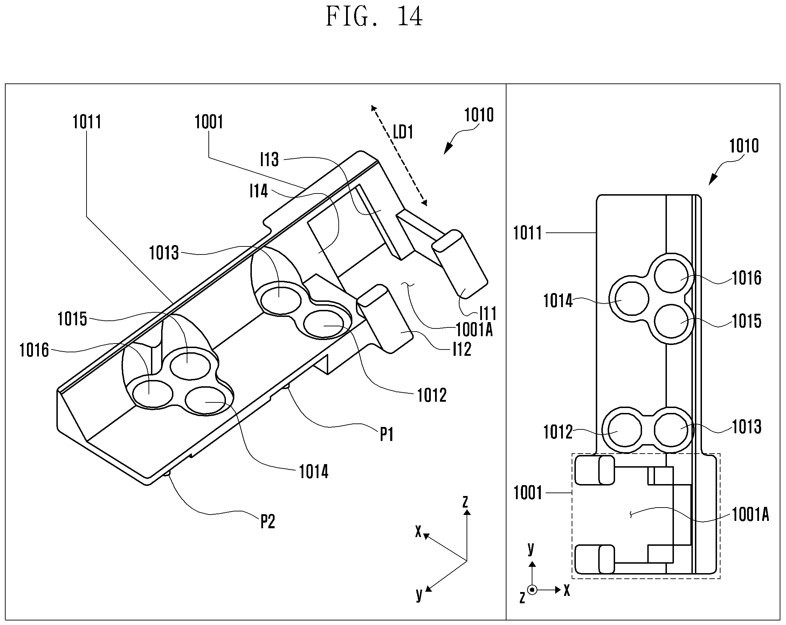

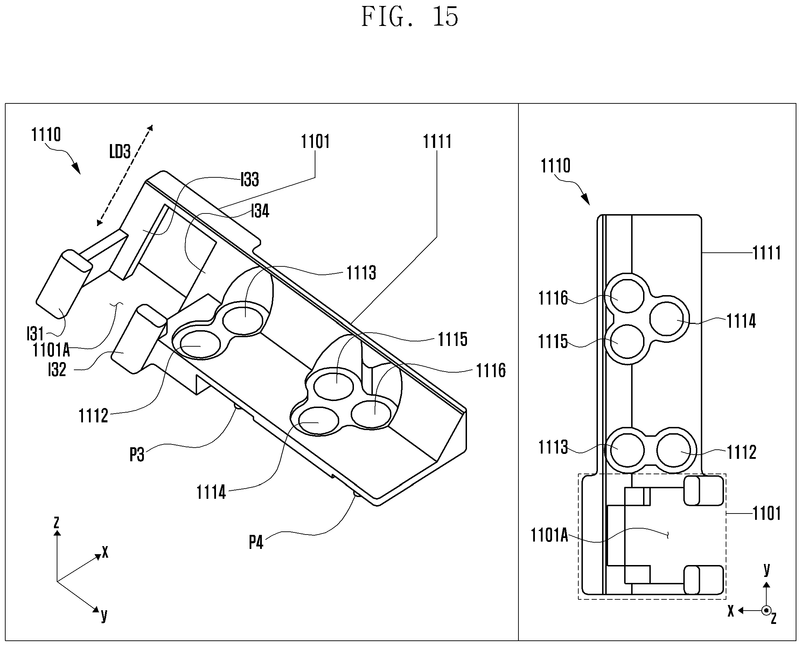

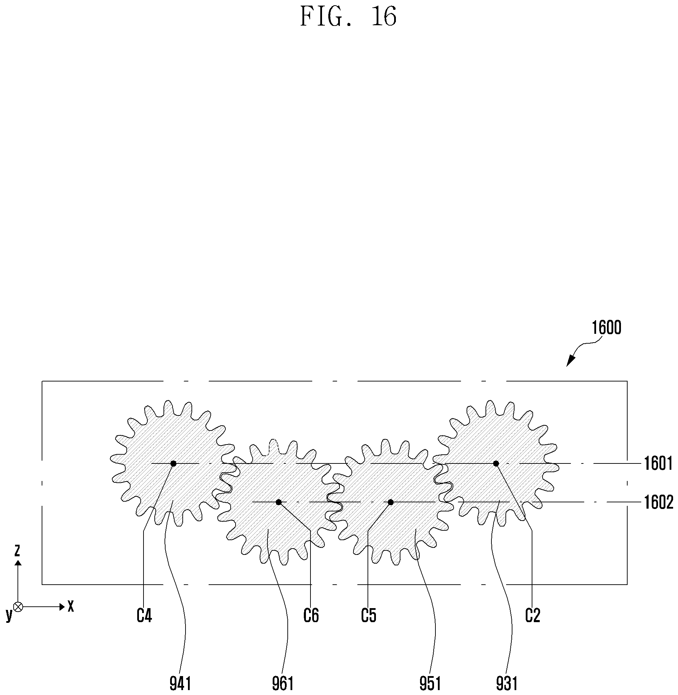

FIG. 8 shows an exploded perspective view of a first hinge module 5A according to an embodiment of the disclosure. FIG. 9 shows a perspective view of the first hinge module 5A according to an embodiment of the disclosure. FIG. 10 shows views illustrating a first unit 810 of the first hinge module 5A according to an embodiment of the disclosure. FIG. 11 shows views illustrating a third unit 830 of the first hinge module 5A according to an embodiment of the disclosure. FIG. 12 shows views illustrating a second unit 820 of the first hinge module 5A according to an embodiment of the disclosure. FIG. 13 shows views illustrating a fourth unit 840 of the first hinge module 5A according to an embodiment of the disclosure. FIG. 14 shows views illustrating a fifth unit 1010 of the first bracket 51A according to an embodiment of the disclosure. FIG. 15 shows views illustrating a seventh unit 1110 of the second bracket 52A according to an embodiment of the disclosure. FIG. 16 shows a cross-sectional view 1600 illustrating a first circular gear 931, a second circular gear 941, a third circular gear 951, and a fourth circular gear 961 according to an embodiment of the disclosure.

Referring to FIGS. 8 to 16, the first hinge module 5A may include a first unit 810, a second unit 820, a third unit 830, a fourth unit 840, an actuator 900, a first bracket 51A, and/or a second bracket 52A. The bracket connector 53A of FIG. 4 may be an assembly including a first unit 810, a second unit 820, a third unit 830, a fourth unit 840, and an actuator 900.

According to an embodiment, the first unit 810 may be connected to the actuator 900 to be rotatable about a first rotation axis C1 with respect to the actuator 900. The first rotation axis C1 may be a central axis (e.g., a straight line that is the center of rotation) about which the first unit 810 rotates, and may be provided by a portion to which the first unit 810 and the actuator 900 are rotatably connected. The second unit 820 may be connected to the actuator 900 to be rotatable about a second rotation axis C2 with respect to the actuator 900. The second rotation axis C2 may be a central axis about which the second unit 820 rotates, and may be provided by a portion to which the second unit 810 and the actuator 900 are rotatably connected. The first rotation axis C1 and the second rotation axis C2 may be substantially parallel to the centerline A of the electronic device 2 (see FIG. 2) and may be spaced apart from each other. The first unit 810 and the second unit 820 may be spaced apart from each other in the direction of the centerline A of the electronic device 2 (see FIG. 2) (e.g., the y-axis direction).

According to an embodiment, the third unit 830 may be connected to the actuator 900 to be rotatable about a third rotation axis C3 with respect to the actuator 900. The third rotation axis C3 may be a central axis (e.g., a straight line that is the center of rotation) about which the third unit 830 rotates, and may be provided by a portion to which the third unit 830 and the actuator 900 are rotatably connected. The fourth unit 840 may be connected to the actuator 900 to be rotatable about a fourth rotation axis C4 with respect to the actuator 900. The fourth rotation axis C4 may be a central axis about which the fourth unit 840 rotates, and may be provided by a portion to which the fourth unit 840 and the actuator 900 are rotatably connected. The third rotation axis C3 and the fourth rotation axis C4 may be substantially parallel to the centerline A of the electronic device 2 (see FIG. 2) and may be spaced apart from each other. The third unit 830 and the fourth unit 840 may be spaced apart from each other in the direction of the centerline A of the electronic device 2 (see FIG. 2) (e.g., the y-axis direction). The first unit 810 and the third unit 830 may be provided substantially symmetrically with respect to the centerline A of the electronic device 2 (see FIG. 2). The second unit 820 and the fourth unit 840 may be provided substantially symmetrically with respect to the centerline A of the electronic device 2 (see FIG. 2). The first rotation axis C1 of the first unit 810 and the third rotation axis C3 of the third unit 830 may be positioned substantially symmetrically with respect to the centerline A of the electronic device 2 (see FIG. 2). The second rotation axis C2 of the second unit 820 and the fourth rotation axis C4 of the fourth unit 840 may be positioned substantially symmetrically with respect to the centerline A of the electronic device 2 (see FIG. 2).

According to an embodiment, the first bracket 51A may be coupled to the first support portion 411 (see FIG. 4) of the first frame 211 through screw fastening. The first hinge module 5A may be connected to the first support portion 411 (see FIG. 4) via the first bracket 51A. Since the first bracket 51A is fixed to the first support portion 411 (see FIG. 4), the first frame 211 (see FIG. 4) may move together with the first bracket 51A when the state of the electronic device 2 changes (e.g., between the unfolded state of FIG. 2 and the folded state of FIG. 3). The first unit 810 and the second unit 820 may be connected to the first bracket 51A to be slidable with respect to the first bracket 51A.

According to an embodiment, the second bracket 52A may be connected to the second support portion 421 (see FIG. 4) of the second frame 221 through screw fastening. The first hinge module 5A may be connected to the second support portion 421 (see FIG. 4) via the second bracket 52A. Since the second bracket 52A is fixed to the second support portion 421 (see FIG. 4), the second frame 221 (see FIG. 4) may move together with the second bracket 52A during the state switching of the electronic device 2 (e.g., between the unfolded state of FIG. 2 and the folded state of FIG. 3). In an embodiment, the first bracket 51A and the second bracket 52A may be provided substantially symmetrically with respect to the centerline A of the electronic device 2 (see FIG. 2). The third unit 830 and the fourth unit 840 may be connected to the second bracket 52A to be slidable with respect to the second bracket 52A.

According to an embodiment, the actuator 900 may include a first rotation support body (or first rotation support assembly) 901 and a second rotation support body (or second rotation support assembly) 902.

According to an embodiment, the first rotation support body 901 may be connected to the first unit 810 and the third unit 830. The first hinge module 5A may include a first rotational motion guide for mutual rotational motion between the first rotation support body 901 and the first unit 810. Through the first rotational motion guide, the first unit 810 may be smoothly rotated with respect to the first rotation support body 901. The first hinge module 5A may include a second rotational motion guide for mutual rotational motion between the first rotation support body 901 and the third unit 830. Through the second rotational motion guide, the third unit 830 may be smoothly rotated with respect to the first rotation support body 901.

According to an embodiment, the first rotational motion guide for mutual rotational motion between the first rotation support body 901 and the first unit 810 may include a first rotational motion guide rail included in the first rotation support body 901, and a first rotational motion slider 810A included in the first unit 810 corresponding to the first rotational motion guide rail. The first rotational motion slider 810A may be positioned on the first rotational motion guide rail. When the first rotational motion slider 810A is moved while being guided by the first rotational motion guide rail, the first unit 810 may be rotated about the first rotation support body 901. The second rotational motion guide for mutual rotational motion between the first rotation support body 901 and the third unit 830 may include a second rotational motion guide rail included in the first rotation support body 901, and a second rotational motion slider 830A included in the third unit 830 corresponding to the second rotational motion guide rail. The second rotational motion slider 830A may be positioned on the second rotational motion guide rail. When the second rotational motion slider 830A is moved while being guided by the second rotational motion guide rail, the third unit 810 may be rotated about the first rotation support body 901.

According to an embodiment, the first rotation support body 901 may include a rotation support bracket 910 and a bracket cover 920 coupled with the rotation support bracket 910. The rotation support bracket 910 may be at least partially positioned between the hinge housing 23 (see FIG. 4) and the bracket cover 920. The rotation support bracket 910 may be coupled with the hinge housing 23 through screw fastening. For screw fastening, the rotation support bracket 910 may include a screw hole 918 provided in the central portion corresponding to the centerline A of the electronic device 2 (see FIG. 2), and the hinge housing 23 (see FIG. 4) may include a screw fastening portion aligned corresponding to the screw hole 918. The first rotation support body 901, the rotation support bracket 910, or the bracket cover 920 may be provided in a substantially symmetrical shape with respect to the centerline A of the electronic device 2 (see FIG. 2).

According to an embodiment, the rotation support bracket 910 and the bracket cover 920 may be coupled through snap-fit fastening. For snap-fit fastening, the rotation support bracket 910 may include a first hook 913 and a second hook 914 positioned on opposite sides with respect to the centerline A (see FIG. 2) of the electronic device 2, and the bracket cover 920 may include a first hook fastening portion (e.g., a first engagement portion) 923 corresponding to the first hook 913 and a first hook fastening portion (e.g., a second engagement portion) 924 corresponding to the second hook 914.

According to an embodiment, the rotation support bracket 910 and the bracket cover 920 may be coupled through screw fastening. For the screw fastening, the bracket cover 920 may include screw holes 925 and 926 spaced apart from each other in the direction of the centerline A (e.g., the y-axis direction) in the central portion corresponding to the centerline A of the electronic device 2 (see FIG. 2), and the rotation support bracket 910 may include screw fastening portions 915 and 916 aligned in a one-to-one correspondence with the screw holes 925 and 926. The screw fastening portions 915 and 916 may be provided in the central portion of the first rotation support body 901 of the first hinge module 5A corresponding to the centerline A (see FIG. 2) of the electronic device 2, and may be disposed spaced apart from each other in the direction of the centerline A. The rotation support bracket 910 may include a first rail surface 911 and a second rail surface 912 provided on the other surface opposite to one surface facing the hinge housing 23 (see FIG. 4). The first rotational motion slider 810A of the first unit 810 may be slidably positioned in the first space between the first rail surface 911 and the bracket cover 920, and the first space may be a first rotational motion guide rail that guides the movement of the first rotational motion slider 810A. The first rotational motion slider 810A and the first rotational motion guide rail may be provided in a curved shape extending in the circumferential direction for mutually stable rotational motion between the first unit 810 and the first rotation support body 901. The second rotational motion slider 830A of the third unit 830 may be slidably positioned in the second space between the second rail surface 912 and the bracket cover 920, and the second space may be a second rotational motion guide rail that guides the movement of the second rotational motion slider 830A. The second rotational motion slider 830A and the second rotational motion guide rail may be provided in a curved shape extending in the circumferential direction for mutually stable rotational motion between the third unit 830 and the first rotation support body 901. The first rotational motion guide rail and the second rotational motion guide rail, and the first rotational motion slider 810A and the second rotational motion slider 830A may be provided substantially symmetrically with respect to the centerline A of the electronic device 2 (see FIG. 2). The first rotation axis C1 of the first unit 810 may be substantially provided by a sliding pair including the first rotational motion slider 810A and the first rotational motion guide rail. The first unit 810 may be rotatable relative to the first rotation support body 901 about the first rotation axis C1, and the extent to which the first rotational motion slider 810A of the first unit 810 is introduced into (or overlaps) the first rotation support body 901 may vary depending on the angle between the first frame 211 (see FIG. 4) and the second frame 221 (see FIG. 4). The third rotation axis C3 of the third unit 830 may be substantially provided by a sliding pair including the second rotational motion slider 830A and the second rotational motion guide rail. The third unit 830 may be rotatable relative to the first rotation support body 901 about the third rotation axis C3, and the extent to which the second rotational motion slider 830A of the third unit 830 is introduced into (or overlaps) the first rotation support body 901 may vary depending on the angle between the first frame 211 (see FIG. 4) and the second frame 221 (see FIG. 4).

According to an embodiment, the combination of the rotation support bracket 910, the bracket cover 920, and the first rotational motion slider 810A of the first unit 810 may be provided to prevent the first rotational motion slider 810A from being separated from the first rotation support body 901 while enabling the first rotational motion slider 810A to move within a predetermined path range of the first rotational motion guide rail. The combination of the rotation support bracket 910, the bracket cover 920, and the second rotational motion slider 830A of the third unit 830 may be provided to prevent the second rotational motion slider 830A from being separated from the first rotation support body 901 while enabling the second rotational motion slider 830A to move within a predetermined path range of the second rotational motion guide rail.

According to an embodiment, the first rotational motion slider 810A of the first unit 810 may include an opening 811 provided corresponding to the first hook 913. The first hook 913 may be inserted into the opening 811. The opening 811 may extend along the movement path of the first rotational motion slider 810A relative to the first rotation support body 901. During the mutual rotational motion between the first unit 810 and the first rotation support body 901, the relative positions between the first hook 913 and the opening 811 may vary. The opening 811 may prevent the first hook 913 and the first rotational motion slider 810A from interfering with each other during the mutual rotational motion between the first unit 810 and the first rotation support body 901. The second rotational motion slider 830A of the third unit 830 may include an opening 831 provided corresponding to the second hook 914. The second hook 914 may be inserted into the opening 831. The opening 831 may extend along the movement path of the second rotational motion slider 830A relative to the first rotation support body 901. During the mutual rotational motion between the third unit 830 and the first rotation support body 901, the relative positions between the second hook 914 and the opening 831 may vary. The opening 831 may prevent the second hook 914 and the second rotational motion slider 830A from interfering with each other during the mutual rotational motion between the third unit 830 and the first rotation support body 901.

According to various embodiments, due to the interference between the first hook 913 and one inner surface of the opening 811, the distance by which the first rotational motion slider 810A of the first unit 810 moves in the direction in which it is pulled out from the first rotation support body 901 is limited, and the connection between the first unit 810 and the first rotation support body 901 may be maintained. Due to the interference between the second hook 914 and one inner surface of the opening 831, the distance by which the second rotational motion slider 830A of the third unit 830 moves in the direction in which it is pulled out from the first rotation support body 901 is limited, and the connection between the third unit 830 and the first rotation support body 901 may be maintained.

According to various embodiments, instead of the first rotational motion guide for the mutual rotational motion between the first rotation support body 901 and the first unit 810, the first unit 810 may be configured to be rotationally movable with respect to the first rotation support body 901 via a shaft or a pin. Instead of the second rotational motion guide for the mutual rotational motion between the first rotation support body 901 and the third unit 830, the third unit 830 may be configured to be rotationally movable with respect to the first rotation support body 901 via a shaft or a pin.

According to an embodiment, the second rotation support body 902 may be connected to the second unit 820 and the fourth unit 840. The second unit 820 may include a first shaft connector (or a first shaft connection arm or a first shaft arm) 821 and a second shaft connector (or a second shaft connection arm or a second shaft arm) 822. The first shaft connector 821 and the second shaft connector 822 may be spaced apart from each other in the direction of the second rotation axis C2 (e.g., the y-axis direction). The first shaft connector 821 and the second shaft connector 822 may be connected to the second rotation support body 902 and may be rotated about the second rotation axis C2. The fourth unit 840 may include a third shaft connector (or a third shaft connection arm or a third shaft arm) 841 and a fourth shaft connector (or a fourth shaft connection arm or a fourth shaft arm) 842. The third shaft connector 841 and the fourth shaft connector 842 may be spaced apart from each other in the direction of the fourth rotation axis C4 (e.g., the y-axis direction). The third shaft connector 841 and the fourth shaft connector 842 may be connected to the second rotation support body 902 and may be rotated about the fourth rotation axis C4.

According to an embodiment, the second rotation support body 902 may include a first shaft 930, a second shaft 940, a third shaft 950, a fourth shaft 960, a gear bracket 970, a cam (or a cam gear) 980, and/or a plurality of springs 990.

According to an embodiment, the first shaft 930 may be connected to the first shaft connector 821 and the second shaft connector 822 of the second unit 820. The first shaft 930 may be positioned through a shaft hole provided in the first shaft connector 821 and a shaft hole provided in the second shaft connector 822. The second rotation axis C2 of the second unit 820 may be the center axis of the first shaft 930. The first shaft connector 821 and the second shaft connector 822 may be fixed to the first shaft 930, and the second unit 820 may be rotated about the second rotation axis C2 together with the first shaft 930.

According to an embodiment, the second shaft 940 may be connected to the third shaft connector 841 and the fourth shaft connector 842 of the fourth unit 840. The second shaft 940 may be positioned through a shaft hole provided in the third shaft connector 841 and a shaft hole provided in the fourth shaft connector 842. The fourth rotation axis C4 of the fourth unit 840 may be the center axis of the second shaft 940. The third shaft connector 841 and the fourth shaft connector 842 may be fixed to the second shaft 940, and the fourth unit 840 may be rotated about the fourth rotation axis C4 together with the second shaft 940.

According to an embodiment, the first shaft 930 and the second shaft 940 may be rotatably disposed in the gear bracket 970. The gear bracket 970 may stably support the rotation of the first shaft 930 and the second shaft 940. The gear bracket 970 may be coupled with the hinge housing 23 (see FIG. 4). The gear bracket 970 may include, for example, a first shaft support portion 971, a second shaft support portion 972, and/or a connector 973. The first shaft support portion 971 and the second shaft support portion 972 may be spaced apart from each other in the direction of the second rotation axis C2 and the fourth rotation axis C4 (e.g., the y-axis direction), and the connector 973 may be a part connecting the first shaft support portion 971 and the second shaft support portion 972 of the gear bracket 970. The first shaft 930 may be positioned through a first shaft hole 971a provided in the first shaft support portion 971 and a third shaft hole 972a provided in the second shaft support portion 972. The second shaft 940 may be positioned through second shaft hole 971b provided in the first shaft support portion 971 and a fourth shaft hole 972b provided in the second shaft support portion 972. The connector 973 may be coupled to the hinge housing 23 through screw fastening. For the screw fastening, the connector 973 may include screw holes 973a and 973b spaced apart from each other in the direction of the centerline A (e.g., the y-axis direction) in the central portion corresponding to the centerline A of the electronic device 2 (see FIG. 2), and the hinge housing 23 may include screw fastening portions (e.g., bosses) aligned in a one-to-one correspondence with the screw holes 973a and 973b. The gear bracket 970 may be provided in a substantially symmetrical shape with respect to the centerline A of the electronic device 2 (see FIG. 2).

According to an embodiment, the first shaft 930 may include a first circular gear 931 positioned between the first rotation support body 901 and the first shaft support portion 971 of the gear bracket 970. The second shaft 940 may include a second circular gear 941 positioned between the first rotation support body 901 and the first shaft support portion 971 of the gear bracket 971. The first shaft 930 and the second shaft 940 may have substantially the same shape. The rotation support bracket 910 of the first rotation support body 901 may include a first seating portion (or a first shaft seating portion) 917a and a second seating portion (or a second shaft seating portion) 917b. The first seating portion 917a and the second seating portion 917b may be provided in a recessed shape. One end portion of the first shaft 930 may be positioned in (or inserted into) the first seating portion 917a. One end portion of the second shaft 940 may be positioned in (or inserted into) the second seating portion 917b. One end portion of the first shaft 930 positioned in the first seating portion 917a between the rotation support bracket 910 and the bracket cover 920 may be rotatably supported by the first rotation support body 901. The first seating portion 917a between the rotation support bracket 910 and the bracket cover 920, the first shaft hole 971a of the gear bracket 970, and the third shaft hole 972a of the gear bracket 970 may support the first shaft 930 to be rotatable about the second rotation axis C2. One end portion of the second shaft 940 positioned in the second seating portion 917b between the rotation support bracket 910 and the bracket cover 920 may be rotatably supported by the first rotation support body 901. The second seating portion 917b between the rotation support bracket 910 and the bracket cover 920, the second shaft hole 971a of the gear bracket 970, and the fourth shaft hole 972a of the gear bracket 970 may support the second shaft 940 to be rotatable about the fourth rotation axis C4.

According to an embodiment, one end portion of the third shaft 950 may be rotatably disposed in a third seating portion (or a third shaft seating portion) 917c provided in the rotation support bracket 910 of the first rotation support body 901, and the other end portion of the third shaft 950 may be rotatably disposed in a fifth shaft hole 971c provided in the first shaft support portion 971 of the gear bracket 970. One end portion of the third shaft 950 positioned in the third seating portion 917c between the rotation support bracket 910 and the bracket cover 920 may be rotatably supported by the first rotation support body 901. The third seating portion 917c between the rotation support bracket 910 and the bracket cover 920, and the fifth shaft hole 971c of the gear bracket 970 may support the third shaft 950 to be rotatable about the fifth rotation axis. One end portion of the fourth shaft 960 may be rotatably disposed in a fourth seating portion (or a fourth shaft seating portion) 917d provided in the rotation support bracket 910 of the first rotation support body 901, and the other end portion of the fourth shaft 960 may be rotatably disposed in a sixth shaft hole 971d provided in the first shaft support portion 971 of the gear bracket 970. One end portion of the fourth shaft 960 positioned in the fourth seating portion 917d between the rotation support bracket 910 and the bracket cover 920 may be rotatably supported by the first rotation support body 901. The fourth seating portion 917d between the rotation support bracket 910 and the bracket cover 920, and the sixth shaft hole 971d of the gear bracket 970 may support the fourth shaft 960 to be rotatable about the sixth rotation axis. The fifth rotation axis of the third shaft 950 and the sixth rotation axis of the fourth shaft 960 may be parallel to the second rotation axis C2 of the first shaft 930 and the fourth rotation axis C4 of the second shaft 940.

According to an embodiment, the third shaft 950 may include a third circular gear 951. The third circular gear 951 may be positioned between the first rotation support body 901 and the first shaft support portion 971 of the gear bracket 970. The fourth shaft 960 may include a fourth circular gear 961. The fourth circular gear 961 may be positioned between the first rotation support body 901 and the first shaft support portion 971 of the gear bracket 970. The third shaft 950 and the fourth shaft 960 may have substantially the same shape. The third circular gear 951 may be engaged with the first circular gear 931 of the first shaft 930. The fourth circular gear 961 may be engaged with the second circular gear 941 of the second shaft 940. The third circular gear 951 and the fourth circular gear 961 may be engaged with each other. The first circular gear 931, the second circular gear 941, the third circular gear 951, and the fourth circular gear 961 may be, for example, spur gears. When the second unit 820 is rotated about the rotation axis (e.g., the second rotation axis C2) of the first shaft 930, the first circular gear 931 of the first shaft 930 may be rotated in the same direction as the second unit 820. When the fourth unit 840 is rotated about the rotation axis (e.g., the fourth rotation axis C4) of the second shaft 940, the second circular gear 941 of the second shaft 940 may be rotated in the same direction as the fourth unit 840. When the first circular gear 931 is rotated in a first direction and the second circular gear 941 is rotated in a second direction opposite to the first direction, the third circular gear 951 and the fourth circular gear 961 may contribute to the transmission of force (e.g., rotational force) and the balance of force between the first circular gear 931 and the second circular gear 941.

Referring to FIG. 16, the second rotation axis C2 of the first circular gear 931 and the fourth rotation axis C4 of the second circular gear 941 may be positioned substantially symmetrically with respect to the centerline A of the electronic device 2 (see FIG. 2). The first circular gear 931 and the second circular gear 941 may have substantially the same shape. The first circular gear 931 and the second circular gear 941 may have, for example, the same number of teeth. The fifth rotation axis C5 of the third circular gear 951 and the sixth rotation axis C6 of the fourth circular gear 961 may be positioned substantially symmetrically with respect to the centerline A of the electronic device 2 (see FIG. 2). The third circular gear 951 and the fourth circular gear 961 may have substantially the same shape. The third circular gear 951 and the fourth circular gear 961 may have, for example, the same number of teeth.

According to an embodiment, the third circular gear 951 and the fourth circular gear 961 may have substantially the same shape as the first circular gear 931 and the second circular gear 941. The first circular gear 931, the second circular gear 941, the third circular gear 951, and the fourth circular gear 961 may have, for example, the same number of teeth.

According to various embodiments, the third circular gear 951 and the fourth circular gear 961 may have a different size from the first circular gear 931 and the second circular gear 941. The third circular gear 951 and the fourth circular gear 961, for example, may be smaller than the first circular gear 931 and the second circular gear 941, and may have fewer teeth than the first circular gear 931 and the second circular gear 941. As another example, the third circular gear 951 and the fourth circular gear 961 may be larger than the first circular gear 931 and the second circular gear 941, and may have more teeth than the first circular gear 931 and the second circular gear 941.

According to an embodiment, a phantom first straight line 1601 passing through the second rotation axis C2 of the first circular gear 931 and the fourth rotation axis C4 of the second circular gear 941 may be spaced apart from and substantially parallel to a phantom second straight line 1602 passing through the fifth rotation axis C5 of the third circular gear 951 and the sixth rotation axis C6 of the fourth circular gear 961. The second straight line 1602 may be located closer to the hinge housing 23 (see FIG. 4) than the first straight line 1601. In various embodiments, the first circular gear 931, the second circular gear 941, the third circular gear 951, and the fourth circular gear 961 may be positioned such that the first straight line 1601 and the second straight line 1602 are substantially aligned.

According to an embodiment, the first circular gear 931, the second circular gear 941, the third circular gear 951, and the fourth circular gear 961 may be substantially concealed by the bracket cover 920 of the first rotation support body 901, thereby rendering the gears substantially invisible.

According to various embodiments, the bracket cover 920 may include an opening where a portion of the first circular gear 931 is positioned (or inserted) and an opening where a portion of the second circular gear 941 is positioned (or inserted). The openings of the bracket cover 920 may prevent the bracket cover 920 from interfering with the first circular gear 931 and the second circular gear 941. The openings of the bracket cover 920 may contribute to slimming the first hinge module 5A.

According to various embodiments, some of the teeth included in the first circular gear 931, which are not engaged with the third circular gear 951 in response to state change of the electronic device 2 (e.g., switching between the unfolded state in FIG. 2 and the folded state in FIG. 3), may be omitted. Some of the teeth included in the second circular gear 941, which are not engaged with the fourth circular gear 961 in response to state change of the electronic device 2, may be omitted.

According to an embodiment, the cam 980 may include a first cam (or a first cam gear) 981 corresponding to the first shaft connector 821 of the second unit 820, and a second cam (or a second cam gear) 982 corresponding to the second shaft connector 822 of the second unit 820. The first cam 981 and the second cam 982 may include shaft holes through which the first shaft 930 is positioned, and may be positioned between the first shaft connector 821 and the second shaft connector 822. The first cam 981 may include a first tooth surface with a concave-convex shape facing the first shaft connector 821, and the first shaft connector 821 may include a second tooth surface 821a with a concave-convex shape facing the first tooth surface. The second cam 982 may include a third tooth surface with a concave-convex shape facing the second shaft connector 822, and the second shaft connector 822 may include a fourth tooth surface 822a with a concave-convex shape facing the third tooth surface.

According to an embodiment, the cam 980 may include a third cam (or a third cam gear) 983 corresponding to the third shaft connector 841 of the fourth unit 840, and a fourth cam (or a fourth cam gear) 945 corresponding to the fourth shaft connector 842 of the fourth unit 840. The third cam 983 and the fourth cam 984 may include shaft holes through which the second shaft 940 is positioned, and may be positioned between the third shaft connector 841 and the fourth shaft connector 842. The third cam 983 may include a fifth tooth surface with a concave-convex shape facing the third shaft connector 841, and the third shaft connector 841 may include a sixth tooth surface 841a with a concave-convex shape facing the fifth tooth surface. The fourth cam 984 may include a seventh tooth surface with a concave-convex shape facing the fourth shaft connector 842, and the fourth shaft connector 842 may include an eighth tooth surface 842a with a concave-convex shape facing the seventh tooth surface.

According to an embodiment, the cam 980 may include a first cam structure (or a first cam part) that includes the first cam 981 and the third cam 983, and a second cam structure (or a second cam part) that includes the second cam 982 and the fourth cam 984. The first shaft 930 and the second shaft 940 may be positioned through the first cam structure and the second cam structure. A plurality of springs (e.g., compression springs) 990 may be positioned between the first cam structure and the second cam structure. The cam 980 may include a connection structure (or a connection part) that connects the first cam structure and the second cam structure. The connection structure may enable a relative positional change between the first cam structure and the second cam structure in the direction of the centerline A of the electronic device 2 while connecting the first cam structure and the second cam structure. The plurality of springs 990 may be supported by the connection structure between the first cam structure and the second cam structure to be stably positioned on the first and second cam structures. Due to the plurality of springs 990, the first cam 981 may elastically press the first shaft connector 821 of the second unit 820, and the second cam 982 may elastically press the second shaft connector 822 of the second unit 820. Due to the plurality of springs 990, the third cam 983 may elastically press the third shaft connector 841 of the fourth unit 840, and the fourth cam 984 may elastically press the fourth shaft connector 842 of the fourth unit 840.

According to an embodiment, the plurality of springs 990 may include a first spring, a second spring, a third spring, and/or a fourth spring. The first shaft 930 may be positioned through the first spring. The second shaft 940 may be positioned through the second spring. The third spring and the fourth spring may be positioned between the first spring and the second spring.

According to an embodiment, the actuator 900 may be configured to provide force to allow the second unit 820 and the fourth unit 840 to rotate relative to each other. The actuator 900 may have a function that allows the second unit 820 and the fourth unit 840 to rotate at the same angle but in opposite directions. The actuator 900 may have a function (e.g., a free-stop function) that allows the second unit 820 and the fourth unit 840 to be rotated and maintained at at least one predetermined angle. The above-described functions of the actuator 900 may be provided through the interaction between the plurality of circular gears 931, 941, 951, and 961, the interaction between the first tooth surface of the first cam 981 and the second tooth surface 821a of the first shaft connector 821 using the elasticity of the plurality of springs 990, the interaction between the third tooth surface of the second cam 982 and the fourth tooth surface 822a of the second shaft connector 822 using the elasticity of the plurality of springs 990, the interaction between the fifth tooth surface of the third cam 983 and the sixth tooth surface 841a of the third shaft connector 841 using the elasticity of the plurality of springs 990, and the interaction between the seventh tooth surface of the fourth cam 984 and the eighth tooth surface 842a of the fourth shaft connector 842 using the elasticity of the plurality of springs 990. Since the first unit 810 and the second unit 820 are slidably connected to the first bracket 51A fixed to the first frame 211 (see FIG. 4) and the third unit 830 and the fourth unit 840 are slidably connected to the second bracket 52A fixed to the second frame 221 (see FIG. 4), the above-described functions of the actuator 900 may be substantially provided for the mutual rotational motion between the first frame 211 and the second frame 221.

According to an embodiment, when viewed in the direction of the first rotation axis C1 of the first unit 810 (e.g., the y-axis direction), the first unit 810 and the first bracket 51A may be connected to be mutually slidable in a first linear direction LD1. When viewed in the direction of the second rotation axis C2 of the second unit 820 (e.g., the y-axis direction), the second unit 820 and the first bracket 51A may be connected to be mutually slidable in a second linear direction LD2 different from the first linear direction LD1.

According to an embodiment, when viewed in the direction of the third rotation axis C3 of the third unit 830 (e.g., the y-axis direction), the third unit 830 and the second bracket 52A may be connected to be mutually slidable in a third linear direction LD3. When viewed in the direction of the fourth rotation axis C4 of the fourth unit 840 (e.g., the y-axis direction), the fourth unit 840 and the second bracket 52A may be connected to be mutually slidable in a fourth linear direction LD4 different from the third linear direction LD3. The first linear direction LD1 in which the first unit 810 slides relative to the first bracket 51A and the third linear direction LD3 in which the third unit 830 slides relative to the second bracket 52A may be provided substantially symmetrically with respect to the centerline A of the electronic device 2 (see FIG. 2). The second linear direction LD2 in which the second unit 820 slides relative to the first bracket 51A and the fourth linear direction LD4 in which the fourth unit 840 slides relative to the second bracket 52A may be provided substantially symmetrically with respect to the centerline A of the electronic device 2 (see FIG. 2). Due to the combination of the first rotation axis C1, the second rotation axis C2, the third rotation axis C3, and the fourth rotation axis C4, when the angle between the first frame 211 (see FIG. 4) and the second frame 221 (see FIG. 4) changes, the first unit 810 and the second unit 820 may move linearly relative to the first bracket 51A while rotating relative to the actuator 900, and the third unit 830 and the fourth unit 840 may move linearly relative to the second bracket 52A while rotating relative to the actuator 900.

According to an embodiment, the first linear direction LD1 in which the first bracket 51A and the first unit 810 are slid relative to each other may be provided such that, when the first unit 810 rotates about the first rotation axis C1 as the angle between the first frame 211 (see FIG. 4) and the second frame 221 (see FIG. 4) changes, the first bracket 51A and the first unit 810 are smoothly slidable relative to each other while reducing mutual interference (e.g., frictional resistance). The frictional resistance may be, for example, the force that resists motion between contact surfaces when two objects are slid relative to each other. The third linear direction LD3 in which the second bracket 52A and the third unit 830 are slid relative to each other may be provided such that, when the third unit 830 rotates about the third rotation axis C3 as the angle between the first frame 211 (see FIG. 4) and the second frame 221 (see FIG. 4) changes, the second bracket 52A and the third unit 830 are smoothly slidable relative to each other while reducing mutual interference (e.g., frictional resistance).

According to an embodiment, the second linear direction LD2 in which the first bracket 51A and the second unit 820 are slid relative to each other may be provided such that, when the second unit 820 rotates about the second rotation axis C2 as the angle between the first frame 211 (see FIG. 4) and the second frame 221 (see FIG. 4) changes, the first bracket 51A and the second unit 820 are smoothly slidable relative to each other while reducing mutual interference (e.g., frictional resistance). The fourth linear direction LD4 in which the second bracket 52A and the fourth unit 840 are slid relative to each other may be provided such that, when the fourth unit 840 rotates about the fourth rotation axis C4 as the angle between the first frame 211 (see FIG. 4) and the second frame 221 (see FIG. 4) changes, the second bracket 52A and the fourth unit 840 are smoothly slidable relative to each other while reducing mutual interference (e.g., frictional resistance).

According to an embodiment, the first hinge module 5A may include a first linear motion guide (e.g., the first linear motion guide LMG1 in FIG. 6) so that the first unit 810 and the first bracket 51A are mutually slidable (e.g., mutually linearly movable) in the first linear direction LD1. Through the first linear motion guide, the first unit 810 and the first bracket 51A may be slid smoothly and seamlessly relative to each other in the first linear direction LD1. The first hinge module 5A may include a third linear motion guide (e.g., the third linear motion guide LMG3 in FIG. 6) so that the third unit 830 and the second bracket 52A are mutually slidable (e.g., mutually linearly movable) in the third linear direction LD3. Through the third linear motion guide, the third unit 830 and the second bracket 52A may be slid smoothly and seamlessly relative to each other in the third linear direction LD3.

According to an embodiment, the first linear motion guide (e.g., the first linear motion guide LMG1 in FIG. 6) for relative linear motion between the first unit 810 and the first bracket 51A may include a first linear motion guide rail 1001 included in the first bracket 51A, and a first linear motion slider 810B included in the first unit 810 corresponding to the first linear motion guide rail 1001. The first unit 810 may be provided as an integrated form including the first rotational motion slider 810A and the first linear motion slider 810B. The first linear motion slider 810B may be positioned on the first linear motion guide rail 1001. By the first linear motion slider 810B being guided and moved by the first linear motion guide rail 1001, the first unit 810 may be movable in the first linear direction LD1 relative to the first bracket 51A. The third linear motion guide for relative linear motion between the third unit 830 and the second bracket 52A may include a third linear motion guide rail 1101 included in the second bracket 52A and a third linear motion slider 830B included in the third unit 830 corresponding to the third linear motion guide rail 1101. The third unit 830 may be provided as an integrated form including the second rotational motion slider 830A and the third linear motion slider 830B. The third linear motion slider 830B may be positioned on the third linear motion guide rail 1101. By the third linear motion slider 830B being guided and moved by the third linear motion guide rail 1101, the third unit 830 may be movable in the third linear direction LD3 relative to the second bracket 52A.

According to an embodiment, the first linear motion guide (e.g., the first linear motion guide LMG1 in FIG. 6) including the first linear motion slider 810B and the first linear motion guide rail 1001 may enable linear motion of the first unit 810 relative to the first bracket 51A fixed to the first frame 211 (see FIG. 4), but may make rotational motion of the first unit 810 relative to the first bracket 51A substantially difficult. The third linear motion guide (e.g., the third linear motion guide LMG3 in FIG. 6) including the third linear motion slider 830B and the third linear motion guide rail 1101 may enable linear motion of the third unit 830 relative to the second bracket 52A fixed to the second frame 221 (see FIG. 4), but may make rotational motion of the third unit 830 relative to the second bracket 52A substantially difficult. The first linear motion guide and the third linear motion guide may be provided substantially symmetrically with respect to the centerline A of the electronic device 2 (see FIG. 2).

According to an embodiment, the first linear motion guide rail 1001 of the first bracket 51A may include a first opening 1001A. The first linear motion slider 810B of the first unit 810 may be positioned in the first opening 1001A. Depending on the position where the first unit 810 and the first bracket 51A are slid relative to each other in the first linear direction LD1, the extent to which the first linear motion slider 810B is inserted into the first opening 1001A may vary. The first linear motion slider 810B may be provided in a form that is fitted into the first opening 1001A. Due to the combination of the first linear motion slider 810B and the first opening 1001A, the first unit 810 and the first bracket 51A may be stably slid relative to each other in the first linear direction LD1. The combination of the first linear motion slider 810B and the first opening 1001A may enable mutual linear motion between the first unit 810 and the first bracket 51A, but may make rotational motion between the first unit 810 and the first bracket 51A substantially difficult.

According to an embodiment, the first linear motion slider 810B of the first unit 810 may include a plurality of first recesses R11, R12, R13, and R14. The first linear motion guide rail 1001 of the first bracket 51A may include a plurality of first inserts I11, I12, I13, and I14 positioned (or inserted) in a one-to-one correspondence with the plurality of first recesses R11, R12, R13, and R14. The plurality of first recesses R11, R12, R13, and R14 may provide a path extended in the first linear direction LD1 along which the first unit 810 and the first bracket 51A are slidable relative to each other when viewed in the direction of the first rotation axis C1 of the first unit 810 (e.g., the y-axis direction). The plurality of first inserts I11, I12, I13, and I14 may be provided in the form extended in the first linear direction LD1 along which the first unit 810 and the first bracket 51A are slidable relative to each other when viewed in the direction of the first rotation axis C1 of the first unit 810 (e.g., the y-axis direction). When the angle between the first frame 211 (see FIG. 4) to which the first bracket 51A is fixed and the second frame 221 (see FIG. 4) to which the second bracket 52A is fixed changes, the plurality of first inserts I11, I12, I13, and I14 and the plurality of first recesses R11, R12, R13, and R14 may guide each other in the first linear direction LD1, and the relative positions between the plurality of first inserts I11, I12, I13, and I14 and the plurality of first recesses R11, R12, R13, and R14 may vary. The first linear motion slider 810B and the first linear motion guide rail 1001 of the first bracket 51A may be connected to be stably and mutually slidable in the first linear direction LD1 due to the combination (e.g., sliding pair) of the plurality of first recesses R11, R12, R13, and R14 and the plurality of first inserts I11, I12, I13, and I14. The combination of the plurality of first recesses R11, R12, R13, and R14 and the plurality of first inserts I11, I12, I13, and I14 may enable mutual linear motion between the first unit 810 and the first bracket 51A, but may make rotational motion between the first unit 810 and the first bracket 51A substantially difficult. In some embodiments, the first linear motion guide rail 1001 of the first bracket 51A may include at least one recess, and the first linear motion slider 810B of the first unit 810 may include at least one insert positioned (or inserted) corresponding to the at least one recess.

According to an embodiment, the third linear motion guide (e.g., the third linear motion guide LMG3 in FIG. 6) including the third linear motion slider 830B of the third unit 830 and the third linear motion guide rail 1101 of the second bracket 52A may be provided substantially symmetrically to the first linear motion guide (e.g., the first linear motion guide LMG1 in FIG. 6) including the first linear motion slider 810B of the first unit 810 and the first linear motion guide rail 1001 of the first bracket 51A, with respect to the centerline A of the electronic device 2 (see FIG. 2). The third linear motion guide may include, for example, the third linear motion slider 830B included in the third unit 830 and the third linear motion guide rail 1101 included in the second bracket 52A. The third linear motion guide rail 1101 may include a second opening 1101A, and the third linear motion slider 830B may be positioned in the second opening 1101A. The third linear motion slider 830B may include a plurality of second recesses R31, R32, R33, and R34. The third linear motion guide rail 1101 may include a plurality of second inserts I31, I32, I33, and I34 positioned (or inserted) in a one-to-one correspondence with the plurality of second recesses R31, R32, R33, and R34.

According to an embodiment, a second linear motion guide (e.g., the second linear motion guide LMG2 in FIG. 6) that enables the second unit 820 and the first bracket 51A to move linearly relative to each other in the second linear direction LD2 may include a pair of second linear motion sliders 820A and 820B included in the second unit 820 and a second linear motion guide rail 1002 included in the first bracket 51A. The second unit 820 may be provided in an integrated form including the first shaft connector 821, the second shaft connector 822, and the pair of second linear motion sliders 820A and 820B. The pair of second linear motion sliders 820A and 820B and the second linear motion guide rail 1002 may be connected to be slidable relative to each other in the second linear direction LD2. The second linear motion guide including the pair of second linear motion sliders 820A and 820B and the second linear motion guide rail 1002 enables linear motion of the second unit 820 relative to the first bracket 51A fixed to the first frame 211 (see FIG. 4), but may make rotational motion of the second unit 820 relative to the first bracket 51A substantially difficult.

According to an embodiment, the first bracket 51A may include a fifth unit 1010 including the first linear motion guide rail 1001, and a sixth unit 1020 coupled with the fifth unit 1010. The fifth unit 1010 may include a support portion 1011 extending from the first linear motion guide rail 1001 corresponding to the second unit 820. The second linear motion guide rail 1002 of the first bracket 51A may be provided as a combination of the support portion 1011 of the fifth unit 1010 and the sixth unit 1020. The support portion 1011 of the fifth unit 1010 may be coupled to the sixth unit 1020 through screw fastening.

According to an embodiment, the support portion 1011 of the fifth unit 1010 may be coupled to the first support portion 411 of the first frame 211 (see FIG. 4) through screw fastening. For screw fastening, the support portion 1011 of the fifth unit 1010 may include screw holes 1012 and 1013, and the first support portion 411 of the first frame 211 (see FIG. 4) may include screw fastening portions (e.g., bosses) aligned in a one-to-one correspondence with the screw holes 1012 and 1013.

According to an embodiment, the sixth unit 1020 may be at least partially positioned between the support portion 1011 of the fifth unit 1010 and the first support portion 411 of the first frame 211 (see FIG. 4). The sixth unit 1020 may be coupled to the support portion 1011 of the fifth unit 1010 through screw fastening. For screw fastening, the support portion 1011 of the fifth unit 1010 may include a screw hole 1014, and the sixth unit 1020 may include a screw fastening portion 1024 aligned with the screw hole 1014. The support portion 1011 of the fifth unit 1010 and the sixth unit 1020 may be coupled to the first support portion 411 of the first frame 211 (see FIG. 4) through screw fastening. For screw fastening, the support portion 411 of the fifth unit 1010 (see FIG. 4) may include screw holes 1015 and 1016, and the sixth unit 1020 may include screw holes 1025 and 1026 aligned in a one-to-one correspondence with the screw holes 1015 and 1016. The first support portion 411 of the first frame 211 (see FIG. 4) may include screw fastening portions aligned in a one-to-one correspondence with the screw holes 1025 and 1026 of the sixth unit 1020.

According to an embodiment, the pair of second linear motion sliders 820A and 820B of the second unit 820 may be inserted between the support portion 1011 of the fifth unit 1010 and the sixth unit 1020. Due to the combination of the support portion 1011 of the fifth unit 1010 and the sixth unit 1020, the space provided between the support portion 1011 of the fifth unit 1010 and the sixth unit 1020 may be configured to guide the movement of the pair of second linear motion sliders 820A and 820B with respect to the first bracket 51A. Depending on the position where the second unit 820 and the first bracket 51A are slid relative to each other in the second linear direction LD2, the extent to which the pair of second linear motion sliders 820A and 820B are inserted into the space between the support portion 1011 of the fifth unit 1010 and the sixth unit 1020 may vary. The second unit 820 and the first bracket 51A may be configured to be stably slidable relative to each other in the second linear direction LD2 due to the combination of the pair of second linear motion sliders 820A and 820B, the support portion 1011 of the fifth unit 1010, and the sixth unit 1020. The combination of the pair of second linear motion sliders 820A and 820B, the support portion 1011 of the fifth unit 1010, and the sixth unit 1020 enables mutual linear motion between the second unit 820 and the first bracket 51A while making rotational motion between the second unit 820 and the first bracket 51A substantially difficult.

According to an embodiment, the space between the support portion 1011 of the fifth unit 1010 and the sixth unit 1020 may provide a path extended in the second linear direction LD2 along which the second unit 820 and the first bracket 51A are slidable relative to each other, when viewed in the direction of the second rotation axis C2 of the second unit 820. When viewed in the direction of the second rotation axis C2 of the second unit 820, the pair of second linear motion sliders 820A and 820B may be extended in the second linear direction LD2, in which the second unit 820 and the first bracket 51A are slidable relative to each other. In an embodiment, the sixth unit 1020 may include a first side 1020a, a second side 1020b, and/or a bottom 1020c. The first side 1020a and the second side 1020b may be spaced apart from each other in the direction of the second rotation axis C2, and the bottom 1020c may be a portion of the sixth unit 1020 that connects the first side 1020a and the second side 1020b. The bottom 1020c may be in the form of a plate and may face the support portion 1011 of the fifth unit 1010. The bottom 1020c may include a screw fastening portion 1024 and screw holes 1025 and 1026. The first side 1020a and the second side 1020b may support the support portion 1011 of the fifth unit 1010 and the bottom 1020c, thereby providing a spacing area between the bottom 1020c and the support portion 1011 of the fifth unit 1010. In an embodiment, the screw fastening portion 1023 may protrude to support the support portion 1011 of the fifth unit 1010 corresponding to the screw hole 1014 included in the support unit 1011 of the fifth unit 1010, and may contribute, together with the first side 1020a and the second side 1020b, to stably positioning the sixth unit 1020 on the fifth unit 1010.

According to an embodiment, the support portion 1011 of the fifth unit 1010 may include a first protrusion P1 and a second protrusion P2 protruding toward the bottom 1020c of the sixth unit 1020. The bottom 1020c of the sixth unit 1020 may include a first hole H1 corresponding to the first protrusion P1 and a second hole H2 corresponding to the second protrusion P2. The end portion of the first protrusion P1 may be fitted into the first hole H1, and the end portion of the second protrusion P2 may be fitted into the second hole H2. One 820A of the second linear motion sliders included in the second unit 820 may include a first slit SL1 through which the first protrusion P1 is positioned. The other 820B of the second linear motion sliders included in the second unit 820 may include a second slit SL2 through which the second protrusion P2 is positioned. The first slit SL1 and the second slit SL2 may extend in the second linear direction LD2, along which the second unit 820 and the first bracket 51A are slidable relative to each other. Depending on the position where the second unit 820 and the first bracket 51A are slid in the second linear direction LD2, the relative position of the first protrusion P1 to the first slit SL1, and the relative position of the second protrusion P2 to the second slit SL2 may vary.

According to an embodiment, due to the interference between one inner surface of the first slit SL1 and the first protrusion P1, and the interference between one inner surface of the second slit SL2 and the second protrusion P2, the distance by which the pair of second linear motion sliders 820A and 820B of the second unit 820 move in the direction of being pulled out from the first bracket 51A may be limited, and the connection between the second unit 820 and the first bracket 51A may be maintained.

According to an embodiment, the fourth linear motion guide (e.g., the fourth linear motion guide LMG4 in FIG. 6) that enables the fourth unit 840 and the second bracket 52A to move linearly relative to each other in the fourth linear direction LD4 may be provided substantially symmetrically to the second linear motion guide (e.g., the second linear motion guide LMG2 in FIG. 6) that enables the second unit 820 and the first bracket 51A to move linearly relative to each other in the second linear direction LD2, with respect to the centerline A of the electronic device 2 (see FIG. 2). The fourth linear motion guide may include, for example, the pair of fourth linear motion sliders 840A and 840B included in the fourth unit 840 and the fourth linear motion guide rail 1102 included in the second bracket 52A. The second bracket 52A may include a seventh unit 1110 including the second linear motion guide rail 1101, and an eighth unit 1120 coupled with the seventh unit 1110. The seventh unit 1110 may include a support portion 1111 extending from the third linear motion guide rail 1101 corresponding to the fourth unit 840. The fourth linear motion guide rail 1102 of the second bracket 52A may be provided as a combination of the support portion 1111 of the seventh unit 1110 and the eighth unit 1120. The seventh unit 1110 may include a plurality of screw holes 1112, 1113, 1114, 1115, and 1116. The eighth unit 1120 may include a screw fastening portion 1124 and screw holes 1125 and 1126. Each of the pair of fourth linear motion sliders 840A and 840B of the fourth unit 840 may include a third slit SL3 and a fourth slit SL4, and the support portion 1111 of the seventh unit 1110 may include a third protrusion P3 corresponding to the third slit SL3 and a fourth protrusion P4 corresponding to the fourth slit SL4. The eighth unit 1120 may include a third hole H3 corresponding to the third protrusion P3 and a fourth hole H4 corresponding to the fourth protrusion P4.

According to an embodiment, the first plate 61 (see FIG. 4) may be coupled to the first linear motion slider 810B of the first unit 810 through screw fastening. The first linear motion slider 810B may include a first screw fastening portion B11 aligned with the first screw hole SH11 of the first plate 61 (see FIG. 4). The second plate 62 (see FIG. 4) may be coupled to the third linear motion slider 830B of the third unit 830 through screw fastening. The third linear motion slider 830B may include a second screw fastening portion B12 aligned with the second screw hole SH12 of the second plate 62 (see FIG. 4).

According to various embodiments, the first unit 810 may be referred to as a "first rotator", and the third unit 830 may be referred to as a "second rotator". The second unit 820 may be referred to as a "first hinge arm" or a "first arm", and the fourth unit 840 may be referred to as a "second hinge arm" or a "second arm".

According to various embodiments, a lubricant (e.g., grease) may be placed (e.g., applied) between any two components included in the first hinge module 5A to reduce friction, loss of motion transmission, or loss of force transmission between the components. In various embodiments, to reduce friction, loss of motion transmission, or loss of force transmission between components, the surfaces of the components may be provided with a lubricating coating (e.g., a coating using various lubricating materials such as Teflon).

According to various embodiments, the components included in the first hinge module 5A may be made of a material that has rigidity or strength (e.g., metal or engineering plastic) that is not substantially deformed in response to the force acting on the mutual rotational motion between the first housing 21 and the second housing 22.

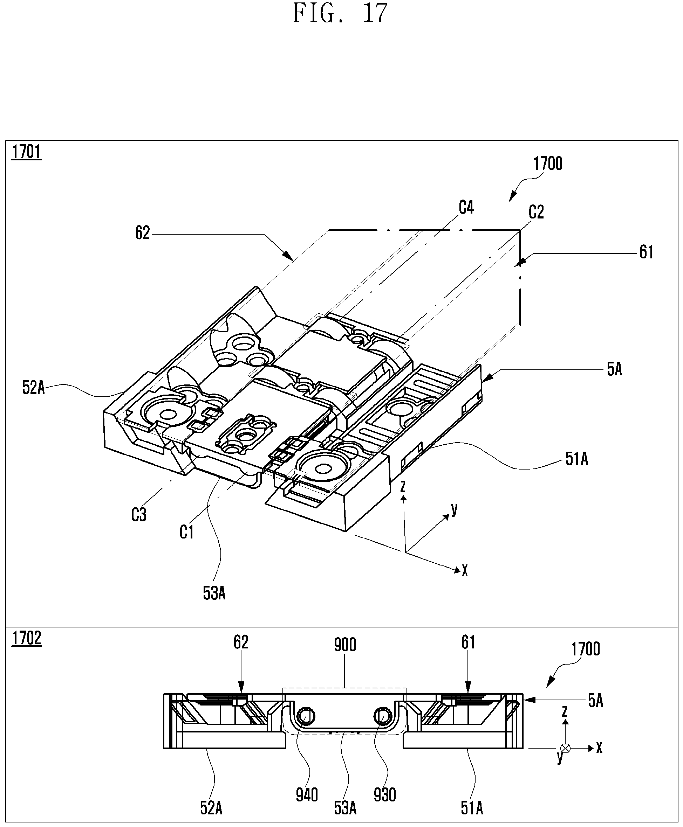

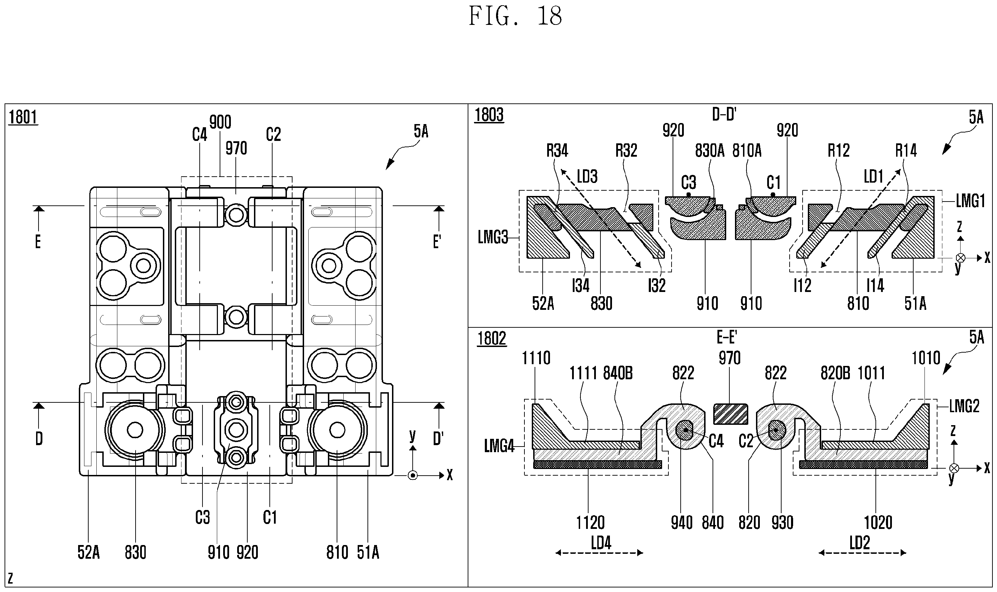

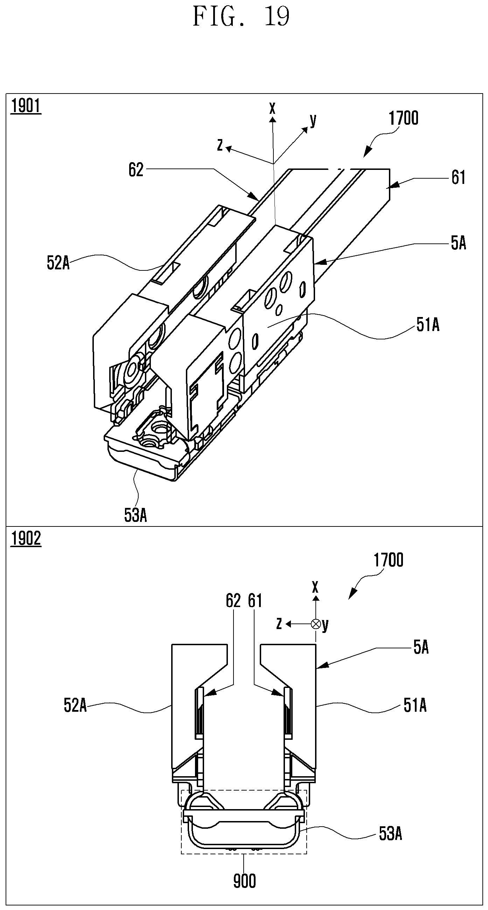

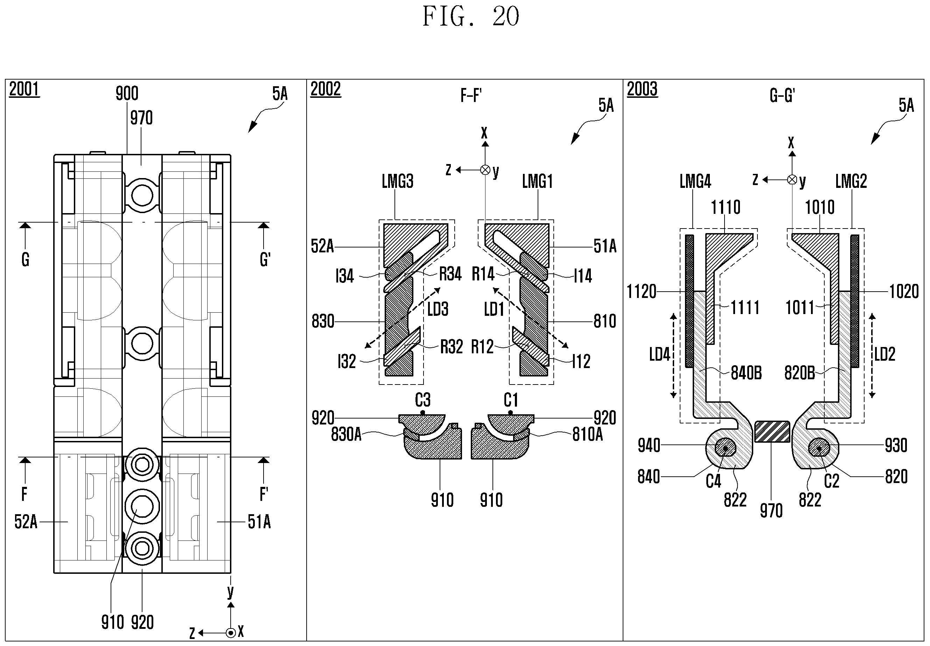

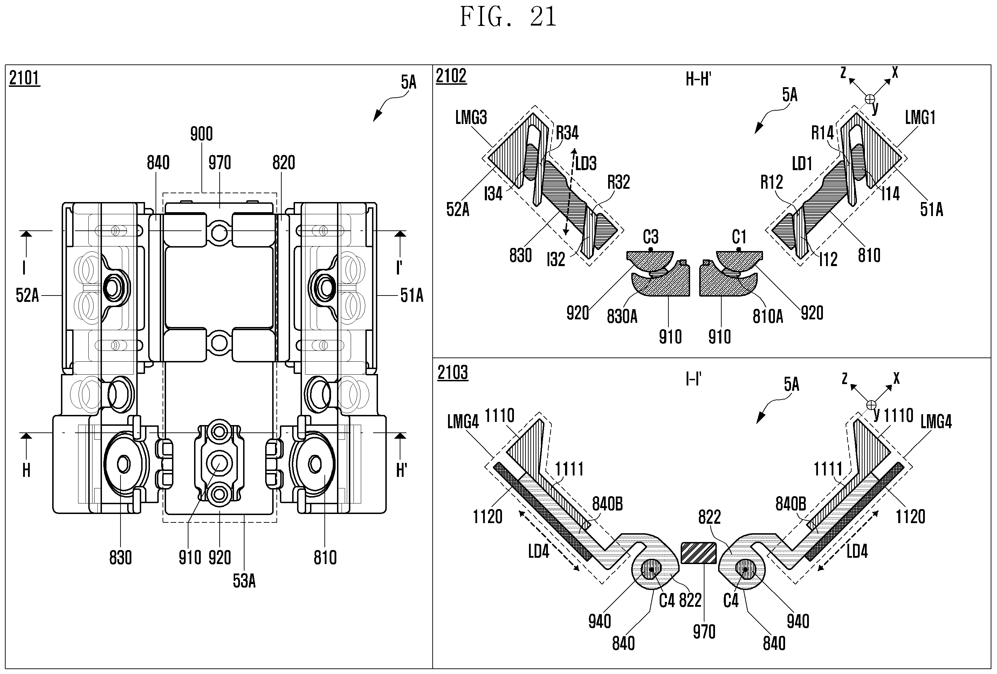

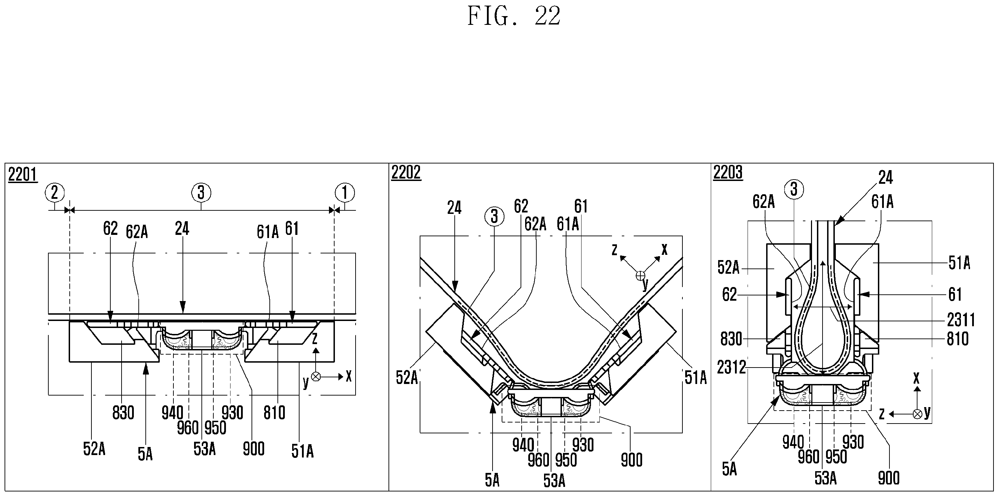

FIG. 17 shows a perspective view of a hinge part 1700 (1701) and a view illustrating the hinge part 1700 (1702) when the electronic device 2 according to an embodiment of the disclosure is in the unfolded state (see FIG. 2). FIG. 18 shows a view illustrating a first hinge module 5A (1801), a cross-sectional view of the first hinge module 5A taken along line D-D' (1802), and a cross-sectional view of the first hinge module 5A taken along line E-E' (1803) when the electronic device 2 according to an embodiment of the disclosure is in the unfolded state (see FIG. 2). FIG. 19 shows a perspective view of the hinge part 1700 (1901) and a view illustrating the hinge part 1700 (1902) when the electronic device 2 according to an embodiment of the disclosure is in the closed state (see FIG. 3). FIG. 20 shows a view illustrating the first hinge module 5A (2001), a cross-sectional view of the first hinge module 5A taken along line F-F' (2002), and a cross-sectional view of the first hinge module 5A taken along line E-E' (2003) when the electronic device 2 according to an embodiment of the disclosure is in the closed state (see FIG. 3). FIG. 21 shows a view illustrating the first hinge module 5A (2101), a cross-sectional view of the first hinge module 5A taken along line H-H' (2102), and a cross-sectional view of the first hinge module 5A taken along line I-I' (2103) when the electronic device 2 according to an embodiment of the disclosure is in the intermediate state. FIG. 22 shows a view illustrating the electronic device 2 in the unfolded state (2201), a view illustrating the electronic device 2 in the intermediate state (2202), and a view illustrating the electronic device 2 in the folded state (2203), according to an embodiment of the disclosure.

Referring to FIGS. 17 to 22, during the switching between the unfolded state and the folded state of the electronic device 2, there may be rotational motion of the first unit 810 about the first rotation axis C1, linear motion between the first unit 810 and the first bracket 51A, rotational motion of the second unit 820 about the second rotation axis C2, and linear motion between the second unit 820 and the first bracket 51A. During the switching between the unfolded state and the folded state of the electronic device 2, there may be rotational motion of the third unit 830 about the third rotation axis C3, linear motion between the third unit 830 and the second bracket 52A, rotational motion of the fourth unit 840 about the fourth rotation axis C4, and linear motion between the fourth unit 840 and the second bracket 52A.

According to an embodiment, when the electronic device 2 is switched from the unfolded state to the folded state, the first rotation axis C1 and the second rotation axis C2 may be positioned further away from the first frame 211 (see FIG. 4) to which the first bracket 51A is fixed compared to the unfolded state of the electronic device 2. When the electronic device 2 is switched from the unfolded state to the folded state, the first unit 810 to which the first plate 61 is fixed may be positioned to be retracted relative to the first bracket 51A in a direction opposite to the direction in which the third display area ③ of the flexible display module 24 is oriented. When the electronic device 2 is switched from the unfolded state to the folded state, the third rotation axis C3 and the fourth rotation axis C4 may be positioned further away from the second frame 221 (see FIG. 4) to which the second bracket 52A is fixed compared to the unfolded state of the electronic device 2. When the electronic device 2 is switched from the unfolded state to the folded state, the third unit 830 to which the second plate 62 is fixed may be positioned to be retracted relative to the second bracket 52A in a direction opposite to the direction in which the third display area ③ of the flexible display module 24 is oriented. When the electronic device 2 is switched from the unfolded state to the folded state, the first surface 61A of the first plate 61 and the second surface 62A of the second plate 62 may be positioned facing each other and spaced apart from each other. When the electronic device 2 is switched from the unfolded state to the folded state, due to the retraction of the first unit 810 relative to the first bracket 51A and the retraction of the third unit 830 relative to the second bracket 52A, the space width in a first direction 2311 (e.g., the first direction 611 in FIG. 6) between the first surface 61A of the first plate 61 and the second surface 62A of the second plate 62 may be provided to allow the third display area ③ to be disposed in a bent shape capable of reducing bending stress and/or buckling. When the electronic device 2 is switched from the unfolded state to the folded state, the first rotation axis C1 and the second rotation axis C2 may move away from the first frame 211 on which the first display area ① is disposed, and the third rotation axis C3 and the fourth rotation axis C4 may move away from the second frame 221 on which the second display area ② is disposed to allow the bracket connector 53A to move away from the structure in which the first frame 211 and the second frame 221 face each other in a second direction 2312 (e.g., the second direction 612 in FIG. 6) that is perpendicular to the first direction 2311. When the electronic device 2 is switched from the unfolded state to the folded state, the actuator 900 may be positioned away from the structure in which the first frame 211 and the second frame 221 may face each other in the second direction 2312 to provide a space width in the second direction 2312 so as to allow the third display area ③ to be disposed in a bent shape capable of reducing bending stress and/or buckling.

According to an embodiment, when the electronic device 2 is switched from the unfolded state to the folded state, the actuator 900 may be positioned away from the structure in which the first frame 211 and the second frame 221 may face each other in the second direction 2312 to allow the hinge housing 23 coupled to the actuator 900 to be exposed outside through the open gap between the first housing 21 and the second housing 22, as illustrated in FIG. 3, while reducing the gap with the first housing 21 and the gap with the second housing 22.

According to an embodiment, when the electronic device 2 is switched from the folded state to the unfolded state, due to the relative position change between the first frame 211 and the second frame 221, and the first hinge module 5A which operates corresponding thereto, the first surface 61A of the first plate 61 and the second surface 62A of the second plate 62 may be positioned to support the third display area ③ of the flexible display module 24.

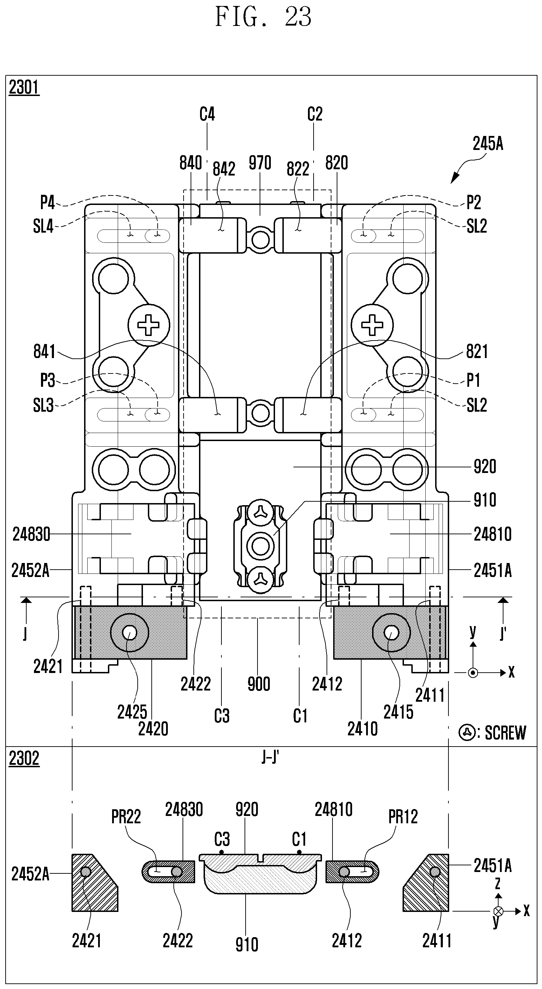

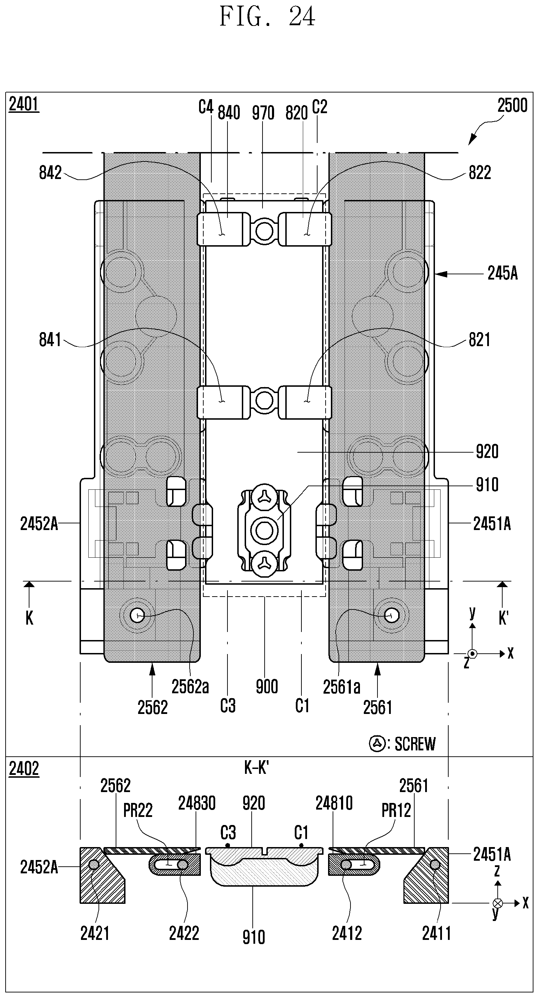

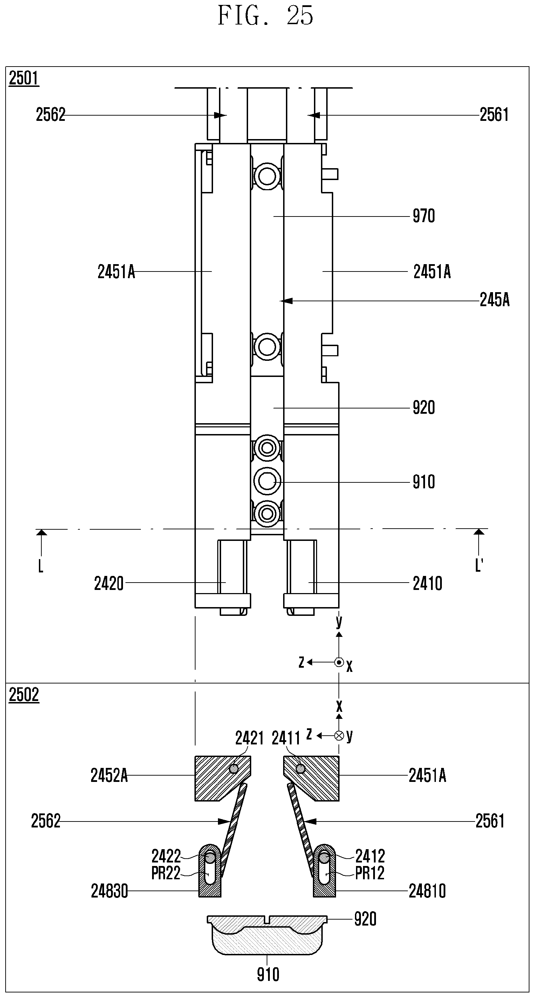

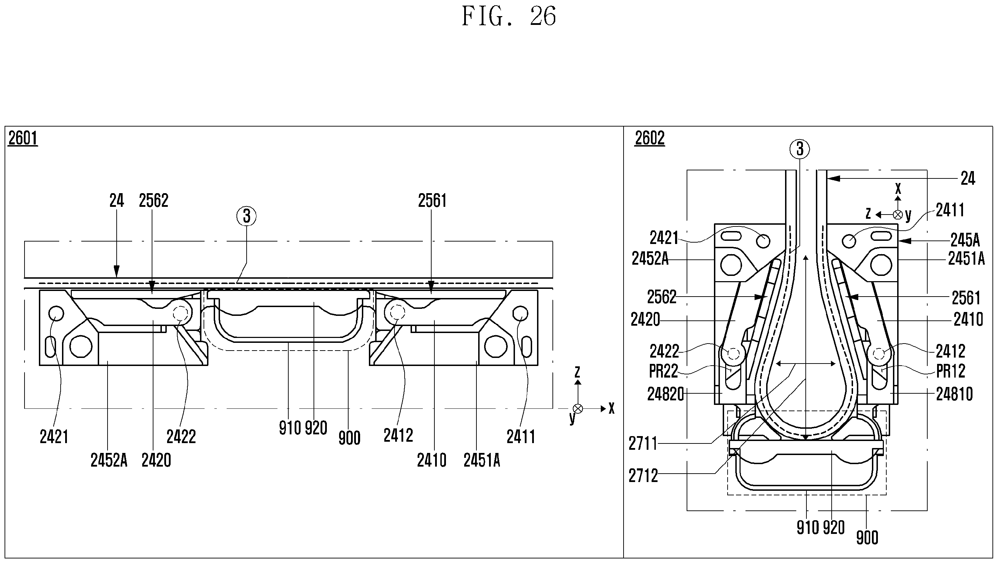

FIG. 23 shows a view illustrating a first hinge module 245A (2301) and a cross-sectional view of the first hinge module 245A taken along line J-J' (2302) when the electronic device 2 according to various embodiments of the disclosure is in the unfolded state (see FIG. 2). FIG. 24 shows a view illustrating a hinge part 2500 (2401) and a cross-sectional view of the hinge part 2500 taken along line K-K' (2402) when the electronic device 2 according to various embodiments of the disclosure is in the unfolded state. FIG. 25 shows a view illustrating the first hinge module 245A (2501) and a cross-sectional view of the first hinge module 245A taken along line L-L' (2502) when the electronic device 2 according to various embodiments of the disclosure is in the folded state (see FIG. 2). FIG. 26 shows a view illustrating the unfolded state of the electronic device 2 (2601) and a view illustrating the folded state of the electronic device 2 (2602), according to various embodiments of the disclosure.

Referring to FIGS. 23 to 26, the first hinge module 245A may include a first unit 24810, a second unit 820, a third unit 24830, a fourth unit 840, an actuator 900, a first bracket 2451A, a second bracket 2452A, a first connector 2410, and/or a second connector 2420. The first hinge module 5A according to the embodiment of FIG. 4 may be replaced with a first hinge module 245A according to the embodiment of FIG. 24. The second hinge module 5B or the third hinge module 5C according to the embodiment of FIG. 4 may be substantially the same as the first hinge module 245A according to the embodiment of FIG. 24. The first hinge module 245A may further include the first connector 2410 and the second connector 2420 compared to the first hinge module 5A according to the embodiment of FIG. 8. The first unit 24810 and the first bracket 2451A of the first hinge module 245A may be modified forms of the first unit 810 and the first bracket 51A according to the embodiment of FIG. 8, corresponding to the first connector 2410. The third unit 24830 and the second bracket 2452A of the first hinge module 245A may be modified forms of the third unit 830 and the third bracket 52A according to the embodiment of FIG. 8, corresponding to the second connector 2420. The first unit 24810 and the third unit 2843 may be provided substantially symmetrically with respect to the centerline A of the electronic device 2 (see FIG. 2). The first bracket 2451A and the second bracket 2452A may be provided substantially symmetrically with respect to the centerline A of the electronic device 2 (see FIG. 2).

According to an embodiment, the first unit 24810 may be connected to the actuator 900 to be rotatable about a first rotation axis C1. The third unit 24830 may be connected to the actuator 900 to be rotatable about a third rotation axis C3. The second unit 820 may be connected to the actuator 900 to be rotatable about a second rotation axis C2. The fourth unit 840 may be connected to the actuator 900 to be rotatable about a fourth rotation axis C4. The first bracket 2451A may be coupled to a first support portion 411 (see FIG. 4) of a first frame 211 through screw fastening. The second bracket 2451B may be coupled to a second support portion 421 (see FIG. 4) of a second frame 221 through screw fastening. The first unit 24810 may be slidably connected to the first bracket 2451A to be linearly movable in a first linear direction with respect to the first bracket 2451A. The second unit 820 may be slidably connected to the first bracket 2451A to be linearly movable in a second linear direction with respect to the first bracket 2451A. The third unit 24830 may be connected to the second bracket 2452A to be linearly movable in a third linear direction with respect to the second bracket 2452A. The fourth unit 840 may be slidably connected to the second bracket 2452A to be linearly movable in a fourth linear direction with respect to the second bracket 2452A.

According to an embodiment, the first connector 2410 may connect the first bracket 2451A and the first unit 24810. The first connector 2410 may include a pinhole, and the first pin 2411 may be positioned through the pinhole. One end portion of the first pin 2411 may be disposed on a first pin support portion provided in the first bracket 2451A, and the other end portion of the first pin 2411 may be disposed on the second pin support portion provided in the first bracket 2451A. The first connector 2410 may be rotatable about the first pin 2411 with respect to the first bracket 2451A. The rotation axis of the first pin 2411 that connects the first connector 2410 and the first bracket 2451A may be substantially parallel to the first rotation axis C1. The first connector 2410 may include a second pin 2412 positioned parallel to and spaced apart from the first pin 2411. The first unit 810 may include a recessed first pin rail PR12 corresponding to the second pin 2412. The second pin 2412 may be inserted into the first pin rail PR12. During the switching between the unfolded state (see FIG. 2) and the folded state (see FIG. 3) of the electronic device 2, the first unit 24810 may move in the first linear direction relative to the first bracket 2451A, and the first connector 24810 may rotate about the first pin 2411 due to the interaction between the second pin 2412 and the first pin rail PR12. During the switching between the unfolded state and the folded state of the electronic device 2, the position of the second pin 2412 relative to the first pin rail PR12 may change corresponding to the linear motion of the first unit 24810 relative to the first bracket 2451A.

According to an embodiment, the second connector 2420 may connect the second bracket 2452A and the second unit 24820. The second connector 2420 may be provided substantially symmetrically to the first connector 2410 with respect to the centerline A of the electronic device 2 (see FIG. 2). The second connector 2420 may include a pinhole, and the third pin 2421 may be positioned through the pinhole. One end portion of the third pin 2421 may be disposed on a third pin support portion provided in the second bracket 2452A, and the other end portion of the third pin 2421 may be disposed on the fourth pin support portion provided in the second bracket 2452A. The second connector 2420 may be rotatable about the third pin 2421 with respect to the second bracket 2452A. The rotation axis of the third pin 2421 that connects the second connector 2420 and the second bracket 2452A may be substantially parallel to the third rotation axis C3. The second connector 2420 may include a fourth pin 2422 positioned parallel to and spaced apart from the third pin 2421. The second unit 820 may include a recessed second pin rail PR22 corresponding to the fourth pin 2422. The fourth pin 2422 may be inserted into the second pin rail PR22. During the switching between the unfolded state (see FIG. 2) and the folded state (see FIG. 3) of the electronic device 2, the third unit 24830 may move in the third linear direction relative to the second bracket 2452A, and the second connector 24820 may rotate about the third pin 2421 due to the interaction between the fourth pin 2422 and the second pin rail PR22. During the switching between the unfolded state and the folded state of the electronic device 2, the position of the fourth pin 2422 relative to the second pin rail PR22 may change depending on the linear motion of the third unit 24830 relative to the second bracket 2452A.

According to an embodiment, the first plate 2561 may be coupled to the first connector 2410 through screw fastening. For screw fastening, the first plate 2561 may include a screw hole 2561a, and the first connector 2410 may include a screw fastening portion 2415 aligned with the screw hole 2561a.

According to an embodiment, the second plate 2562 may be coupled to the second connector 2420 through screw fastening. For screw fastening, the second plate 2562 may include a screw hole 2562a, and the second connector 2420 may include a screw fastening portion 2425 aligned with the screw hole 2562a.

According to an embodiment, during the switching between the unfolded state (see FIG. 2) and the folded state (see FIG. 3) of the electronic device 2, there may be rotational motion of the first unit 24810 about the first rotation axis C1, linear motion between the first unit 24810 and the first bracket 2451A, rotational motion of the second unit 820 about the second rotation axis C2, linear motion between the second unit 820 and the first bracket 2451A, and motion of the first connector 2410 connecting the first unit 24810 and the first bracket 2451A. During the switching between the unfolded state and the folded state of the electronic device 2, there may be rotational motion of the third unit 24830 about the third rotation axis C3, linear motion between the third unit 24830 and the second bracket 2452A, rotational motion of the fourth unit 840 about the fourth rotation axis C4, linear motion between the fourth unit 840 and the second bracket 2452A, and motion of the second connector 2420 connecting the third unit 24830 and the second bracket 2452A.

According to an embodiment, when the electronic device 2 is switched from the unfolded state to the folded state, the first rotation axis C1 and the second rotation axis C2 may be positioned further away from the first frame 211 (see FIG. 4) to which the first bracket 2451A is fixed compared to the unfolded state of the electronic device 2. When the electronic device 2 is switched from the unfolded state to the folded state, the first unit 24810 to which the first plate 2561 is fixed may be positioned to be retracted relative to the first bracket 2451A in a direction opposite to the direction in which the third display area ③ of the flexible display module 24 is oriented. When the electronic device 2 is switched from the unfolded state to the folded state, the third rotation axis C3 and the fourth rotation axis C4 may be positioned further away from the second frame 221 (see FIG. 4) to which the second bracket 2452A is fixed compared to the unfolded state of the electronic device 2. When the electronic device 2 is switched from the unfolded state to the folded state, the third unit 24830 to which the second plate 2562 is fixed may be positioned to be retracted relative to the second bracket 2452A in a direction opposite to the direction in which the third display area ③ of the flexible display module 24 is oriented. When the electronic device 2 is switched from the unfolded state to the folded state, the first plate 2561 and the second plate 62 may face each other and be spaced apart from each other. When the electronic device 2 is switched from the unfolded state to the folded state, due to the retraction of the first unit 24810 relative to the first bracket 2451A and the motion of the first connector 2410 connecting the first unit 24810 and the first bracket 2451A, the first plate 2561 coupled with the first connector 2410 may be tilted relative to the first bracket 2451A so as not to interfere with the third display area ③ of the flexible display module 24, compared to the unfolded state of the electronic device 2. When the electronic device 2 is switched from the unfolded state to the folded state, due to the retraction of the third unit 24830 relative to the second bracket 2452A and the motion of the second connector 2420 connecting the third unit 24830 and the second bracket 2452A, the second plate 2562 coupled with the second connector 2420 may be tilted relative to the second bracket 2452A so as not to interfere with the third display area ③ of the flexible display module 24, compared to the unfolded state of the electronic device 2. When the electronic device 2 is switched from the unfolded state to the folded state, the width of the space between the first plate 2561 and the second plate 2562 in the first direction 2711 may be provided to enable the third display area ③ to be disposed in a bent shape capable of reducing bending stress and/or buckling. In the folded state of the electronic device 2, the space between the first plate 2561 and the second plate 2562 may be provided in a form that widens toward the actuator 900. When the electronic device 2 is switched from the unfolded state to the folded state, the first rotation axis C1 and the second rotation axis C2 may move away from the first frame 211 on which the first display area ① is disposed, and the third rotation axis C3 and the fourth rotation axis C4 may move away from the second frame 221 on which the second display area ② is disposed to allow the actuator 900 to move away from the structure in which the first frame 211 and the second frame 221 face each other in a second direction 2712 that is perpendicular to the first direction 2711. When the electronic device 2 is switched from the unfolded state to the folded state, the actuator 900 may be positioned away from the structure in which the first frame 211 and the second frame 221 may face each other in the second direction 2712 to provide a space width in the second direction 2712 so as to allow the third display area ③ to be disposed in a bent shape capable of reducing bending stress and/or buckling.

According to an embodiment, when the electronic device 2 is switched from the unfolded state to the folded state, the actuator 900 may be positioned away from the structure in which the first frame 211 and the second frame 221 may face each other in the second direction 2712 to allow the hinge housing 23 coupled to the actuator 900 to be exposed outside through the open gap between the first housing 21 and the second housing 22, as illustrated in FIG. 3, while reducing the gap with the first housing 21 and the gap with the second housing 22.

According to an embodiment, when the electronic device 2 is switched from the folded state to the unfolded state, due to the relative position change between the first frame 211 and the second frame 221, and the first hinge module 245A which operates corresponding thereto, the first plate 2561 and the second plate 2562 may be positioned to support the third display area ③ of the flexible display module 24.

According to an exemplary embodiment of the disclosure, an electronic device (e.g., the electronic device 2 in FIG. 2) may include a first housing (e.g., the first housing 21 in FIG. 2) and a second housing (e.g., the second housing 22 in FIG. 2). The electronic device may include a hinge module (e.g., the first hinge module 5A in FIG. 8) connecting the first housing and the second housing. The hinge module may include a first unit (e.g., the first unit 810 in FIG. 8) configured to be rotatable about a first rotation axis (e.g., the first rotation axis C1 in FIG. 9). The hinge module may include a second unit (e.g., the second unit 820 in FIG. 8) configured to be rotatable about a second rotation axis (e.g., the second rotation axis C2 in FIG. 9). The second rotation axis may be positioned in parallel to the first rotation axis and spaced apart from the first rotation axis. The hinge module may include a first bracket (e.g., the first bracket 51A in FIG. 8) connected to the first unit and the second unit. The first bracket may be fixed to the first housing. The first unit and the first bracket may be connected to be slidable relative to each other in a first linear direction. The second unit and the first bracket may be connected to be slidable relative to each other in a second linear direction different from the first linear direction. When the angle between the first housing and the second housing changes, the first unit and the first bracket may slide relative to each other, and the second unit and the first bracket may slide relative to each other.

According to an exemplary embodiment of the disclosure, the electronic device may further include a flexible display module 24. The flexible display module may include a third display area positioned corresponding to the hinge module, a first display area extending from the third display area and disposed on the first housing, and a second display area extending from the third display area and disposed on the second housing.

According to an exemplary embodiment of the disclosure, the electronic device may further include a first plate coupled to the first unit corresponding to one side area of the third display area with respect to the centerline of the electronic device.

According to an exemplary embodiment of the disclosure, the hinge module may further include a first connector connecting the first bracket and the first unit. The electronic device may further include a first plate coupled to the first connector corresponding to one side area of the third display area with respect to the centerline of the electronic device. The first connector may be connected to the first bracket to be rotatable via a first pin parallel to the first rotation axis. The first connector may include a second pin parallel to the first pin. The second pin may be positioned on the first pin rail provided in the first unit.

According to an exemplary embodiment of the disclosure, the first linear direction and the second linear direction may be perpendicular to the first rotation axis and form an acute angle with each other.

According to an exemplary embodiment of the disclosure, the first unit may include a rotational motion slider positioned on a rotational motion guide rail included in the hinge module. The second rotation axis may be provided by a combination of the rotational motion guide rail and the rotational motion slider.

According to an exemplary embodiment of the disclosure, the second unit may be connected to a shaft included in the hinge module, and the second rotation axis may be provided by the shaft.

According to an exemplary embodiment of the disclosure, the hinge module may include an elastically supported cam gear, and the second unit may be connected to a cam gear corresponding to the first rotation axis.

According to an exemplary embodiment of the disclosure, the hinge module may further include a third unit configured to be rotatable about a third rotation axis. The hinge module may further include a fourth unit configured to be rotatable about a fourth rotation axis. The hinge module may further include a second bracket fixed to the second housing. The second bracket may be connected to the third unit and the fourth unit. The third rotation axis may be positioned symmetrically to the first rotation axis with respect to the centerline of the electronic device. The third unit may be provided symmetrically to the first unit with respect to the centerline of the electronic device. The fourth rotation axis may be positioned symmetrically to the second rotation axis with respect to the centerline of the electronic device. The fourth unit may be provided symmetrically to the second unit with respect to the centerline of the electronic device. The third unit and the second bracket may be connected to be slidable relative to each other in a third linear direction symmetrical to the first linear direction with respect to the centerline of the electronic device. The fourth unit and the second bracket may be connected to be slidable relative to each other in a fourth linear direction symmetrical to the second linear direction with respect to the centerline of the electronic device. When the angle between the first housing and the second housing changes, the third unit and the second bracket may slide relative to each other, and the fourth unit and the second bracket may slide relative to each other.

According to an exemplary embodiment of the disclosure, the electronic device may further include a flexible display module. The flexible display module may include a third display area positioned corresponding to the hinge module, a first display area extending from the third display area and disposed on the first housing, and a second display area extending from the third display area and disposed on the second housing. The electronic device may further include a first plate coupled to the first unit corresponding to one side area of the third display area with respect to the centerline of the electronic device. The electronic device may further include a second plate coupled to the third unit corresponding to the other side area of the second display area with respect to the centerline of the electronic device.

According to an exemplary embodiment of the disclosure, the electronic device may further include a flexible display module. The flexible display module may include a third display area positioned corresponding to the hinge module, a first display area extending from the third display area and disposed on the first housing, and a second display area extending from the third display area and disposed on the second housing. The hinge module may further include a first connector connecting the first bracket and the first unit, and a second connector connecting the second bracket and the third unit. The electronic device may further include a first plate connected to the first connector corresponding to one side area of the third display area with respect to a centerline of the electronic device, and a second plate connected to the second connector corresponding to the other side area of the third display area with respect to the centerline of the electronic device. The first connector may be connected to the first bracket to be rotatable via a first pin parallel to the first rotation axis. The first connector may include a second pin parallel to the first pin, and the second pin may be positioned on a first pin rail provided in the first unit. The second connector may be connected to the second bracket to be rotatable via a third pin parallel to the third rotation axis. The second connector may include a fourth pin parallel to the third pin. The fourth pin may be positioned on the second pin rail provided in the third unit.

According to an exemplary embodiment of the disclosure, the hinge module may further include an actuator positioned corresponding to the centerline of the electronic device. The first unit may be connected to the actuator to be rotatable about the first rotation axis. The second unit may be connected to the actuator to be rotatable about the second rotation axis. The third unit may be connected to the actuator to be rotatable about the third rotation axis. The fourth unit may be connected to the actuator to be rotatable about the fourth rotation axis. The actuator may include a first shaft connected to the second unit and providing a second rotation axis. The actuator may include a second shaft connected to the fourth unit and providing a fourth rotation axis. The actuator may include a third circular gear engaged with a first circular gear included in the first shaft. The actuator may include a fourth circular gear engaged with the second circular gear included in the second shaft and the third circular gear.

According to an exemplary embodiment of the disclosure, the actuator includes an elastically supported cam gear, and the first shaft and the second shaft may be connected to the cam gear.

According to an exemplary embodiment of the disclosure, the electronic device may further include a hinge housing coupled with the actuator. The hinge housing may be exposed outside through the space between the first housing and the second housing when the electronic device is switched from an unfolded state to a folded state, thereby providing a portion of an outer surface of the electronic device.

According to an exemplary embodiment of the disclosure, the electronic device may include a first housing and a second housing. The electronic device may include a hinge module connecting the first housing and the second housing. The hinge module may include a first unit configured to be rotatable about a first rotation axis. The hinge module may include a second unit configured to be rotatable about a second rotation axis. The second rotation axis may be positioned in parallel to the first rotation axis and spaced apart from the first rotation axis. The hinge module may include a first bracket fixed to the first housing. The first bracket may be connected to the first unit and the second unit. The hinge module may include a third unit configured to be rotatable about a third rotation axis. The hinge module may include a fourth unit configured to be rotatable about a fourth rotation axis. The hinge module may include a second bracket fixed to the second housing. The second bracket may be connected to the third unit and the fourth unit. The third rotation axis may be positioned symmetrically to the first rotation axis with respect to the centerline of the electronic device. The third unit may be provided symmetrically to the first unit with respect to the centerline of the electronic device. The fourth rotation axis may be positioned symmetrically to the second rotation axis with respect to the centerline of the electronic device. The fourth unit may be provided symmetrically to the second unit with respect to the centerline of the electronic device. The first unit and the first bracket may be connected to be slidable relative to each other in a first linear direction. The second unit and the first bracket may be connected to be slidable relative to each other in a second linear direction different from the first linear direction. The third unit and the second bracket may be connected to be slidable relative to each other in a third linear direction symmetrical to the first linear direction with respect to the centerline of the electronic device. The fourth unit and the second bracket may be connected to be slidable relative to each other in a fourth linear direction symmetrical to the second linear direction with respect to the centerline of the electronic device. When the angle between the first housing and the second housing changes, the first unit and the second unit may slide relative to the first bracket, and the third unit and the fourth unit may slide relative to the second bracket.

According to an exemplary embodiment of the disclosure, the electronic device may further include a flexible display module. The flexible display module may include a third display area positioned corresponding to the hinge module, a first display area extending from the third display area and disposed on the first housing, and a second display area extending from the third display area and disposed on the second housing.

According to an exemplary embodiment of the disclosure, the electronic device may further include a first plate coupled to the first unit corresponding to one side area of the third display area with respect to the centerline of the electronic device. The electronic device may further include a second plate coupled to the third unit corresponding to the other side area of the third display area with respect to the centerline of the electronic device.

According to an exemplary embodiment of the disclosure, the hinge module may further include a first connector connecting the first unit and the first bracket, and a second connector connecting the third unit and the second bracket. The electronic device may further include a first plate coupled to the first connector corresponding to one side area of the third display area with respect to the centerline of the electronic device. The electronic device may further include a second plate coupled to the second connector corresponding to the other side area of the third display area with respect to the centerline of the electronic device. The first connector may be connected to the first bracket to be rotatable via a first pin parallel to the first rotation axis. The first connector may include a second pin parallel to the first pin, and the second pin may be positioned on a first pin rail provided in the first unit. The second connector may be connected to the second bracket to be rotatable via a third pin parallel to the third rotation axis. The second connector may include a fourth pin parallel to the third pin. The fourth pin may be positioned on the second pin rail provided in the third unit.

According to an exemplary embodiment of the disclosure, the hinge module may further include an actuator positioned corresponding to the centerline of the electronic device. The first unit may be connected to the actuator to be rotatable about the first rotation axis. The second unit may be connected to the actuator to be rotatable about the second rotation axis. The first unit may be connected to the actuator to be rotatable about the first rotation axis. The third unit may be connected to the actuator to be rotatable about the third rotation axis. The fourth unit may be connected to the actuator to be rotatable about the fourth rotation axis. The actuator may include a first shaft. The first shaft may be connected to the second unit and may provide a second axis of rotation. The actuator may include a second shaft. The second shaft may be connected to the fourth unit and may provide a fourth axis of rotation. The actuator may include a third circular gear engaged with a first circular gear included in the first shaft. The actuator may include a fourth circular gear engaged with the second circular gear included in the second shaft and the third circular gear.

According to an exemplary embodiment of the disclosure, the actuator may include an elastically supported cam gear. The first shaft and the second shaft may be connected to the cam gear.

Embodiments disclosed in the disclosure and drawings are merely presented as specific examples to easily describe technical content and aid understanding of the disclosure, and are not intended to limit the scope of the disclosure. Accordingly, the scope of the various embodiments of the disclosure should be construed as including changes or modifications of the embodiments in addition to the embodiments disclosed herein. In addition, it will be appreciated that any embodiment(s) described herein may be used with any other embodiment(s) described herein.

## Claims

1. An electronic device comprising:
a first housing and a second housing; and
a hinge module connecting the first housing and the second housing,
wherein the hinge module comprises:
a first unit configured to rotate about a first rotation axis;
a second unit configured to rotate about a second rotation axis that is parallel to and spaced apart from the first rotation axis; and
a first bracket connected to the first unit and the second unit, and fixed to the first housing,
wherein the first unit and the first bracket are connected to be slidable relative to each other in a first linear direction, and the second unit and the first bracket are connected to be slidable relative to each other in a second linear direction different from the first linear direction, and
wherein, in case that an angle between the first housing and the second housing changes, the first unit and the first bracket slide relative to each other, and the second unit and the first bracket slide relative to each other.

2. The electronic device of claim 1, comprising:
a flexible display module comprising a third display area positioned corresponding to the hinge module, a first display area extending from the third display area and disposed on the first housing, and a second display area extending from the third display area and disposed on the second housing.

3. The electronic device of claim 2, comprising:
a first plate coupled to the first unit, corresponding to one side area of the third display area with respect to a centerline of the electronic device.

4. The electronic device of claim 2, wherein the hinge module comprises a first connector connecting the first bracket and the first unit,
wherein the electronic device comprises a first plate coupled to the first connector corresponding to one side area of the third display area with respect to the centerline of the electronic device, and
wherein the first connector comprises a first pin parallel to the first rotation axis, and a second pin parallel to the first pin and positioned on a first pin rail provided in the first unit, the first connector being rotatably connected to the first bracket via the first pin.

5. The electronic device of claim 1, wherein the first linear direction and the second linear direction are perpendicular to the first rotation axis and form an acute angle with each other.

6. The electronic device of claim 1, wherein the first unit comprises a rotational motion slider positioned in a rotational motion guide rail included in the hinge module, and wherein the second rotation axis is provided by a combination of the rotational motion guide rail and the rotational motion slider.

7. The electronic device of claim 1, wherein the second unit is connected to a shaft included in the hinge module, and wherein the second rotation axis is provided by the shaft.

8. The electronic device of claim 1, wherein the hinge module comprises an elastically supported cam gear, and wherein the second unit is connected to the cam gear corresponding to the first rotation axis.

9. The electronic device of claim 1, wherein the hinge module comprises:
a third unit configured to rotate about a third rotation axis;
a fourth unit configured to rotate about a fourth rotation axis; and
a second bracket connected to the third unit and the fourth unit, and fixed to the second housing,
wherein the third rotation axis is positioned symmetrically to the first rotation axis with respect to a centerline of the electronic device,
wherein the third unit is provided symmetrically to the first unit with respect to the centerline of the electronic device,
wherein the fourth rotation axis is positioned symmetrically to the second rotation axis with respect to the centerline of the electronic device,
wherein the fourth unit is provided symmetrically to the second unit with respect to the centerline of the electronic device,
wherein the third unit and the second bracket are connected to be slidable relative to each other in a third linear direction that is symmetrical to the first linear direction with respect to the centerline of the electronic device,
wherein the fourth unit and the second bracket are connected to be slidable relative to each other in a fourth linear direction that is symmetrical to the second linear direction with respect to the centerline of the electronic device, and
wherein, in case that an angle between the first housing and the second housing changes, the third unit and the second bracket slide relative to each other, and the fourth unit and the second bracket slide relative to each other.

10. The electronic device of claim 9, comprising:
a flexible display module comprising a third display area positioned corresponding to the hinge module, a first display area extending from the third display area and disposed on the first housing, and a second display area extending from the third display area and disposed on the second housing;
a first plate coupled to the first unit, corresponding to one side area of the third display area with respect to a centerline of the electronic device; and
a second plate coupled to the third unit, corresponding to another side area of the second display area with respect to a centerline of the electronic device.

11. The electronic device of claim 9, comprising:
a flexible display module comprising a third display area positioned corresponding to the hinge module, a first display area extending from the third display area and disposed on the first housing, and a second display area extending from the third display area and disposed on the second housing,
wherein the hinge module comprises a first connector connecting the first bracket and the first unit, and a second connector connecting the second bracket and the third unit,
wherein the electronic device comprises:
a first plate coupled to the first connector corresponding to one side area of the third display area with respect to the centerline of the electronic device, and a second plate coupled to the second connector corresponding to another side area of the third display area with respect to the centerline of the electronic device,
wherein the first connector comprises a first pin parallel to the first rotation axis and a second pin parallel to the first pin and positioned on a first pin rail provided in the first unit, the first connector being rotatably connected to the first bracket via the first pin, and
wherein the second connector comprises a third pin parallel to the third rotation axis, and a fourth pin parallel to the third pin and positioned on a second pin rail provided in the third unit, the second connector being rotatably connected to the second bracket via the third pin.

12. The electronic device of claim 9, wherein the hinge module comprises an actuator positioned corresponding to the centerline of the electronic device,
wherein the first unit is connected to the actuator to be rotatable about the first rotation axis,
wherein the second unit is connected to the actuator to be rotatable about the second rotation axis,
wherein the third unit is connected to the actuator to be rotatable about the third rotation axis,
wherein the fourth unit is connected to the actuator to be rotatable about the fourth rotation axis, and
wherein the actuator comprises:
a first shaft connected to the second unit and configured to provide the second rotation axis;
a second shaft connected to the fourth unit and configured to provide the fourth rotation axis;
a third circular gear engaged with a first circular gear included in the first shaft; and
a fourth circular gear engaged with a second circular gear included in the second shaft and with the third circular gear.

13. The electronic device of claim 12, wherein the actuator comprises an elastically supported cam gear, and wherein the first shaft and the second shaft are connected to the cam gear.

14. The electronic device of claim 12, comprising:
a hinge housing coupled to the actuator,
wherein the hinge housing is exposed outside through a space between the first housing and the second housing in case that the electronic device is switched from an unfolded state to a folded state, thereby providing a portion of an outer surface of the electronic device.
